(19) Europäisches Patentamt
European Patent Office
Office européen des brevets

(11) EP 2 498 130 A2

(12) **EUROPEAN PATENT APPLICATION**

(43) Date of publication:
**12.09.2012 Bulletin 2012/37**

(51) Int Cl.:
***G03F 7/038*** *(2006.01)* ***G02B 3/00*** *(2006.01)*

(21) Application number: **12158562.4**

(22) Date of filing: **08.03.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **08.03.2011 JP 2011050678**

(71) Applicant: **Fujifilm Corporation**
**Minato-ku**
**Tokyo (JP)**

(72) Inventor: **Shitabatake, Kouji**
**Shizuoka (JP)**

(74) Representative: **HOFFMANN EITLE**
**Patent- und Rechtsanwälte**
**Arabellastrasse 4**
**81925 München (DE)**

(54) **Curable composition for solid-state imaging device, and photosensitive layer, permanent pattern, wafer-level lens, solid-state imaging device and pattern forming method each using the composition**

(57) There is provided a curable composition for a solid-state imaging device, comprising:
(A) an infrared-blocking material,
(B) a compound capable of generating an acid upon irradiation with an actinic ray or radiation,
(C) a compound caused to undergo a crosslinking reaction by the action of an acid, and
(D) a binder resin.

EP 2 498 130 A2

## Description

## BACKGROUND OF THE INVENTION

### 1. Field of the Invention

The present invention relates to a curable composition for a solid-state imaging device, and a photosensitive layer, a permanent pattern, a wafer-level lens, a solid-state imaging device and a pattern forming method each using the composition. More specifically, the present invention relates to a curable composition for a solid-state imaging device, which can be suitably used for formation of a solder resist, and a photosensitive layer, a permanent pattern, a solid-state imaging device and a pattern forming method each using the composition.

### 2. Description of the Related Art

Conventionally, in the case of forming a permanent pattern such as solder resist, a photosensitive layer is formed on a target member by using a method of applying a photosensitive composition in a liquid form by spin-coating, screen printing or spray printing and drying the coating film, or a method of coating and drying a photosensitive composition on a temporary support to obtain a laminate film having a photosensitive layer and transferring only the photosensitive layer onto the member by means of a vacuum laminator or a roll laminator. As for the method to form a permanent pattern such as solder resist, there is known, for example, a method of forming a photosensitive layer by the method above on a silicon wafer on which a permanent pattern is formed, on a wired silicon wafer, or on a substrate such as copper-lined laminate board, exposing the photosensitive layer of the laminate, developing the exposed photosensitive layer to form a pattern, and then performing a curing treatment or the like to form a permanent pattern.

This permanent pattern formation is applied also to a package substrate interposed between a semiconductor chip and a printed board. As for the package substrate, with the demand for higher density packaging in recent years, reduction in the wiring pitch, increase in the strength of solder resist layer, enhancement of the insulating property, film thinning and the like are proceeding, and in turn, resistance to repeated heat/cold shocks (thermal cycle test resistance, TCT resistance) is more keenly demanded. Also, it is required to reduce the via diameter and in view of packaging property, form a pattern having a rectangular profile.

On the other hand, a solid-state imaging device (image sensor) used in cellular phones, digital cameras, digital videos, monitoring cameras and the like is a photoelectric conversion device having an integrated circuit formed using the production technique of a semiconductor device. In recent years, with reduction in size and weight of a cellular phone or a digital camera, the solid-state imaging device is required to be more downsized.

For downsizing the solid-state imaging device, a technique of applying a through-electrode or thinning a silicon wafer has been proposed (see, for example, JP-A-2009-194396 (the term "JP-A" as used herein means an "unexamined published Japanese patent application")). Downsizing can be realized by polishing and thereby thinning the silicon wafer, but due to thinning of the silicon wafer, light at a wavelength of 800 nm or more is liable to be transmitted, though the effect of blocking light at 800 nm or less is maintained. A photodiode used in the solid-state imaging device reacts also to light of 800 to 1,200 nm, and transparency to light of 800 nm or more is found to cause a new problem that the pictorial quality is deteriorated.

The solid-state imaging device has a configuration that a color filter and a lens are provided adjacently to one side of a photodiode, an infrared cut filter is present in the vicinity of the color filter or lens to cut light of 800 to 1,200 nm, and a metal wiring, a solder resist and the like are present on the opposite side of the color filter. For example, the space between metal wirings is filled with a solder resist in many cases, but there is a problem that infrared light such as leakage light intruding into the inside of a cellular phone, a digital camera or the like cannot be cut by the solder resist. To cope with this problem, a technique of further providing an infrared-blocking layer on the outer side of the solder resist poor in the light-blocking effect for infrared light and thereby ensuring the infrared-blocking effect has been conventionally employed. However, a height difference due to wiring or the like is generally present on the solder resist and an infrared-blocking layer material can be hardly coated to a uniform thickness on a substrate surface having a height difference, which gives rise to a problem that if a thin portion exits, light is transmitted therethrough.

In order to provide an infrared-blocking layer only in a desired portion, the composition preferably exhibits photosensitivity and has a photolithography performance enabling patterning by exposure. The light-blocking photosensitive composition having a photolithography performance includes a black resist using carbon black employed for the formation of an LCD color filter. The carbon black has a high light-blocking effect in the visible region but exhibits a low light-blocking effect in the infrared region and when it is attempted to apply such a black resist as a solder resist, if carbon black is added in an amount large enough to ensure the required light-blocking effect in the infrared region, this causes a problem that the light-blocking effect in the visible region becomes excessively high, light at a shorter wavelength than the visible region, which is usually employed for image formation and used at the exposure to high-pressure mercury

lamp, KrF, ArF or the like, is also cut, making it impossible to obtain sufficient photo-curability, and an excellent pattern cannot be obtained even through a development step using an alkali developer.

Also, at present, an infrared-blocking layer is separately provided after forming a solder resist by a coating method and therefore, in the solder resist formation and the infrared-blocking layer formation, steps such as coating, exposure, development and post-heating must be performed a plurality of times, which leads to a cumbersome process and a rise in the cost. In this regard, improvements are required.

For meeting the requirement, it has been attempted to impart a light-blocking effect to the solder resist itself, and, for example, a black solder resist composition containing a black colorant, a colorant other than black, and a polyfunctional epoxy compound has been proposed (see, for example, JP-A-2008-257045). However, this composition is characterized in that the content of the black colorant is kept low by using a colorant other than black in combination, and is practically insufficient from the standpoint of satisfying both light-blocking effect, particularly light-blocking effect in the infrared region, and pattern formability.

## Summary of the Invention

Under these circumstances, a curable composition capable of forming an excellent pattern with excellent heat/cold shock resistance and high light-blocking effect in the infrared region by alkali development is demanded at present.

The present invention has been made by taking into consideration these current circumstances, and the task of the present invention is to solve various conventional problems described above and attain the following object.

That is, an object of the present invention is to provide a curable composition for a solid-state imaging device, ensuring that a pattern having high light-blocking effect in the infrared region, excellent durability (such as heat/cold shock resistance or adherence to substrate) and a desired rectangular profile can be formed by alkali development with high sensitivity, and a photosensitive layer, a permanent pattern, a wafer-level lens, a solid-state imaging device, and a pattern forming method each using the composition.

The present invention has the following configurations, and the above-described objects can be attained by these configurations.

(1) A curable composition for a solid-state imaging device, comprising:

- (A) an infrared-blocking material,
- (B) a compound capable of generating an acid upon irradiation with an actinic ray or radiation,
- (C) a compound caused to undergo a crosslinking reaction by the action of an acid, and
- (D) a binder resin.

(2) The curable composition for a solid-state imaging device as described in (1) above, wherein the compound (C) is a compound having an oxirane group, a hydroxymethyl group, an alkoxymethyl group or a phenol group.

(3) The curable composition for a solid-state imaging device as described in (2) above, wherein the compound (C) is a compound having two or more oxirane groups, hydroxymethyl groups, alkoxymethyl groups or phenol groups.

(4) The curable composition for a solid-state imaging device as described in any one of (1) to (3) above, wherein the compound (B) is an onium salt compound.

(5) The curable composition for a solid-state imaging device as described in any one of (1) to (4) above, wherein the binder resin (D) has an acid group.

(6) The curable composition for a solid-state imaging device as described in any one of (1) to (5) above, wherein the binder resin (D) is at least either one of a polyamide-based resin and a polyimide-based resin.

(7) The curable composition for a solid-state imaging device as described in any one of (1) to (5) above, wherein the binder resin (D) is a urethane resin.

(8) The curable composition for a solid-state imaging device as described in any one of (1) to (7) above, wherein the infrared-blocking material (A) is a tungsten compound.

(9) The curable composition for a solid-state imaging device as described in any one of (1) to (8) above, wherein the viscosity at 25˚C is from 200 to 1,000 mPas.

(10) A photosensitive layer formed of the curable composition for a solid-state imaging device described in any one of (1) to (9) above.

(11) A permanent pattern formed using the curable composition for a solid-state imaging device described in any one of (1) to (9) above.

(12) The permanent pattern as described in (11) above, wherein the permanent pattern is a solder resist layer.

(13) The permanent pattern as described in (11) above, wherein the permanent pattern is an infrared-blocking film.

(14) A wafer-level lens having a lens and the permanent pattern described in (11) above formed in the circumferential edge part of the lens.

(15) A solid-state imaging device having the permanent pattern described in any one of (11) to (13) above.
(16) A solid-state imaging device comprising:

a solid-state imaging device substrate having an imaging element part formed on one surface thereof, and
an infrared-blocking film provided on the other surface side of the solid-state imaging device substrate,
wherein the infrared-blocking film is the permanent pattern described in (13) above.

(17) A pattern forming method comprising, in order,

a step of forming the photosensitive layer described in (10) above,

a step of patternwise exposing said photosensitive layer to cure the exposed area, and

a step of removing the unexposed area by alkali development to form a permanent pattern.

According to the present invention, a curable composition for a solid-state imaging device, ensuring that a pattern having high light-blocking effect in the infrared region, excellent durability (such as heat/cold shock resistance or adherence to substrate) and a desired rectangular profile can be formed by alkali development with high sensitivity, and a photosensitive layer, a permanent pattern, a wafer-level lens, a solid-state imaging device, and a pattern forming method each using the composition, can be provided.

**Brief Description of Drawings**

Fig. 1 is a schematic cross-sectional view showing the configuration of a camera module equipped with the solid-state imaging device according to an embodiment of the present invention.
Fig. 2 is a schematic cross-sectional view showing the solid-state imaging device according to an embodiment of the present invention.
Fig. 3 is a plan view showing one example of the wafer-level lens array.
Fig. 4 is a cross-sectional view along line A-A in Fig. 3.
Fig. 5 is a view showing how a molding material working out to a lens is supplied to a substrate.
Figs. 6A to 6C are views showing the procedure of molding a lens on a substrate by using a mold.
Figs. 7A to 7C are schematic views showing the process of forming a patterned light-blocking film on a substrate having molded thereon a lens.
Fig. 8 is a cross-sectional view showing one example of the wafer-level lens array.
Figs. 9A to 9C are schematic views showing another embodiment of the process of forming a light-blocking film.
Figs. 10A to 10C are schematic views showing the process of molding a lens on a substrate having thereon a patterned light-blocking film.

**DETAILED DESCRIPTION OF THE INVENTION**

The curable composition for a solid-state imaging device of the present invention is described in detail below.
In the description of the present invention, when a group (atomic group) is denoted without specifying whether substituted or unsubstituted, the group includes both a group having no substituent and a group having a substituent. For example, "an alkyl group" includes not only an alkyl group having no substituent (unsubstituted alkyl group) but also an alkyl group having a substituent (substituted alkyl group). Also, in the description of the present invention, the viscosity value indicates the value at 25°C.
In the description of the present invention, the term "actinic ray" or "radiation" means, for example, a bright line spectrum of mercury lamp, such as g-line, h-line and i-line, a far ultraviolet ray typified by excimer laser, an extreme-ultraviolet ray (EUV light), an X-ray or an electron beam (EB). Also, in the present invention, the "light" means an actinic ray or radiation.
Furthermore, in the description of the present invention, unless otherwise indicated, the "exposure" includes not only exposure to a mercury lamp, a far ultraviolet ray typified by excimer laser, an X-ray, EUV light or the like but also lithography with a particle beam such as electron beam and ion beam.
The curable composition for a solid-state imaging device of the present invention contains an infrared-blocking material, a compound capable of generating an acid upon irradiation with an actinic ray or radiation, a compound caused to undergo a crosslinking reaction by the action of an acid, and a binder resin.

The curable composition for a solid-state imaging device of the present invention is, for example, a negative composition and is typically a negative resist composition. The configuration of this composition is described below.

The constituent requirements may be described below based on representative embodiments of the present invention, but the present invention is not limited to these embodiments. Incidentally, in the description of the present invention, the range expressed by "(numerical value) to (numerical value)" means a range including the numerical values before and after "to" as the lower limit and the upper limit, respectively.

In the description of the present invention, the term "(meth)acrylate" indicates acrylate and methacrylate, the term "(meth)acryl" indicates acryl and methacryl, and the term "(meth)acryloyl" indicates acryloyl and methacryloyl. Also, in the description of the present invention, the "monomeric substance" has the same meaning as "monomer". The "monomer" as used in the present invention is differentiated from an oligomer and a polymer and indicates a compound having a mass average molecular weight of 2,000 or less. In the description of the present invention, the term "polymerizable compound" indicates a compound having a polymerizable group and may be either a monomer or a polymer. The term "polymerizable group" indicates a group participating in the polymerization reaction.

[1] (A) Infrared-blocking material

The curable composition for a solid-state imaging device of the present invention contains an infrared-blocking material.

As the infrared-blocking material for use in the present invention, a compound capable of absorbing light at a wavelength of 800 to 1,200 nm may be used without any particular limitation, and the compound may be either an infrared absorbing dye or an infrared absorbing pigment.

Examples of the infrared absorbing dye usable as the infrared-blocking material in the present invention include a cyanine dye, a phthalocyanine dye, a naphthalocyanine dye, an immonium dye, an aminium dye, a quinolium dye, a pyrylium dye, and a metal complex dye such as Ni complex dye.

The dye usable as the infrared-blocking material in the present invention is also available as a commercial product, and preferred examples thereof include the following commercially available dyes:

S0345, S0389, S0450, S0253, S0322, S0585, S0402, S0337, S0391, S0094, S0325, S0260, S0229, S0447, S0378, S0306 and S0484 produced by FEW Chemicals;

ADS795WS, ADS805WS, ADS819WS, ADS820WS, ADS823WS, ADS830WS, ADS850WS, ADS845MC, ADS870MC, ADS880MC, ADS890MC, ADS920MC, ADS990MC, ADS805PI, ADSW805PP, ADS810CO, ADS813MT, ADS815EI, ADS816EI, ADS818HT, ADS819MT, ADS819MT, ADS821NH, ADS822MT, ADS838MT, ADS840MT, ADS905AM, ADS956BP, ADS1040P, ADS1040T, ADS1045P, ADS1040P, ADS1050P, ADS1065A, ADS1065P, ADS1100T and ADS1120F produced by American Dye Source, Inc.:

YKR-4010, YKR-3030, YKR-3070, MIR-327, MIR-371, SIR-159, PA-1005, MIR-369, MIR-379, SIR-128, PA-1006, YKR-2080, MIR-370, YKR-3040, YKR-3081, SIR-130, MIR-362, YKR-3080, SIR-132 and PA-1001 produced by Yamamoto Chemical Industry Co., Ltd.; and

NK-123, NK-124, NK-1144, NK-2204, NK-2268, NK-3027, NKX-113, NKX-1199, NK-2674, NK-3508, NKX-114, NK-2545, NK-3555, NK-3509 and NK-3519 produced by Hayashibara Biochemical Labs, Inc. Among these dyes, in view of heat resistance, a phthalocyanine dye and a metal complex dye are preferred.

One of these dyes may be used alone, or two or more thereof appropriate for the purpose may be mixed and used so as to bring out good light-blocking effect for light at a wavelength of 800 to 1,200 nm.

Examples of the infrared-absorbing pigment usable as the infrared-blocking material in the present invention include zinc flower, lead white, lithopone, titanium oxide, chromium oxide, iron oxide, precipitating barium sulfate, barite powder, red lead, iron oxide red, lead yellow, zinc yellow (type 1 zinc yellow, type 2 zinc yellow), ultramarine blue, Prussian blue (iron/potassium ferrocyanide), zircon grey, praseodymium yellow, chrome-titanium yellow, chrome green, peacock blue, Victoria green, iron blue (irrelevant to Prussian blue), vanadiumzirconium blue, chrome-tin pink, manganese pink, salmon pink, titanium black, a tungsten compound, an a metal boride. Furthermore, for example, a metal oxide, a metal nitride or a mixture thereof, each containing one metal element or two or more metal elements selected from the group consisting of Co, Cr, Cu, Mn, Ru, Fe, Ni, Sn, Ti and Ag, may be used as the black pigment.

In the present invention, in addition to having a high light-blocking effect for infrared light, from the standpoint of resolution or sensitivity in the pattern formation using a light source at a wavelength of 500 nm or less, the infrared-blocking material is preferably a tungsten compound or a metal boride, which are described below, and most preferably a tungsten compound.

The tungsten compound is an infrared-blocking material having high absorption for infrared ray (light at a wavelength of about 800 to 1,200 nm) (that is, the light-blocking effect (shielding property) for infrared ray is high) and low absorption for visible light. Therefore, when the curable composition for a solid-state imaging device of the present

invention contains a tungsten compound, a pattern not only having a high light-blocking effect in the infrared region but also having a high light transmittance in the visible region can be formed.

In general, for the purpose of detecting the position of a semiconductor substrate by a visible light sensor in the process of producing a solid-state imaging device, a position detection alignment mark such as convex or concave is often provided at the predetermined position on the surface in the metal wiring and solder resist side (that is, the surface opposite the color filter or lens) of a semiconductor substrate of a solid-state imaging device.

In the configuration where an infrared-blocking layer is further provided on the outside of the solder resist lacking the light-blocking effect for infrared light, even when the infrared-blocking layer is a layer having a light-blocking effect for visible light, the thickness of this layer need not be so large for the infrared-blocking purpose (because the infrared-blocking purpose can be achieved by a thinner film than the solder resist layer) and therefore, the detection by a visible light sensor does not face a serious trouble due to covering of the alignment mark with the infrared-blocking layer. But, particularly in the configuration where, as in JP-A-2008-257045, a black colorant is contained in the solder resist composition for imparting a light-blocking effect to the solder resist itself, when the alignment mark is covered with a solder resist layer, maybe due to thickness of the solder resist layer, a trouble that the alignment mark is not detected by the visible light sensor is liable to more often occur.

However, when the curable composition for a solid-state imaging device of the present invention contains a tungsten compound, as described above, a pattern having high transmittance for light in the visible region can be formed, and this is advantageous in that the above-described trouble is less likely to occur.

Also, as described above, the tungsten compound has small absorption also for light at a shorter wavelength than the visible region (for a light source at a wavelength of 500 nm or less), which is employed for image formation and used at the exposure to high-pressure mercury lamp, KrF, ArF or the like. Therefore, by combining such a tungsten compound with other components in the curable composition for a solid-state imaging device of the present invention, a pattern excellent in resolution and sensitivity is obtained.

The tungsten compound includes, for example, a tungsten oxide-based compound, a tungsten boride-based compound and a tungsten sulfide-based compound and is preferably a tungsten oxide-based compound represented by the following formula (compositional formula) (I):

$$M_xW_yO_z \qquad (I)$$

wherein M represents a metal, W represents tungsten, O represents oxygen,
$0.001 \le x/y \le 1.1$, and
$2.2 \le z/y \le 3.0$.

The metal of M includes an alkali metal, an alkaline earth metal, Mg, Zr, Cr, Mn, Fe, Ru, Co, Rh, Ir, Ni, Pd, Pt, Cu, Ag, Au, Zn, Cd, Al, Ga, In, Tl, Sn, Pb, Ti, Nb, V, Mo, Ta, Re, Be, Hf, Os and Bi and is preferably an alkali metal. The metal of M may be one kind of a metal or two or more kinds of metals.

M is preferably an alkali metal, more preferably Rb or Cs, still more preferably Cs.

When x/y is 0.001 or more, the infrared ray can be sufficiently blocked, and when it is 1.1 or less, production of an impurity phase in the tungsten compound can be more unfailingly avoided.

When z/y is 2.2 or more, chemical stability as the material can be more enhanced, and when it is 3.0 or less, the infrared ray can be sufficiently blocked.

Specific examples of the tungsten oxide-based compound represented by formula (I) include $Cs_{0.33}WO_3$, $Rb_{0.33}WO_3$, $K_{0.33}WO_3$ and $Ba_{0.33}WO_3$. The compound is preferably $Cs_{0.33}WO_3$ or $Rb_{0.33}WO_3$, more preferably $Cs_{0.33}WO_3$.

The tungsten compound is preferably a fine particle. The average particle diameter of the tungsten fine particle is preferably 800 nm or less, more preferably 400 nm or less, still more preferably 200 nm or less. When the average particle diameter is in this range, the tungsten fine particle is scarcely allowed to block the visible light because of light scattering, so that light transparency in the visible region can be more successfully ensured. From the standpoint of avoiding light scattering, the average particle diameter is preferably smaller, but for the reason of easy handling or the like at the production, the average particle diameter of the tungsten fine particle is usually 1 nm or more.

The tungsten compound is available as a commercial product but when the tungsten compound is, for example, a tungsten oxide-based compound, the tungsten oxide-based compound can be obtained by a method of heat-treating a tungsten compound in an inert gas atmosphere or a reducing gas atmosphere (see, Japanese Patent 4,096,205).

The tungsten oxide-based compound is also available, for example, as a tungsten fine particle dispersion such as YMF-02 produced by Sumitomo Metal Industries, Ltd.

Similarly to the tungsten compound, the metal boride has high absorption for infrared ray (light at a wavelength of about 800 to 1,200 nm) and low absorption for visible light and also has small absorption for light at a shorter wavelength

than the visible region, which is employed for image formation and used at the exposure to high-pressure mercury lamp, KrF, ArF or the like. Therefore, when the curable composition for a solid-state imaging device of the present invention contains a metal boride, similarly to containing a tungsten compound, a pattern having a high light-blocking effect in the infrared region and high light transmittance for light in the visible region and being excellent in resolution and sensitivity can be obtained.

The metal boride includes one member or two or more members of, for example, lanthanum boride ($LaB_6$), praseodymium boride ($PrB_6$), neodymium boride ($NdB_6$), cerium boride ($CeB_6$), yttrium boride ($YB_6$), titanium boride ($TiB_2$), zirconium boride ($ZrB_2$), hafnium boride ($HfB_2$), vanadium boride ($VB_2$), tantalum boride ($TaB_2$), chromium boride (CrB, $CrB_2$), molybdenum boride ($MoB_2$, $MO_2B_5$, MoB) and tungsten boride ($W_2B_5$), and is preferably lanthanum boride ($LaB_6$).

The metal boride is preferably a fine particle. The average particle diameter of the metal boride fine particle is preferably 800 nm or less, more preferably 300 nm or less, still more preferably 100 nm or less. When the average particle diameter is in this range, the metal boride fine particle is less likely to block visible light by light scattering, so that transmittance of light in the visible region can be more successfully ensured. From the standpoint of avoiding light scattering, the average particle diameter is preferably smaller, but for the reason of easy handling or the like at the production, the average particle diameter of the metal boride fine particle is usually 1 nm or more.

The metal boride is available as a commercial product and is also available as a metal boride fine particle dispersion such as KHF-7 produced by Sumitomo Metal Industries, Ltd.

The content of the infrared-blocking material is preferably from 0.1 to 50 mass%, more preferably from 1 to 45 mass%, still more preferably from 5 to 40 mass%, and most preferably from 5 to 20 mass%, based on the entire solid content by mass of the curable composition for a solid-state imaging device of the present invention.

Also, two or more kinds of infrared-blocking materials may be used.

[2] (B) Compound Capable of Generating Acid Upon Irradiation with Actinic Ray or Radiation

The curable composition for a solid-state imaging device of the present invention contains a compound capable of generating an acid upon irradiation with an actinic ray or radiation (hereinafter, sometimes referred to as "acid generator" or "compound (B)").

As for the acid generated from the acid generator upon irradiation with an actinic ray or radiation, an acid having a pKa of 3 or less is preferably generated. The acid generator may be a compound capable of generating an acid by heat.

Examples of the acid generated from the acid generator upon irradiation with an actinic ray or radiation include a carboxylic acid, a sulfonic acid, a phosphoric acid, a sulfinic acid, a sulfuric acid, a sulfurous acid, a sulfuric acid monoester, a hydrochloric acid, a hexafluorophosphoric acid, and a quaternary boric acid such as tetrafluoroboric acid.

Examples of the compound capable of generating an acid include an organic halide compound, an organic boric acid compound, a sulfonic acid compound, an oxime ester compound, and an onium salt compound.

The organic halide compound specifically includes compounds described, for example, in Wakabayashi et al., Bull. Chem. Soc. Japan, 42, 2924 (1969), U.S. Patent 3,905,815, JP-B-46-4605 (the term "JP-B" as used herein means an "examined Japanese patent publication"), JP-A-48-36281, JP-A-55-32070, JP-A-60-239736, JP-A-61-169835, JP-A-61-169837, JP-A-62-58241, JP-A-62-212401, JP-A-63-70243, JP-A-63-298339, and M.P. Hutt, Journal of Heterocyclic Chemistry, 1, No. 3 (1970). In particular, the compound includes an oxazole compound substituted with a trihalomethyl group; and an S-triazine compound.

An s-triazine derivative where at least one mono-, di- or trihalogen-substituted methyl group is bonded to the s-triazine ring is more preferred, and specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6 -bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-phenyl-4,6-bis (trichloromethyl)-s-triazine, 2-(p-methoxyphenyl)-4,6-bis(trichloromethyl)-s-triazine, 2-(3,4-epoxyphenyl)-4,6-bis (trichloromethyl)-s-triazine, 2-(p-chlorophenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichoromethyl)-s-triazine, 2-benzyathio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine.

Examples of the organoboron compound include organic borates described in JP-A-62-143044, JP-A-62-150242, JP-A-9-188685, JP-A-9-188686, JP-A-9-188710, JP-A-2000-131837, JP-A-2002-107916, Japanese Patent 2764769, Japanese Patent Application No. 2000-310808 and Martin Kunz, Rad Tech '98. Proceeding April 19-22, 1998, Chicago; organic boron-sulfonium complexes and organic boron-oxosulfonium complexes described in JP-A-6-157623, JP-A-6-175564 and JP-A-6-175561; organic boron-iodonium complexes described in JP-A-6-175554 and JP-A-6-175553; organic boron-phosphonium complexes described in JP-A-9-188710; and organic boron-transition metal

coordination complexes described in JP-A-6-348011, JP-A-7-128785, JP-A-7-140589, JP-A-7-306527 and JP-A-7-292014.

The disulfone compound includes compounds described, for example, in JP-A-61-166544 and Japanese Patent Application No. 2001-132318.

The oxime ester compound includes compounds described in J.C.S. Perkin II, 1653-1660 (1979), J.C.S. Perkin II, 156-162 (1979), Journal of Photopolymer Science and Technology, 202-232 (1995), and JP-A-2000-66385, and in view of sensitivity, the compound is preferably a sulfonic acid ester.

Examples of the onium salt compound include onium salts such as diazonium salts described in S.I. Schlesinger, Photogr. Sci. Eng., 18, 387 (1974) and T.S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U.S. Patents 339,049 and 410,201, JP-A-2-150848 and JP-A-2-296514, sulfonium salts described in European Patents 370,693, 390,214, 233,567, 297,443 and 297,442, U.S. Patents 4,933,377, 161,811, 410,201, 339,049, 4,760,013, 4,734,444 and 2,833,827, and German Patents 2,904,626, 3,604,580 and 3,604,581, selenonium salts described in J.V. Crivello et al., Macromolecules, 10 (6), 1307 (1977) and J.V. Crivello et al., J. Polymer Sci., Polymer Chem. Ed., 17, 1047 (1979), and arsonium salts described in C.S. Wen et al., Teh. Proc. Conf. Rad. Curing ASIA, p. 478, Tokyo, Oct. (1988).

Above all, in view of reactivity and stability, the above-described oxime ester compound or onium salt compound is preferred.

The onium salt compound is suitably a diazonium salt, an iodonium salt or a sulfonium salt.

The onium salt suitably used in the present invention is an onium salt represented by the following formulae (RI-I) to (RI-III):

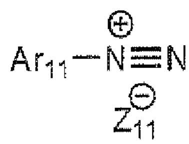
(RI-I)

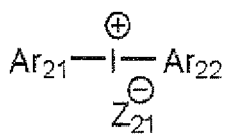
(RI-II)

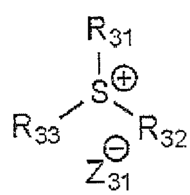
(RI-III)

In formula (RI-I), $Ar_{11}$ represents an aryl group (preferably having a carbon number of 20 or less). The aryl group may have a substituent (preferably from 1 to 6 substituents), and examples of the substituent include an alkyl group (preferably having a carbon number of 1 to 12), an alkenyl group (preferably having a carbon number of 1 to 12), an alkynyl group (preferably having a carbon number of 1 to 12), an aryl group (preferably having a carbon number of 1 to 12), an alkoxy group (preferably having a carbon number of 1 to 12), an aryloxy group (preferably having a carbon number of 1 to 12), a halogen atom, an alkylamino group (preferably having a carbon number of 1 to 12), a dialkylamino group (preferably having a carbon number of 1 to 12), an alkylamido group (preferably having a carbon number of 1 to 12), an arylamido group (preferably having a carbon number of 6 to 12), a carbonyl group, a carboxyl group, a cyano group, a sulfonyl group, a thioalkyl group (preferably having a carbon number of 1 to 12), and a thioaryl group (preferably having a carbon number of 6 to 12).

$Z_{11}^-$ represents a monovalent anion, and examples of the anion include a halogen ion, a perchlorate ion, a hexafluorophosphate ion, a tetrafluoroborate ion, a sulfonate ion, a sulfinate ion, a thiosulfonate ion and a sulfate ion. In view of stability, the anion is preferably a perchlorate ion, a hexafluorophosphate ion, a tetrafluoroborate ion, a sulfonate ion or a sulfinate ion.

In formula (RI-II), each of $Ar_{21}$ and $Ar_{22}$ independently represents an aryl group (preferably having a carbon number of 20 or less). The aryl group may have a substituent (preferably from 1 to 6 substituents), and examples of the

substituent are the same as those described for the substituent which the aryl group as $Ar_{11}$ in formula (RI-I) may have.

$Z_{21}^-$ represents a monovalent anion. Specific examples thereof are the same as those described for $Z_{11}^-$ in formula (RI-I), and preferred examples include those described for $Z_{11}^-$ in formula (RI-I) and a carboxylate ion.

In formula (RI-III), each of $R_{31}$, $R_{32}$ and $R_{33}$ independently represents an aryl group, an alkyl group, an alkenyl group or an alkynyl group and in view of reactivity and stability, is preferably an aryl group.

Each of the aryl group, alkyl group, alkenyl group and alkynyl group may have a substituent (preferably from 1 to 6 substituents), and examples of the substituent are the same as those described for the substituent which the aryl group as $Ar_{11}$ in formula (RI-I) may have.

$Z_{31}^-$ represents a monovalent anion, and specific examples and preferred examples thereof are the same as those described for $Z_{11}^-$ in formula (RI-I).

The amount of the compound (B) is preferably from 0.01 to 30 mass%, more preferably from 0.1 to 20 mass%, still more preferably from 0.1 to 15 mass%, based on the entire solid content by mass of the curable composition for a solid-state imaging device of the present invention.

[3] (C) Compound caused to undergo a crosslinking reaction by the action of an acid

The curable composition for a solid-state imaging device of the present invention contains a compound caused to undergo a crosslinking reaction by the action of an acid (hereinafter, sometimes referred to as "crosslinking agent" or "compound (C)").

The compound (C) includes, for example, a compound having an oxirane group (such as epoxy group and oxetanyl group), a hydroxymethyl group, an alkoxymethyl group or a phenolic hydroxyl group.

In view of sensitivity, resolution and stability at the pattern formation, the compound (C) is preferably a compound having an oxirane group (such as epoxy group and oxetanyl group), a hydroxymethyl group or an alkoxymethyl group, or a compound having a phenolic hydroxyl group, more preferably a compound having a hydroxymethyl group or an alkoxymethyl group, or a compound having a phenolic hydroxyl group.

The alkyl moiety in the alkoxymethyl group may be linear, branched or cyclic, and the carbon number of the alkoxymethyl group is preferably from 1 to 10, more preferably from 1 to 5.

The compound (C) preferably has two or more oxirane groups, hydroxymethyl groups, alkoxymethyl groups or phenolic hydroxyl groups, and the number of groups is preferably from 2 to 10, more preferably from 2 to 6.

In view of curability, the compound having a hydroxymethyl group or an alkoxymethyl group is preferably a compound having two or more hydroxymethyl groups or alkoxymethyl groups per molecule, more preferably a compound having four or more hydroxymethyl groups or alkoxymethyl groups per molecule.

Specific examples of the compound having a hydroxymethyl group or an alkoxymethyl group include a 2,6-dimethylolphenol moiety-containing compound, hexamethylolmelamine, and hexa(methoxymethyl)melamine.

The compound having a hydroxymethyl group or an alkoxymethyl group is also preferably a compound having a group represented by the following formula (I): Formula (I):

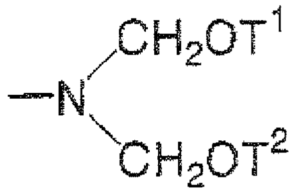

(wherein each of $T^1$ and $T^2$ independently represents a hydrogen atom, an alkyl group, an alkenyl group, an acyl group or an acetyl group).

In the case where each of $T^1$ and $T^2$ in formula (I) is an alkyl group, the carbon number of the alkyl group is preferably from 1 to 8, more preferably from 1 to 4. Specific preferred examples thereof include a methyl group, an ethyl group, an isopropyl group and a tert-butyl group.

Also, in the case where each of $T^1$ and $T^2$ is an alkenyl group, the carbon number of the alkenyl group is preferably from 2 to 18, more preferably from 2 to 4.

Furthermore, in the case where each of $T^1$ and $T^2$ is an acyl group, the carbon number of the acyl group is preferably from 2 to 18, more preferably from 2 to 4.

Specific examples of the structure represented by formula (I) include a methoxymethylolamine group, a dimethoxymethylamino group, a dimethylolamino group (dihydroxyamino group), and a diethoxymethylamino group.

The compound having a hydroxymethyl group or an alkoxymethyl group is preferably a compound having two or more structures represented by formula (I) within the molecule, and such a compound includes a compound having

a melamine skeleton, a compound having a benzoguanamine skeleton, a compound having a glycoluril skeleton, and a compound having a urea skeleton. The compound may be also a condensation product formed by fusing compounds having a group represented by formula (I) through a divalent linking group.

In the present invention, among these, an amino compound represented by the following formula (II) is preferred: Formula (II):

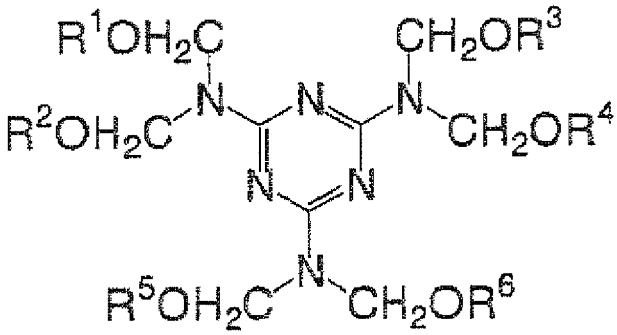

(wherein each of $R^1$ to $R^6$ independently represents a hydrogen atom, an alkyl group, an alkenyl group, an acyl group or an acetyl group).

Here, the hydrogen atom, the alkyl group, the alkenyl group, the acyl group and the acetyl group in $R^1$ to $R^6$ of formula (II) have the same meanings as the hydrogen atom, the alkyl group, the alkenyl group, the acyl group, and the acetyl group in $T^1$ and $T^2$ of formula (I).

Specific examples of the specified amino compound suitably used in the present invention are illustrated below, but the present invention is not limited thereto.

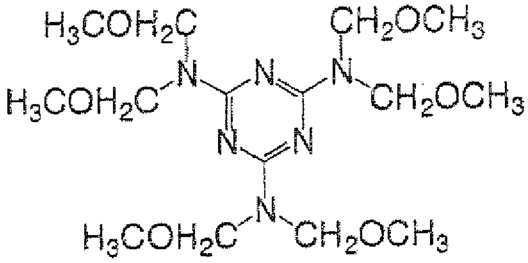

(C-1)

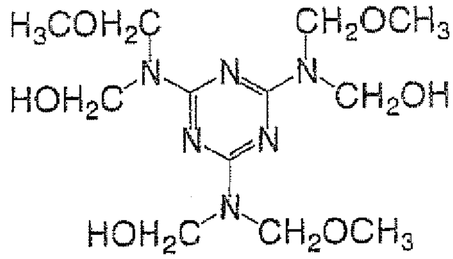

(C-2)

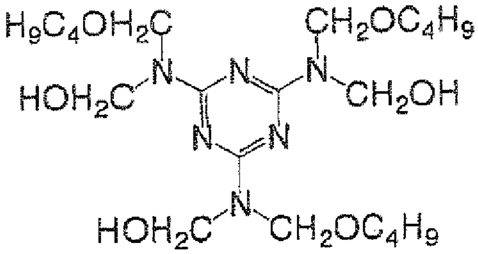

(C-3)

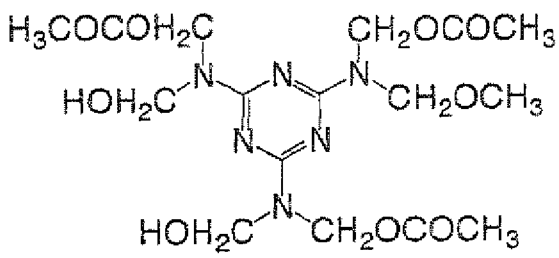

(C-4)

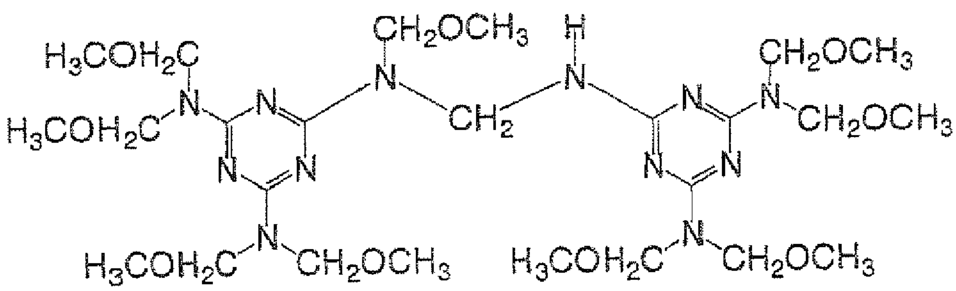

(C-5)

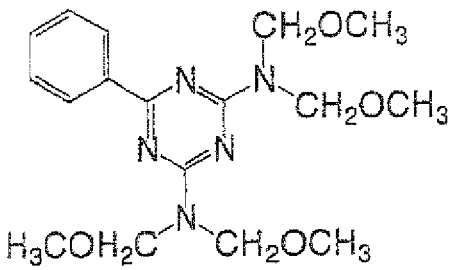

(C-6)

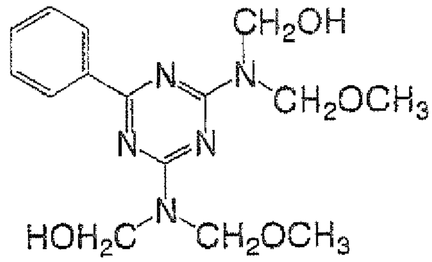

(C-7)

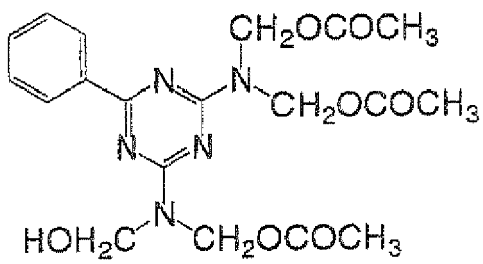

(C-8)

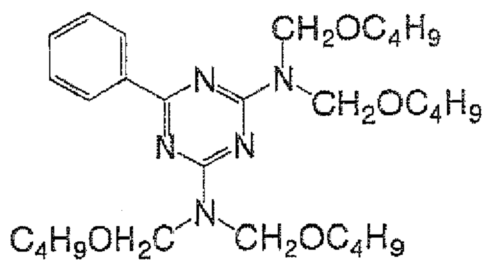

(C-9)

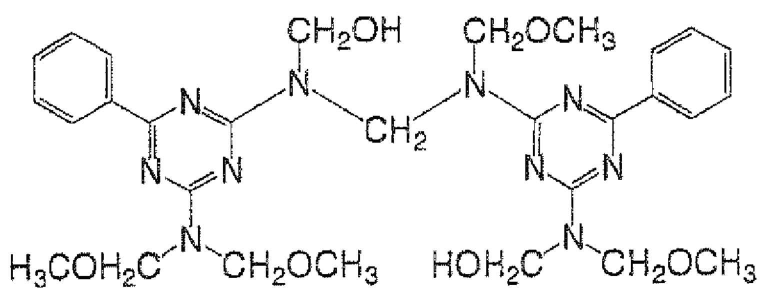

(C-10)

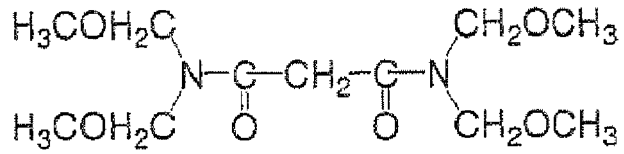

(C-11)

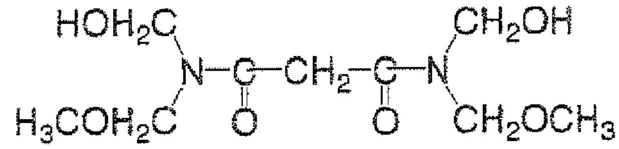

(C-12)

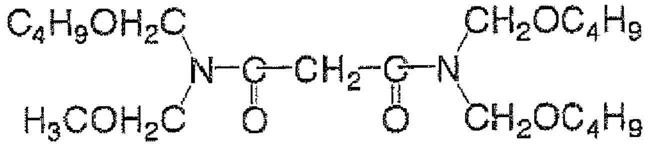

(C-13)

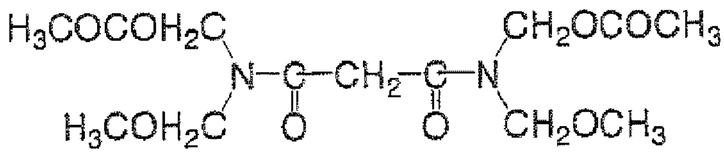

(C-14)

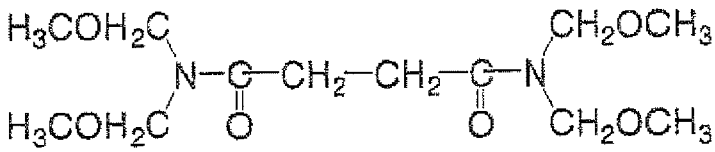

(C-15)

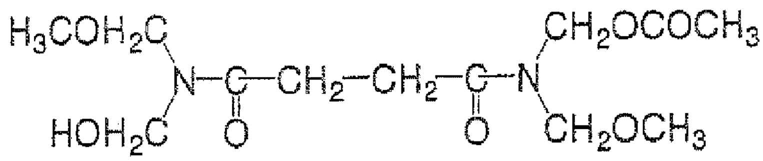

(C-16)

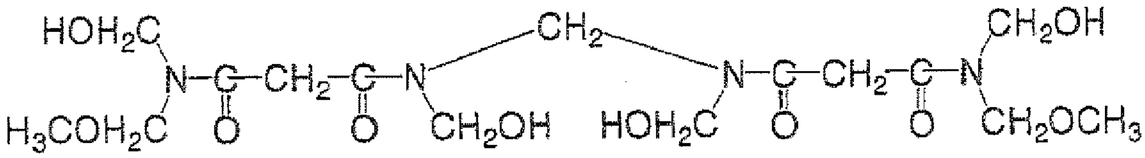

(C-17)

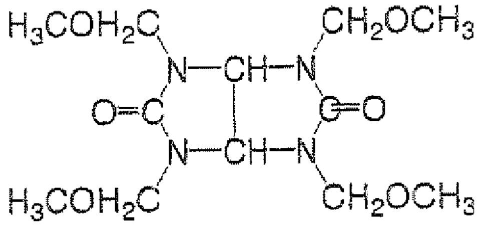

(C-18)

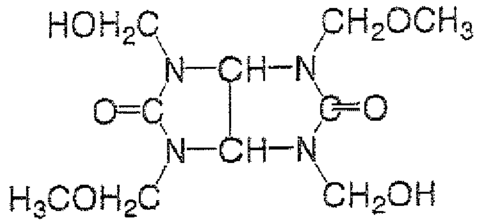

(C-19)

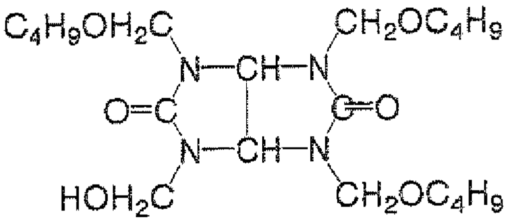

(C-20)

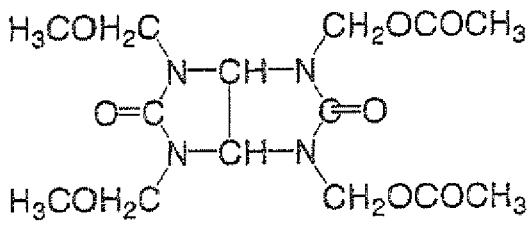

(C-21)

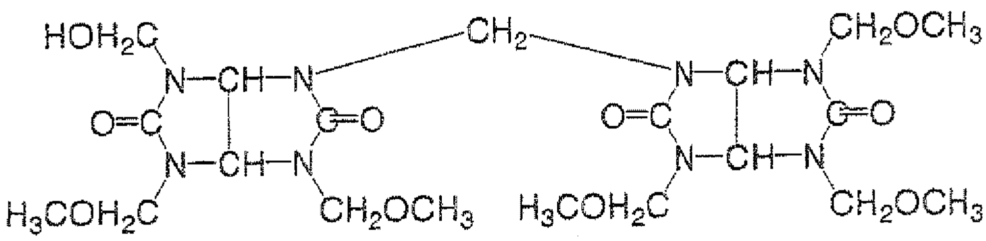

(C-22)

As the compound having a hydroxymethyl group or an alkoxymethyl group, a compound represented by the following formula (I) or (II) is also preferred:

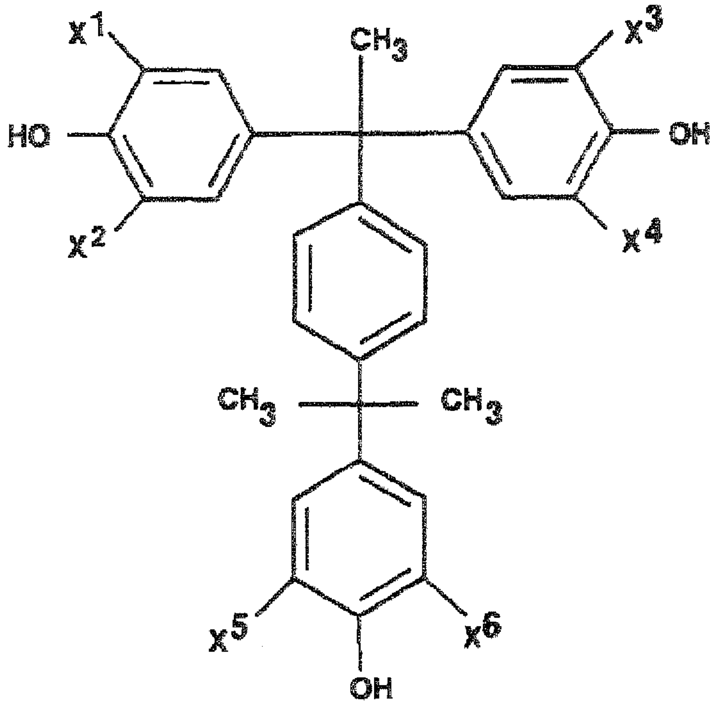

(I)

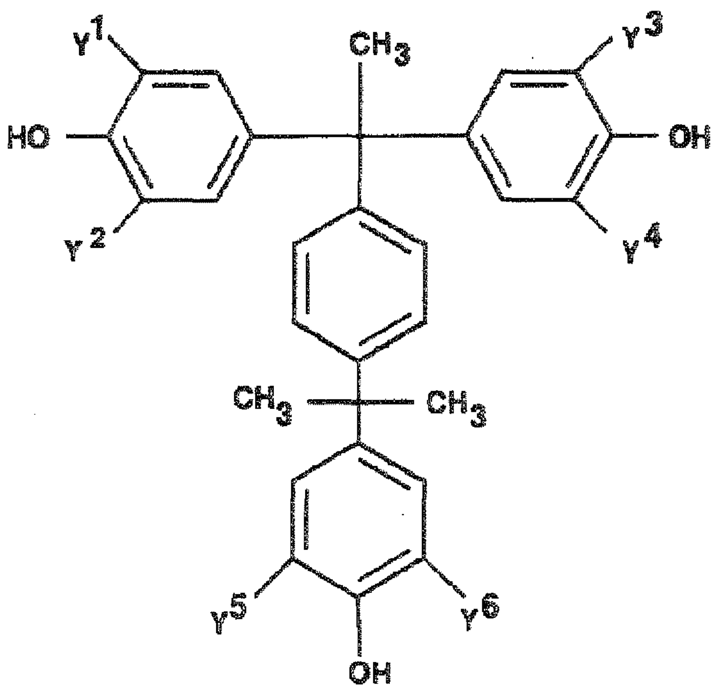

(II)

In formula (I), each of $X^1$ to $X^6$ represents $CH_2OH$ or H, and at least three of $X^1$ to $X^6$ are $CH_2OH$. In formula (II), each of $Y^1$ to $Y^6$ represents $CH_2OCH_3$, $CH_2OH$ or H, and at least three of $Y^1$ to $Y^6$ are $CH_2OCH_3$ or $CH_2OH$, with at least one being $CH_2OCH_3$. Preferably, four or more of $X^1$ to $X^6$ are $CH_2OH$, and four or more of $Y^1$ to $Y^6$ are $CH_2OCH_3$ or $CH_2OH$, with at least one or more being $CH_2OCH_3$. More preferably, all of $X^1$ to $X^6$ are $CH_2OH$, and all of $Y^1$ to $Y^6$ are $CH_2OCH_3$ or $CH_2OH$, with at least one or more being $CH_2OCH_3$.

The compound having an oxirane group is suitably an epoxy group having at least two epoxy groups per molecule, or an oxetane compound having at least two oxetanyl groups per molecule.

Examples of the epoxy compound having at least two epoxy groups per molecule include, but are not limited to, a bixylenol-type or biphenol-type epoxy compound (such as "YX4000 produced by Japan Epoxy Resins Co., Ltd."), a mixture thereof, a heterocyclic epoxy compound having an isocyanurate skeleton or the like (such as "TEPIC produced by Nissan Chemicals Industries, Ltd." and "ARALDITE PT810 produced by BASF Japan"), a bisphenol A-type epoxy compound, a novolak-type epoxy compound, a bisphenol F-type epoxy compound (Epotohto YDF-170, produced by Tohto Kasei Co., Ltd.), a hydrogenated bisphenol A-type epoxy compound, a bisphenol S-type epoxy compound, a phenol novolak-type epoxy compound, a cresol novolak-type epoxy compound, a halogenated epoxy compound (such as low brominated epoxy compound, high halogenated epoxy compound and brominated phenol novolak-type epoxy compound), an allyl group-containing bisphenol A-type epoxy compound, a trisphenolmethane-type epoxy compound, a diphenyldimethanol-type epoxy compound, a phenol biphenylene-type epoxy compound, a dicyclopentadiene-type epoxy compound (such as "HP-7200, HP-7200H produced by DIC Corp."), a glycidylamine-type epoxy compound (such as diaminodiphenylmethane-type epoxy compound, glycidylaniline and triglycidylaminophenol), a glycidyl ester-type epoxy compound (such as diglycidyl phthalate, diglycidyl adipate, diglycidyl hexahydrophthalate and diglycidyl dimerate), a hydantoin-type epoxy compound, an alicyclic epoxy compound (such as 3,4-epoxycyclohexylmethyl-3',4'-epoxycyclohexanecarboxylate, bis(3,4-epoxycyclohexylmethyl)adipate, dicyclopentadiene diepoxide, and "GT-300, GT-400, EHPE3150 produced by Daicel Chemical Industries, Ltd."), an imide-type alicyclic epoxy compound, a trihydroxyphenylmethane-type epoxy compound, bisphenol A novolak-type epoxy compound, a tetraphenylolethane-type epoxy compound, a glycidyl phthalate compound, a tetraglycidyl xylenoylethane compound, a naphthalene group-containing epoxy compound (such as naphthol aralkyl-type epoxy compound, naphthol novolak-type epoxy compound, tetrafunctional naphthalene-type epoxy compound, and commercially available "ESN-190 and ESN-360 produced by Nippon Steel Chemical Co., Ltd.", and "HP-4032, EXA-4750 and EXA-4700 produced by DIC Corp."), a reaction product of epichlorohydrin with a polyphenol compound obtained by an addition reaction between a phenol compound and a diolefin compound such as divinylbenzene and dicyclopentadiene, a ring-opening polymerized 4-vinylcyclohexene-1-oxide epoxidized with peracetic acid or the like, an epoxy compound having a linear phosphorus-containing structure, an epoxy compound having a cyclic phosphorus-containing structure, an α-methylstilbene-type liquid crystal epoxy compound, a dibenzoyloxybenzene-type liquid crystal epoxy compound, an azophenyl-type liquid crystal epoxy compound, an azomethine phenyl-type liquid crystal epoxy compound, a binaphthyl-type liquid crystal epoxy compound, an azine-type epoxy compound, a glycidyl methacrylate copolymer-based epoxy compound (such as "CP-50S and CP-50M produced by NOF Corporation"), a copolymerized epoxy compound of cyclohexyl maleimide and glycidyl methacrylate, a bis(glycidyloxyphenyl)fluorene-type epoxy compound, and a bis(glycidyloxyphenyl)adamantane-type epoxy compound. One of these epoxy compounds may be used alone, or two or more thereof may be used in combination.

Other than the epoxy compound having at least two epoxy groups per molecule, an epoxy compound containing, per molecule, at least two epoxy groups each having an alkyl group at the β-position may be used, and a compound containing an epoxy group substituted with an alkyl group at the β-position (more specifically, a β-alkyl-substituted glycidyl group or the like) is particularly preferred.

In the epoxy compound containing at least an epoxy group having an alkyl group at the β-position, all of two or more epoxy groups contained per molecule may be a β-alkyl-substituted glycidyl group, or at least one epoxy group may be a β-alkyl-substituted glycidyl group.

In the epoxy compound containing an epoxy group having has an alkyl group at the β-position, in view of storage stability at room temperature, the ratio of the β-alkyl-substituted glycidyl group in all epoxy groups is preferably 30 mol% or more, more preferably 40 mol% or more, still more preferably 50 mol% or more, based on the entire amount of the epoxy compound contained in the curable composition for a solid-state imaging device.

The β-alkyl-substituted glycidyl group is not particularly limited and may be appropriately selected according to the purpose. Examples thereof include a β-methylglycidyl group, a β-ethylglycidyl group, a β-propylglycidyl group, and a β-butylglycidyl group. Among these, a β-methylglycidyl group is preferred from the standpoint of enhancing storage stability of the curable composition for a solid-state imaging device as well as in view of easy synthesis.

The epoxy compound containing an epoxy group having an alkyl group at the β-position is preferably, for example, an epoxy compound derived from a polyhydric phenol compound and a β-alkylepihalohydrin.

Moreover, the β-alkylepihalohydrin is not particularly limited and may be appropriately selected according to the purpose. Examples thereof include a β-methylepihalohydrin such as β-methylepichlorohydrin, β-methylepibromohydrin and β-methylepifluorohydrin; a β-ethylepihalohydrin such as β-ethylepichlorohydrin, β-ethylepibromohydrin and β-ethylepifluorohydrin; a β-propylepihalohydrin such as β-propylepichlorohydrin, β-propylepibromohydrin and β-propylepifluorohydrin; and a β-butylepihalohydrin such as β-butylepichlorohydrin, β-butylepibromohydrin and β-butylepifluorohydrin. Among these, β-methylepihalohydrin is preferred in view of reactivity with the polyhydric phenol and fluidity.

The polyhydric phenol compound is not particularly limited as long as it is a compound containing two or more aromatic hydroxyl groups per molecule, and the compound may be appropriately selected according to the purpose. Examples thereof include a bisphenol compound such as bisphenol A, bisphenol F and bisphenol S, a biphenol compound such as biphenol and tetramethylbiphenol, a naphthol compound such as dihydroxynaphthalene and binaphthol, a

phenol novolak compound such as phenol-formaldehyde polycondensate, a monoalkyl (having a carbon number of 1 to 10)-substituted phenol-formaldehyde polycondensate such as cresol-formaldehyde polycondensate, a dialkyl (having a carbon number of 1 to10)-substituted phenol-formaldehyde polycondensate such as xylenol-formaldehyde polycondensate, a bisphenol compound-formaldehyde polycondensate such as bisphenol A-formaldehyde polycondensate, a copolycondensate of phenol and a monoalkyl (having a carbon number of 1 to 10)-substituted phenol with formaldehyde, and a polyadduct of a phenol compound with divinylbenzene. Among these, for example, in the case of selecting the compound so as to improve the fluidity and storage stability, a bisphenol compound is preferred.

Examples of the epoxy compound containing an epoxy group having an alkyl group at the β-position include a di-β-alkyl glycidyl ether of a bisphenol compound, such as di-β-alkyl glycidyl ether of bisphenol A, di-β-alkyl glycidyl ether of bisphenol F, and di-β-alkyl glycidyl ether of bisphenol S; a di-β-alkyl glycidyl ether of a biphenol compound, such as di-β-alkyl glycidyl ether of biphenol and di-β-alkyl glycidyl ether of tetramethyl biphenol; a β-alkyl glycidyl ether of a naphthol compound, such as di-β-alkyl glycidyl ether of dihydroxynaphthalene and di-β-alkyl glycidyl ether of binaphthol; a poly-β-alkyl glycidyl ether of a phenol-formaldehyde polycondensate; a poly-β-alkyl glycidyl ether of a monoalkyl (having a carbon number of 1 to 10)-substituted phenol-formaldehyde polycondensate, such as poly-β-alkyl glycidyl ether of cresol-formaldehyde polycondensate; a poly-β-alkyl glycidyl ether of a dialkyl (having a carbon number of 1 to 10)-substituted phenol-formaldehyde polycondensate, such as poly-β-alkyl glycidyl ether of xylenol-formaldehyde polycondensate; a poly-β-alkyl glycidyl ether of a bisphenol compound-formaldehyde polycondensate, such as poly-β-alkyl glycidyl ether of bisphenol A-formaldehyde polycondensate; and a poly-β-alkyl glycidyl ether of a polyadduct of a phenol compound with divinylbenzene.

Among these, a β-alkyl glycidyl ether derived from a bisphenol compound represented by the following formula (D-1) and a polymer produced from the bisphenol compound and epichlorohydrin or the like, and a poly-β-alkyl glycidyl ether of a phenol compound-formaldehyde polycondensate represented by the following formula (D-2) are preferred:

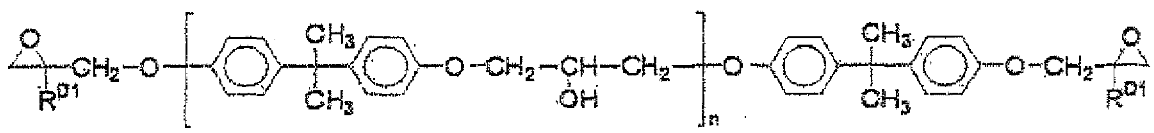

Formula (D-1)

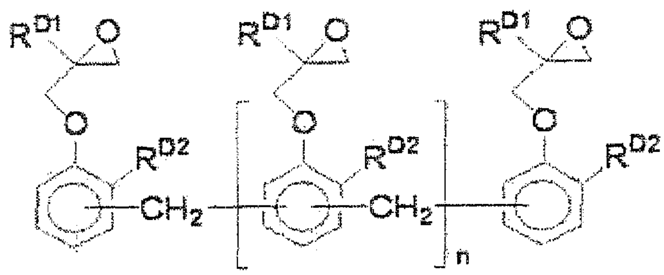

Formula (D-2)

In formula (D-1), $R^{D1}$ represents a hydrogen atom or an alkyl group having a carbon number of 1 to 6, and n represents an integer of 0 to 20.

In formula (D-2), $R^{D1}$ represents a hydrogen atom or an alkyl group having a carbon number of 1 to 6, $R^{D2}$ represents a hydrogen atom or $CH_3$, and n represents an integer of 0 to 20.

In formulae (D-1) and (D-2), plurality of $R^{D1}$ or $R^{D2}$ are present, each of $R^{D1}$ or $R^{D2}$ may be the same as or different from every other $R^{D1}$ or $R^{D2}$.

One of these epoxy compounds containing an epoxy group having an alkyl group at the β-position may be used alone, or two or more thereof may be used in combination. Also, an epoxy compound containing at least two epoxy rings per molecule and an epoxy compound containing an epoxy group having an alkyl group at the β-position may be used in combination.

As for the skeleton of the epoxy compound, at least one compound selected from a bisphenol-type epoxy compound, a novolak-type epoxy compound, an alicyclic group-containing epoxy compound and a sparingly soluble epoxy compound is preferred.

Examples of the oxetane compound containing at least two oxetanyl groups per molecule include polyfunctional

oxetanes such as bis[(3-methyl-3-oxetanylmethoxy)methyl]ether, bis[(3-ethyl-3-oxetanylmethoxy)methyl]ether, 1,4-bis[(3-methyl-3-oxetanylmethoxy)methyl]benzene, 1,4-bis[(3-ethyl-3-oxetanylmethoxy)methyl]benzene, (3-methyl-3-oxetanyl)methyl acrylate, (3-ethyl-3-oxetanyl)methyl acrylate, (3-methyl-3-oxetanyl)methyl methacrylate, (3-ethyl-3-oxetanyl)methyl methacrylate, and an oligomer or a copolymer thereof; and an ether compound of a compound having an oxetane group with a resin having a hydroxyl group, such as novolak resin, poly(p-hydroxystyrene), cardo bisphenols, calixarenes, calixresorcinarenes and silsesquioxane. Other examples include a copolymer of an unsaturated monomer having an oxetane ring with an alkyl (meth)acrylate.

The compound having a phenolic hydroxyl group includes a phenol resin such as novolak resin and resole resin. As the phenol resin, all known phenol resins can be used.

As for the compound (C), a polyisocyanate compound described in JP-A-5-9407 may be used, and the polyisocyanate compound may be derived from an aliphatic, cyclic aliphatic or aromatic group-substituted aliphatic compound containing at least two isocyanate groups. Specific examples thereof include a bifunctional isocyanate (such as 1,3-phenylene diisocyanate/1,4-phenylene diisocyanate mixture, 2,4-toluene diisocyanate, 2,6-toluene diisocyanate, 1,3-xylylene diisocyanate, 1,4-xylylene diisocyanate, bis(4-isocyanate-phenyl)methane, bis(4-isocyanatocyclohexyl)methane, isophorone diisocyanate, hexamethylene diisocyanate and trimethylhexamethylene diisocyanate), a polyfunctional alcohol such as trimethylolpropane, pentaerythritol and glycerin, an adduct of an alkylene oxide adduct of the polyfunctional alcohol above with the bifunctional isocyanate above; and a cyclic trimer such as hexamethylene diisocyanate, hexamethylene-1,6-diisocyanate, and a derivative thereof. The commercial product of the polyisocyanate compound includes, for example, BL317 (produced by Sumitomo Bayer Urethane K.K.)

Another example of the compound (C) includes a compound obtained by reacting a blocking agent with an isocyanate group of the polyisocyanate above or its derivative.

Examples of the blocking agent for a isocyanate group include alcohols (e.g., isopropanol, tert-butanol), lactams (e.g., ε-caprolactam), phenols (e.g., phenol, cresol, p-tertbutylphenol, p-sec-butylphenol, p-sec-aminophenol, p-octylphenol, p-nonylphenol), heterocyclic hydroxyl compounds (e.g., 3-hydroxypyridine, 8-hydroxyquinoline), and active methylene compounds (e.g., dialkyl malonate, methyl ethyl ketoxime, acetylacetone, alkyl acetoacetate oxime, acetoxime, cyclohexanone oxime). In addition, for example, a compound having either at least one polymerizable double bond or at least one block isocyanate group within the molecule described in JP-A-6-295060 may be used.

The compound (C) is preferably a low molecular compound having a molecular weight of 2,000 or less, more preferably a low molecular compound having a molecular weight of 1,500 or less, still more preferably a low molecular compound having a molecular weight of 900 or less. The low molecular compound as used in the present invention is not a so-called polymer or oligomer obtained by cleaving an unsaturated bond of a compound having an unsaturated bond (so-called polymerizable monomer) with use of an initiator, thereby growing the bond in a chain reaction, but indicates a compound having a certain molecular weight in a range of 2,000 or less (more preferably 1,500 or less, still more preferably 900 or less) (a compound substantially having no molecular weight distribution). Incidentally, the molecular weight is usually 100 or more.

As the compound (C), one compound may be used alone, or two or more compounds may be used in combination.

The content of the compound (C) is preferably from 1 to 50 mass%, more preferably from 3 to 30 mass%, based on the entire solid content by mass of the curable composition for a solid-state imaging device of the present invention.

[4] (D) Binder Resin

The curable composition for a solid-state imaging device of the present invention contains a binder resin.

The binder resin is preferably an alkali-soluble binder. In this case, when exposure is performed to form a pattern in the film obtained from the curable composition, the unexposed area can be more reliably removed by an alkali developer, and a more excellent pattern can be formed by alkali development.

The alkali-soluble binder contains an alkali-soluble group, and examples of the alkali-soluble group include an acid group, an alcoholic hydroxyl group, a pyrrolidone group, and an alkylene oxide group, with an acid group being preferred.

The acid group is not particularly limited, but examples thereof include a carboxyl group, an active methylene group, a phosphonic acid group, a sulfonic acid group, a phenolic hydroxyl group, and a carboxylic anhydride group. Among these, a carboxyl group and an active methylene group are preferred, and a carboxyl group is more preferred.

The alkali-soluble binder having an acid group is not particularly limited but is preferably a polymer obtained by using, as a monomer component, an acid group-containing polymerizable compound and from the standpoint of adjusting the acid value, a copolymer obtained by copolymerizing an acid group-containing polymerizable compound and an acid group-free polymerizable compound is more preferred.

The acid group-containing polymerizable compound is not particularly limited and may be appropriately selected

according to the purpose, and examples thereof include acrylic acid, methacrylic acid, itaconic acid, crotonic acid, isocrotonic acid, maleic acid, and p-carboxylstyrene, with acrylic acid, methacrylic acid and p-carboxylstyrene being preferred. One of these compounds may be used alone, or two or more thereof may be used in combination.

The acid group-free polymerizable compound is not particularly limited, but preferred examples thereof include a (meth)acrylic acid ester (such as alkyl ester, aryl ester and aralkyl ester).

The alkyl group in the alkyl ester moiety of the (meth)acrylic acid ester may be linear or branched and is preferably an alkyl group having a carbon number of 1 to 10, more preferably an alkyl group having a carbon number of 1 to 6.

The aryl group in the aryl ester moiety of the (meth)acrylic acid ester is preferably an aryl group having a carbon number of 6 to 14, more preferably an aryl group having a carbon number of 6 to 10.

The aralkyl group in the aralkyl ester moiety of the (meth)acrylic acid ester is preferably an aralkyl group having a carbon number of 7 to 20, more preferably an aralkyl group having a carbon number of 7 to 12.

The molar ratio between a monomer corresponding to the acid group-containing polymerizable compound and a monomer corresponding to the acid group-free polymerizable compound is usually from 1:99 to 99:1, preferably from 30:70 to 99:1, more preferably from 50:50 to 99:1.

The content of the acid group in the alkali-soluble binder is not particularly limited but is preferably from 0.4 to 4.0 meq/g, more preferably from 1.0 to 3.0 meq/g. When the content is 0.5 meq/g or more, satisfactory alkali developability is obtained and an excellent pattern can be more unfailingly obtained. Also, when the content is 4.0 meq/g or less, the fear of impairing the strength of the permanent pattern can be reliably avoided.

A linear organic polymer is preferably used as the binder resin.

The linear organic polymer is preferably a polymer having a carboxyl group in the side chain. Examples thereof include a methacrylic acid copolymer, an acrylic acid copolymer, an itaconic acid copolymer, a crotonic acid copolymer, a maleic acid copolymer and a partially esterified maleic acid copolymer described in JP-A-59-44615, JP-B-54-34327, JP-B-58-12577, JP-B-54-25957, JP-A-59-53836 and JP-A-59-71048, and also include an acidic cellulose derivative having a carboxyl group in the side chain, and a product obtained by adding an acid anhydride to a polymer having a hydroxyl group.

Above all, a benzyl (meth)acrylate/(meth)acrylic acid copolymer, and a multicomponent copolymer composed of benzyl (meth)acrylate/(meth)acrylic acid/other monomers are preferred.

In addition, for example, a polymer obtained by copolymerizing 2-hydroxyethyl methacrylate is also useful. The polymer may be used by mixing it in an arbitrary amount.

As the specific constituent of the binder polymer, a copolymer of a (meth)acrylic acid and another monomer copolymerizable therewith is preferred. Here, the (meth)acrylic acid is a generic term which collectively encompasses acrylic acid and methacrylic acid, and hereinafter, (meth)acrylate is also a generic term of acrylate and methacrylate.

Examples of another monomer copolymerizable with a (meth)acrylic acid include alkyl (meth)acrylates, aryl (meth)acrylates and a vinyl compound. Here, hydrogen atom of the alkyl group and the aryl group may be substituted with a substituent.

Specific examples of the alkyl (meth)acrylate and the aryl (meth)acrylate include methyl (meth)acrylate, ethyl (meth)acrylate, propyl (meth)acrylate, butyl (meth)acrylate, isobutyl (meth)acrylate, pentyl (meth)acrylate, hexyl (meth) acrylate, octyl (meth)acrylate, phenyl (meth)acrylate, benzyl (meth)acrylate, tolyl (meth)acrylate, naphthyl (meth)acrylate and cyclohexyl (meth)acrylate.

Examples of the vinyl compound include styrene, $\alpha$-methylstyrene, vinyltoluene, glycidyl methacrylate, acrylonitrile, vinyl acetate, N-vinylpyrrolidone, tetrahydrofurfuryl methacrylate, polystyrene macromonomer, polymethyl methacrylate macromonomer, $CH_2=CR^1R^2$, and $CH_2=C(R^1)(COOR^3)$ [wherein $R^1$ represents a hydrogen atom or an alkyl group having a carbon number of 1 to 5, $R^2$ represents an aromatic hydrocarbon ring having a carbon number of 6 to 10, and $R^3$ represents an alkyl group having a carbon number of 1 to 8 or an aralkyl group having a carbon number of 6 to 12].

One of these other copolymerizable monomers may be used alone, or two or more thereof may be used in combination. The another copolymerizable monomer is preferably at least one member selected from $CH_2=CR^1R^2$, $CH_2=C(R^1)(COOR^3)$, phenyl (meth)acrylate, benzyl (meth)acrylate and styrene, more preferably $CH_2=CR^1R^2$ and/or $CH_2=C(R^1)(COOR^3)$.

The binder resin may be a resin having a crosslinking group, and in this case, a resin having a crosslinking group in the side chain is preferred. Thanks to such a configuration, particularly, both curability of the exposed area and alkali developability of the unexposed area can be enhanced.

The crosslinking group as used herein indicates a group capable of crosslinking the binder resin in the process of a crosslinking reaction occurring in the photosensitive layer when the photosensitive layer obtained from the curable composition is exposed or heated.

The crosslinking group is not particularly limited as long as it is a group having such a function, but examples of the crosslinking group include a phenol group, an ethylenically unsaturated bond group, an amino group, and an

epoxy group. The ethylenically unsaturated bond group includes a styryl group, a (meth)acryloyl group or an allyl group, and from the standpoint of satisfying both stability of the crosslinking group before exposure and strength of the permanent pattern, a (meth)acryloyl group is preferred.

The content of the crosslinking group in the binder resin is not particularly limited but is preferably from 0.3 to 3.0 meq/g, more preferably from 1.0 to 3.0 meq/g, still more preferably from 1.5 to 2.8 meq/g. When the content is 0.3 meq/g or more, the amount of curing reaction is sufficiently large and high sensitivity is obtained, and when the content is 3.0 meq/g or less, storage stability of the curable composition can be enhanced.

The content (meg/g) above can be measured, for example, by iodine value titration.

The crosslinking group-containing resin (hereinafter, sometimes referred to as specified binder resin A; the specified binder resin A is preferably an alkali-soluble binder) usable in the present invention preferably has, in its structure, an acid group for letting the resin become more unfailingly alkali-soluble and a crosslinking group, so as to enhance various performances such as removability of non-image area. The binder resin having such a partial structure is described in detail in JP-A-2003-262958, and the compounds described therein can be used also in the present invention.

Examples of the binder resin having a crosslinking group are described below, but the binder resin is not limited thereto as long as an alkali-soluble group such as COOH group and OH group and a crosslinking group are contained in the molecule:

(1) a urethane-modified polymerizable double bond-containing acrylic resin obtained by reacting a compound which has one unreacted isocyanate group remaining after previously reacting an isocyanate group and an OH group and contains at least one (meth)acryloyl group, with a carboxyl group-containing acrylic resin;
(2) an unsaturated group-containing acrylic resin obtained by reacting a carboxyl group-containing acrylic resin with a compound having both an epoxy group and a polymerizable double bond within the molecule; and
(3) a polymerizable double bond-containing acrylic resin obtained by reacting an OH group-containing acrylic resin with a dibasic acid anhydride having a polymerizable double bond.

Among these, the resins of (1) and (2) are preferred.

The crosslinking group-containing binder polymer usable in the present invention may be a binder polymer having at least one polymerizable group, such as a polymer having at least one ethylenically unsaturated double bond or an epoxy acrylate polymer.

The polymer having at least one ethylenically unsaturated double bond preferably further has at least one acid group.

The acid group includes those described above, but in view of raw material availability, a carboxyl group is preferred.

As the crosslinking group in the specified binder resin A, for example, a (meth)acryl group such as (meth) acrylate group and (meth)acrylamide group, and various polymerizable double bonds such as vinyl ester, vinyl ether or allyl ether of carboxylic acid, can be used. Specific examples of the specified binder resin A include a compound obtained by adding a cyclic ether group-containing polymerizable compound such as glycidyl acrylate, glycidyl methacrylate and glycidyl ester of an unsaturated fatty acid (e.g., cinnamic acid), or an epoxy group-containing polymerizable compound such as compound having an alicylcic epoxy group (for example, having an epoxy group such as cyclohexene oxide in the same molecule) and a (meth)acryloyl group, to an acrylic resin containing a carboxyl group as the acid group. Other examples include a compound obtained by adding an isocyanate group-containing polymerizable compound such as isocyanatoethyl (meth)acrylate to an acrylic resin containing an acid group and a hydroxyl group; a compound obtained by adding a hydroxyl group-containing polymerizable compound such as hydroxyalkyl (meth)acrylate to an acrylic resin containing an anhydride group; and a compound obtained by copolymerizing a cyclic ether group-containing polymerizable compound such as glycidyl methacrylate with a vinyl monomer such as (meth)acryloyl alkyl ester and adding a (meth)acrylic acid to an epoxy group in the side chain.

Examples of these compounds include those described in Japanese Patent 2,763,775, JP-A-3-172301 and JP-A-2000-232264.

Among these, the specified binder resin A is preferably either one polymer compound selected from a compound obtained by adding a cyclic ether group (for example, a group having an epoxy group or an oxetane group in a partial structure)-containing polymerizable compound to a part of an acid group of a polymer compound, and a compound obtained by adding a carboxyl group-containing polymerizable compound to a part or all of cyclic ether groups of a polymer compound. At this time, the addition reaction between an acid group and a cyclic ether group-containing compound is preferably performed in the presence of a catalyst, and it is particularly preferred that the catalyst is selected from an acidic compound and a neutral compound.

Above all, in view of development stability with aging of the curable composition for a solid-state imaging device, the specified binder resin A is preferably a polymer compound containing a carboxyl group in the side chain and at the

same time, containing an aromatic group which may contain a heterocyclic ring, and an ethylenically unsaturated bond in the side chain.

Examples of the aromatic group which may contain a heterocyclic ring (hereinafter, sometimes simply referred to as "aromatic group") include a benzene ring, a condensed ring formed by fusing 2 or 3 benzene rings, and a condensed ring formed by fusing a benzene ring and a 5-membered unsaturated ring.

Specific examples of the aromatic group include a phenyl group, a naphthyl group, an anthryl group, a phenanthryl group, an indenyl group, an acenaphthenyl group, a fluorenyl group, a benzopyrrole ring group, a benzofuran ring group, a benzothiophene ring group, a pyrazole ring group, an isoxazole ring group, an isothiazole ring group, an indazole ring group, a benzisoxazole ring group, a benzisothiazole ring group, an imidazole ring group, an oxazole ring group, a thiazole ring group, a benzimidazole ring group, a benzoxazole ring group, a benzothiazole ring group, a pyridine ring group, a quinoline ring group, an isoquinoline ring group, a pyridazine ring group, a pyrimidine ring group, a pyrazine ring group, a phthalazine ring group, a quinazoline ring group, a quinoxaline ring group, an aciridine ring group, a phenanthridine ring group, a carbazole ring group, a purine ring group, a pyran ring group, a piperidine ring group, a piperazine ring group, an indole ring group, an indolizine ring group, a chromene ring group, a cinnoline ring group, an acridine ring group, a phenothiazine ring group, a tetrazole ring group, and a triazine ring group. Among these, a hydrocarbon aromatic group is preferred, and a phenyl group and a naphthyl group are more preferred.

The aromatic group may have a substituent, and examples of the substituent include a halogen atom, an amino group which may have a substituent, an alkoxycarbonyl group, a hydroxyl group, an ether group, a thiol group, a thioether group, a silyl group, a nitro group, a cyano group, and alkyl, alkenyl, alkynyl, aryl group and heterocyclic groups each of which may have a substituent.

The content of the acid group in the specified binder resin A is preferably from 1.0 to 4.0 meq/g, more preferably from 1.5 to 3.0 meq/g. When the content of the acid group is 1.0 meq/g or more, satisfactory alkali developability is obtained and an excellent pattern can be more unfailingly obtained. Also, when the content is 4.0 meq/g or less, the fear of impairing the strength of the permanent pattern can be reliably avoided.

The preferred range of the content of the cross linking group in the specified binder resin A is the same as the preferred range described above for the content of the crosslinking group in the alkali-soluble binder.

Another preferred example of the binder resin for use in the present invention is at least either one of a polyamide-based resin and a polyimide-based resin (hereinafter, sometimes referred to as specified binder resin B). The specified binder resin B includes, for example, a polyamide resin, a polyimide resin, a silicon-containing polyimide resin, a polyimidesiloxane resin, and a polymaleimide resin.

The polyamide resin for use in the present invention includes a polyamide acid (polyamic acid), and the polyimide resin for use in the present invention is formed, for example, by thermal ring-closing imidization of the polyamic acid above as a precursor.

The polyamic acid used for the synthesis of the polyamide resin and the polyimide resin usually contains a structural unit represented by the following formula (IV) as the main component:

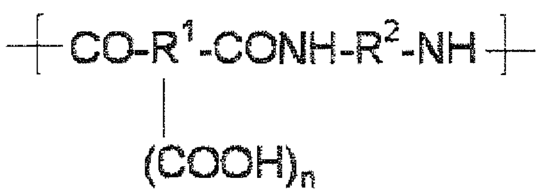

Formula (IV)

In formula (IV), n represents an integer of 0 to 4. $R^1$ is an acid component residue and represents a trivalent or tetravalent organic group containing at least two carbon atoms.

In view of heat resistance, $R^1$ is preferably a trivalent or tetravalent group containing a cyclic hydrocarbon, an aromatic ring or an aromatic heterocyclic ring and having a carbon number of 6 to 30.

Examples of the organic group represented by $R^1$ include, but are not limited to, a group derived from a phenyl group, a biphenyl group, a terphenyl group, a naphthalene group, a perylene group, a diphenyl ether group, a diphenylsulfone group, a diphenylpropane group, a benzophenone group, a biphenyl trifluoropropane group, a cyclobutyl group, and a cyclopentyl group. Above all, $R^1$ is preferably a phenyl group or a cyclobutyl group.

$R^2$ represents a divalent organic group containing at least two carbon atoms. In view of heat resistance, $R^2$ is preferably a divalent group containing a cyclic hydrocarbon, an aromatic ring or an aromatic heterocyclic ring and having a carbon number of 6 to 30.

Examples of the divalent organic group represented by $R^2$ include, but are not limited to, a divalent group

derived from a phenyl group, a biphenyl group, a terphenyl group, a naphthalene group, a perylene group, a diphenyl ether group, a diphenylsulfone group, a diphenylpropane group, a benzophenone group, a biphenyl trifluoropropane group, a diphenylmethane group, and a cyclohexylmethane group. Above all, $R^2$ is preferably a diphenyl ether group, a diphenylsulfone group, a diphenylpropane group or a diphenylmethane group.

The polymer containing a structural unit represented by formula (IV) as the main component may be a homopolymer containing only one structural unit represented by formula (IV) or a copolymer containing two or more structural units represented by formula (IV) differing from each other.

Also, a structural unit other than the structural unit represented by formula (IV) may be contained as a copolymerization component.

Still another preferred example of the binder resin for use in the present invention is a urethane resin (hereinafter, sometimes referred to as specified binder resin C). Here, the specified binder resin C may have a crosslinking group in the side chain.

The crosslinking group which may be contained in the side chain of the specified binder resin C include a functional group represented by any one of the following formulae (C-1) to (C-3). The functional groups represented by formulae (C-1) to (C-3) are described below.

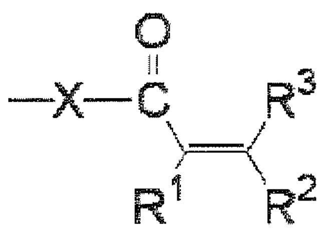

(C-1)

In formula (C-1), each of $R^1$ to $R^3$ independently represents a hydrogen atom or a monovalent organic group. $R^1$ is preferably a hydrogen atom or an alkyl group which may have a substituent, and because of high radical reactivity, more preferably a hydrogen atom or a methyl group. Also, each of $R^2$ and $R^3$ is independently, for example, a hydrogen, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and because of high radical reactivity, preferably a hydrogen atom, a carboxyl group, an alkoxycarbonyl group, an alkyl group which may have a substituent, or an aryl group which may have a substituent.

X represents an oxygen atom, a sulfur atom, or -N($R^{12}$)-, and $R^{12}$ represents a hydrogen atom or a monovalent organic group. Here, $R^{12}$ includes, for example, an alkyl group which may have a substituent, and because of high radical reactivity, is preferably a hydrogen atom, a methyl group, an ethyl group, or an isopropyl group.

Examples of the substituent which can be introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group, and an arylsulfonyl group.

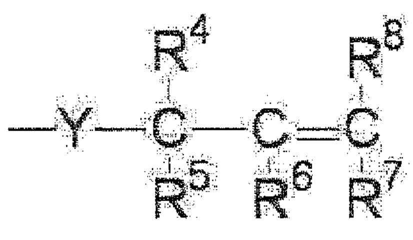

(C-2)

In formula (C-2), each of $R^4$ to $R^8$ independently represents a hydrogen atom or a monovalent organic group. Each of $R^4$ to $R^8$ is preferably, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a

substituent, and more preferably a hydrogen atom, a carboxyl group, an alkoxycarbonyl group, an alkyl group which may have a substituent, or an aryl group which may have a substituent.

Examples of the substituent which can be introduced are the same as those described in formula (C-1). Y represents an oxygen atom, a sulfur atom, or $-N(R^{12})-$. $R^{12}$ has the same meaning as $R^{12}$ in formula (C-1) and the preferred examples are also the same.

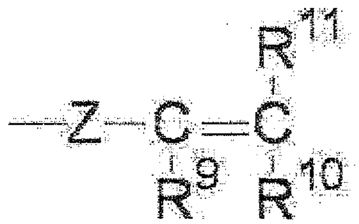

(C-3)

In formula (C-3), $R^9$ is preferably, for example, a hydrogen atom or an alkyl group which may have a substituent, and because of high radical reactivity, more preferably a hydrogen atom or a methyl group. Each of $R^{10}$ and $R^{11}$ is independently, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and because of high radical reactivity, preferably a hydrogen atom, a carboxyl group, an alkoxycarbonyl group, an alkyl group which may have a substituent, or an aryl group which may have a substituent.

Examples of the substituent which can be introduced are the same as those of the substituent which can be introduced in formula (C-1). Z represents an oxygen atom, a sulfur atom, $-N(R^{13})-$, or a phenylene group which may have a substituent. $R^{13}$ is, for example, an alkyl group which may have a substituent, and because of high radical reactivity, preferably a methyl group, an ethyl group or an isopropyl group.

The basic skeleton of the specified binder resin C for use in the present invention is described below.

The specified binder resin C for use in the present invention is a polyurethane resin having, as the basic skeleton, a structural unit as a reaction product of at least one diisocyanate compound represented by the following formula (C-4) and at least one diol compound represented by formula (C-5):

$$OCN\text{-}X^0\text{-}NCO \qquad (C\text{-}4)$$

$$HO\text{-}Y^0\text{-}OH \qquad (C\text{-}5)$$

In formulae (C-4) and (C-5), each of $X^0$ and $Y^0$ independently represents a divalent organic residue.

As long as at least either one of the diisocyanate compound represented by formula (C-4) and the diol compound represented by formula (C-5) has at least one of the groups represented by formulae (C-1) to (C-3), a polyurethane resin having introduced into the side chain thereof a group represented by formulae (C-1) to (C-3) is produced as a reaction product of the diisocyanate compound and the diol compound. According to such a method, a polyurethane resin having a crosslinking group in the side chain can be more easily produced than substitution on or introduction into the desired side chain after the reaction and production of the polyurethane resin.

1) Diisocyanate compound

The diisocyanate compound represented by formula (C-4) includes, for example, a product obtained by an addition reaction of a triisocyanate compound with 1 equivalent of a crosslinking group-containing monofunctional alcohol or a monofunctional amine compound.

Specific examples of the compound above for obtaining the diisocyanate compound are described in paragraphs [0034] to [0040] of JP-A-2006-63550, and the compounds described therein can be used. Also, compounds having a polymerizable group in the side chain described in paragraphs [0042] to [0049] of the same patent publication are preferably used as the diisocyanate compound.

2) Diol compound

The diol compound represented by formula (C-5) widely includes, for example, a polyether diol compound, a polyester diol compound, and a polycarbonate diol compound.

In the case where the specified binder resin C has a crosslinking group in the side chain, as the method for obtaining this specified binder resin C, a method where a diol compound having an unsaturated group in the side chain is used as a raw material for the production of a polyurethane resin, is also preferred, in addition to the above-described method. The diol compound may be, for example, a commercially available product such as trimethylolpropane monoallyl ether, or may be a compound easily produced by the reaction of a halogenated diol compound, a triol compound or an aminodiol compound with an unsaturated group-containing carboxylic acid, an acid chloride, an isocyanate, an alcohol, an amine, a thiol or an alkyl halide compound. Specific examples of such a compound include those described in paragraphs [0057] to [0066] of patent publication above, and the compounds described therein can be suitably used also in the present invention..

In the synthesis of the specified binder resin C, in addition to the diol compound above, a diol compound having a carboxyl group may be also used in combination.

Examples of this diol compound include those shown by formulae (17) to (19) in the patent publication above, and specific examples thereof include 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl) acetic acid, 2,2-bis(hydroxymethyl)butyric acid, 4,4-bis(4-hydroxyphenyl)pentanoic acid, tartaric acid, N,N-dihydroxyethylglycine, and N,N-bis(2-hydroxyethyl)-3-carboxy-propionamide.

The presence of such a carboxyl group is preferred, because characteristics such as hydrogen bonding property and alkali solubility can be imparted to the specified binder resin C.

The polyurethane resin having a crosslinking group in the side chain is more preferably a resin having a carboxyl group in the side chain. More specifically, a polyurethane resin containing, as equivalent, 0.3 meq/g or more, preferably from 0.35 to 1.50 meq/g, of an ethylenically unsaturated bond group in the side chain and at the same time, containing 0.4 meq/g or more, preferably from 0.45 to 1,00 meq/g, of a carboxyl group in the side chain is particularly preferred as the binder polymer for use in the present invention.

The binder resin is preferably at least either one of a polyamide-based resin and a polyimide-based resin, more preferably a polyamide-based resin.

The weight average molecular weight of the binder polymer which can be used in the curable composition for a solid-state imaging device of the present invention is preferably 3,000 or more, more preferably from 5,000 to 300,000, and most preferably from 10,000 to 30,000, and the number average molecular weight is preferably 1,000 or more, more preferably from 2,000 to 250,000. The polydispersity (weight average molecular weight/number average molecular weight) is preferably 1 or more, more preferably from 1.1 to 10.

The binder resin may be any of a random polymer, a block polymer, a graft polymer and the like.

The binder resin usable in the present invention can be synthesized by a conventionally known method. Examples of the solvent used at the synthesis include tetrahydrofuran, ethylene dichloride, cyclohexanone, propylene glycol monomethyl ether, propylene glycol monomethyl ether acetate, and butyl acetate. One of these solvents may be used alone, or two or more thereof may be mixed and used.

The radical polymerization initiator used when the binder resin usable in the curable composition for a solid-state imaging device is synthesized from a vinyl bond-containing monomer, includes known compounds such as azo-based initiator and peroxide initiator.

As the binder resin for use in the present invention, an acetal-modified polyvinyl alcohol-based binder resin having an acid group described, for example, in European Patents 993,966 and 1,204,000 and JP-A-2001-318463 is preferred because of excellent balance between film strength and developability. In addition, a water-soluble linear organic polymer such as polyvinylpyrrolidone and polyethylene oxide is useful. Also, an alcohol-soluble nylon, a polyether of 2,2-bis-(4-hydroxyphenyl)-propane and epichlorohydrin, and the like are useful for increasing the strength of the cured film.

Other examples include a polymer compound having an acid group and an ethylenically unsaturated bond in the side chain and having a bisphenol A-type skeleton and a bisphenol F-type skeleton, a novolak resin having an acidic group and an ethylenically unsaturated bond, and a resol resin. These resins can be obtained by the technique described in paragraphs [0008] to [0027] of JP-A-11-240930.

In addition, as the binder resin for use in the present invention, a resin obtained by adding an acid anhydride to a hydroxyl group-containing polymer, a polyhydroxystyrene-based resin, a polysiloxane-based resin, poly(2-hydroxyethyl (meth)acrylate), polyvinylpyrrolidone, polyethylene oxide, polyvinyl alcohol, and the like are also useful. The binder resin may be also a resin obtained by copolymerizing a monomer having hydrophilicity. Examples thereof include an alkoxyalkyl (meth)acrylate, a hydroxyalkyl (meth)acrylate, glycerol (meth)acrylate, a (meth)acrylamide, an N-methylolacrylamide, a secondary or tertiary alkylacrylamide, a dialkylaminoalkyl (meth)acrylate, a morpholine (meth)acrylate,

an N-vinylpyrrolidone, an N-vinylcaprolactam, a vinylimidazole, a vinyl triazole, a methyl (meth)acrylate, an ethyl (meth) acrylate, a branched or linear propyl (meth)acrylate, a branched or linear butyl (meth)acrylate, and a phenoxyhydroxypropyl (meth)acrylate. As the monomer having hydrophilicity, for example, a monomer containing a tetrahydrofurfuryl group, a phosphoric acid group, a phosphoric acid ester group, a quaternary ammonium salt group, an ethyleneoxy chain, a propyleneoxy chain, a sulfonic acid group or a group derived from a salt thereof, or a morpholinoethyl group is useful.

Moreover, the binder resin for use in the present invention not only can enhance the coating formability when applying the curable composition for a solder resist of a solid-state imaging device but also, by selecting the kind of the binder resin, can enhance the toughness or insulation reliability of the solder resist film formed. For example, when an epoxy acrylate-containing resin, a polyamide(imide)-containing resin, a polyimide precursor, a copolymer formed by containing a benzyl (meth)acrylate monomer and a (meth)acrylic acid monomer, or a copolymer formed by containing an allyl (meth)acrylate monomer and a (meth)acrylic acid is selected as the binder resin, strength of the cured film by exposure is improved and toughness and insulation reliability of the solder resist obtained by exposing and developing the curable composition for a solder resist of a solid-state imaging device are improved.

The content of the binder resin is preferably from 5 to 80 mass%, more preferably from 10 to 70 mass%, based on the entire solid content by mass of the curable composition for a solid-state imaging device of the present invention.

When the content is in this range, the exposure sensitivity is high, the processing time can be short, and good heat/cold shock resistance is obtained.

[5] Dispersant

The curing composition for a solid-state imaging device of the present invention may be dispersed using a known dispersant for the purpose of enhancing the dispersibility and dispersion stability of the infrared-blocking material in the curable composition.

Examples of the dispersant usable in the present invention include a polymer dispersant (such as polyamide amine and a salt thereof, polycarboxylic acid and a salt thereof, high-molecular-weight unsaturated acid ester, modified polyurethane, modified polyester, modified poly(meth)acrylate, (meth)acrylic copolymer, and naphthalene sulfonic acid formalin condensate), and a surfactant such as polyoxyethylene alkylphosphate, polyoxyethylene alkylamine and alkanolamine.

The polymer dispersant can be classified into a linear polymer, a terminal-modified polymer, a graft polymer, and a block polymer, by its structure.

Examples of the terminal-modified polymer having an anchor moiety to the surface include a polymer having a phosphoric acid group at the terminal described in JP-A-3-112992 and JP-T-2003-533455 (the term "JP-T" as used herein means a published Japanese translation of a PCT patent application), a polymer having a sulfonic acid group at the terminal described in JP-A-2002-273191, a polymer having an organic dye partial skeleton or a heterocyclic ring described in JP-A-9-77994, and a polymer produced by modifying an oligomer or polymer having a hydroxyl group or an amino group at one end with an acid anhydride described in JP-A-2008-29901. Furthermore, a polymer in which two or more anchor moieties (for example, an acid group, a basic group, an organic dye partial skeleton, or a heterocyclic ring) to the infrared-blocking material surface are introduced into the polymer terminal, described in JP-A-2007-277514, is also preferred because of its excellent dispersion stability.

Examples of the graft polymer having an anchor moiety to the surface include a reaction product of a poly (lower alkyleneimine) and a polyester described in JP-A-54-37082, JP-T-8-507960 and JP-A-2009-258668, a reaction product of a polyallylamine and a polyester described in JP-A-9-169821, an amphoteric dispersant resin having a basic group and an acidic group described in JP-A-2009-203462, a copolymer of a macromonomer and a nitrogen atom monomer described in JP-A-10-339949 and JP-A-2004-37986, a graft polymer having an organic dye partial skeleton or a heterocyclic ring described in JP-A-2003-238837, JP-A-2008-9426 and JP-A-2008-81732, and a copolymer of a macromonomer and an acid group-containing monomer described in JP-A-2010-106268.

As the macromonomer used when a graft polymer having an anchor moiety to surface is produced by radical polymerization, a known macromonomer can be used, and examples thereof include macromonomers AA-6 (polymethyl methacrylate in which the terminal group is methacryloyl group), AS-6 (polystyrene in which the terminal group is methacryloyl group), AN-6S (a copolymer of styrene and acrylonitrile, in which the terminal group is methacryloyl group), and AB-6 (polybutyl acrylate in which the terminal group is methacryloyl group) produced by Toagosei Co., Ltd.; PLACCEL FM5 (ε-caprolactone 5-mol equivalent adduct of 2-hydroxyethyl methacrylate), and FA10L (ε-caprolactone 10-mol equivalent adduct of 2-hydroxyethyl acrylate) produced by Daicel Chemical Industries; and a polyester-based macromonomer described in JP-A-2-272009. Among these, a polyester-based macromonomer excellent particularly in flexibility and affinity for solvent is preferred in view of dispersibility and dispersion stability of the infrared-blocking material in the curable composition and developability of the curable composition using the infrared-blocking material. A polyester-based macromonomer represented by the polyester-based macromonomer described in JP-A-2-272009 is most preferred.

As the block polymer having an anchor moiety to surface, block polymers described in JP-A-2003-49110 and JP-A-2009-52010 are preferred.

The dispersant used can be appropriately selected from, for example, know dispersants and surfactants.

Specific examples thereof include "Disperbyk-101 (polyamidoamine phosphate), 107 (carboxylic acid ester), 110 (acid group-containing copolymer), 130 (polyamide), 161, 162, 163, 164, 165, 166 and 170 (high molecular copolymer)", and "BYK-P104, P105 (high-molecular-weight unsaturated polycarboxylic acid)" produced by BYK Chemie; "EFKA 4047, 4050-4010-4165 (polyurethane type), EFKA 4330-4340 (block copolymer), 4400-4402 (modified polyacrylate), 5010 (polyesteramide), 5765 (high-molecular-weight polycarboxylate), 6220 (fatty acid polyester), and 6745 (phthalocyanine derivative)" produced by EFKA; "AJISPER PB821, PB822, PB880 and PB881" produced by Ajinomoto-Fine-Techno Co., Inc.; "Florene TG-710 (urethane oligomer)" and "Polyflow No. 50E and No. 300 (acrylic copolymer)" produced by Kyoeisha Chemical Co., Ltd.; "Disparlon KS-860, 873SN, 874, #2150 (aliphatic polyvalent carboxylic acid), #7004 (polyether ester), DA-703-50, DA-705 and DA-725" produced by Kusumoto Chemicals Ltd.; "Demol RN, N (naphthalenesulfonic acid-formalin polycondensate), MS, C and SN-B (aromatic sulfonic acid-formalin polycondensate)", "Homogenol L-18 (polymer polycarboxylic acid)", "Emulgen 920, 930, 935 and 985 (polyoxyethylene nonylphenyl ether)" and "Acetamine 86 (stearylamine acetate)" produced by Kao Corporation; "Solsperse 5000 (phthalocyanine derivative), 13240 (polyesteramine), 3000, 17000, 27000 (polymer having a functional moiety at the terminal), 24000, 28000, 32000 and 38500 (graft-type polymer)" produced by The Lubrizol Corp.; "Nikkol T106 (polyoxyethylene sorbitan monooleate) and MYS-IEX (polyoxyethylene monostearate)" produced by Nikko Chemicals Co., Ltd.; T-8000E and the like produced by Kawaken Fine Chemicals, Ltd.; Organosiloxane Polymer KP341 produced by Shin-Etsu Chemical Co., Ltd.; "W001, cationic surfactant", nonionic surfactant such as polyoxyethylene lauryl ether, polyoxyethylene stearyl ether, polyoxyethylene oleyl ether, polyoxyethylene octyl phenyl ether, polyoxyethylene nonylphenyl ether, polyethylene glycol dilaurate, polyethylene glycol distearate, and sorbitan fatty acid ester, and anionic surfactant such as "W004, W005, and W017", produced by Yusho Co., Ltd.; "EFKA-46, EFKA-47, EFKA-47EA, EFKA POLYMER 100, EFKA POLYMER 400, EFKA POLYMER 401 and EFKA POLYMER 450" produced by Morishita Industries Co., Ltd.; polymer dispersant such as "Disperse Aid 6, Disperse Aid 8, Disperse Aid 15 and Disperse Aid 9100" produced by San Nopco Limited; "Adeka Pluronic L31, F38, L42, L44, L61, L64, F68, L72, P95, F77, P84, F87, P94, L101, P103, F108, L121, and P-123" produced by Adeka Corporation; and "Ionet (trade name) S-20" produced by Sanyo Chemical Industries, Ltd.

One of these dispersants may be used alone, or two or more thereof may be used in combination. Also, the dispersant for use in the present invention may be used in combination with an alkali-soluble resin, together with the above-described terminal-modified polymer having an anchor moiety to the infrared-blocking material surface, graft polymer or block polymer. The alkali-soluble resin includes a (meth)acrylic acid copolymer, an itaconic acid copolymer, a crotonic acid copolymer, a maleic acid copolymer, a partially esterified maleic acid copolymer, an acidic cellulose derivative having a carboxylic acid in the side chain, and a resin obtained by modifying a hydroxyl group-containing polymer with an acid anhydride, with a (meth)acrylic acid copolymer being preferred. In addition, an N-position-substituted maleimide monomer copolymer described in JP-A-10-300922, an ether dimer copolymer described in JP-A-2004-300204, and a polymerizable group-containing alkali-soluble resin described in JP-A-7-319161 are also preferred.

From the standpoint of dispersibility, developability and precipitation, the following resins described in JP-A-2010-106268 are preferred, and particularly, in view of dispersibility, a polymer dispersant having a polyester chain in the side chain is preferred. Also, in view of dispersibility and resolution of a pattern formed by photolithography, a resin having an acid group and a polyester chain is preferred. In view of adsorptive property, the acid group in the dispersant is preferably an acid group having a pKa of 6 or less, more preferably a carboxylic acid, a sulfonic acid or a phosphoric acid.

The dispersant resin described in JP-A-2010-106268, which is preferably used in the present invention, is described below.

The dispersant is preferably a graft copolymer containing, in the molecule, a graft chain having a number of atoms, excluding hydrogen atom, of 40 to 10,000 and being selected from a polyester structure, a polyether structure and a polyacrylate structure, and preferably contains a structural unit represented by any one of the following formulae (1) to (4), more preferably a structural unit represented by any one of the following formulae (1A), (2A), (3) and (4):

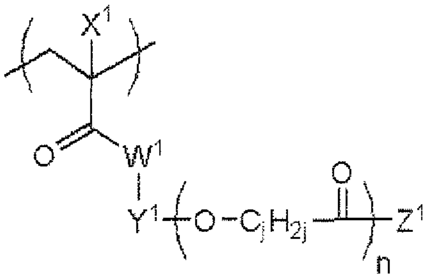

(1)

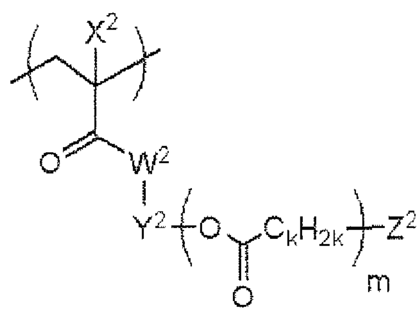

(2)

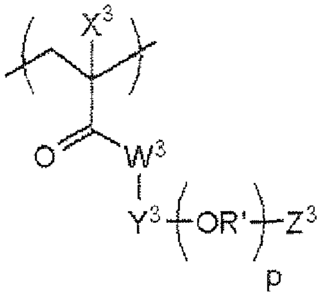

(3)

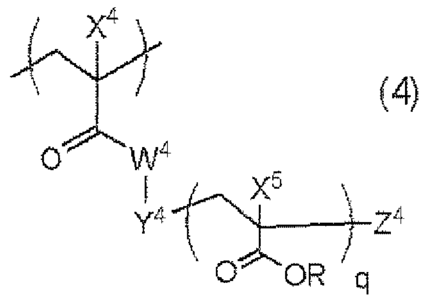

(4)

In formulae (1) to (4), each of $X^1$, $X^2$, $X^3$, $X^4$ and $X^5$ independently represents a hydrogen atom or a monovalent organic group and in view of restriction in the synthesis, is preferably a hydrogen atom or an alkyl group having a carbon number of 1 to 12, more preferably a hydrogen atom or a methyl group, still more preferably a methyl group.

In formulae (1) to (4), each of $W^1$, $W^2$, $W^3$ and $W^4$ independently represents an oxygen atom or NH and is preferably an oxygen atom.

In formula (3), R' represents a branched or linear alkylene group (the carbon number is preferably from 1 to 10, more preferably 2 or 3) and is preferably a group represented by$-CH_2-CH(CH_3)-$ or a group represented by $-CH(CH_3)-CH_2-$.

In formulae (1) to (4), each of $Y^1$, $Y^2$, $Y^3$ and $Y^4$ independently represents a divalent linking group and is not particularly restricted in view of structure. Specific examples thereof include the following linking groups (Y-1) to (Y-20). In the structures below, A and B indicate bonds to the left terminal group and the right terminal group, respectively, in formulae (1) to (4). Among the structures shown below, in view of easy synthesis, (Y-2) and (Y-13) are preferred.

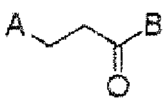

(Y-1)

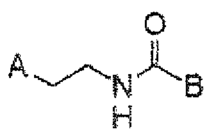

(Y-2)

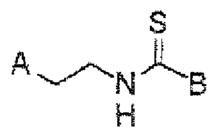

(Y-3)

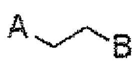

(Y-4)

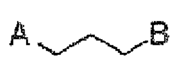

(Y-5)

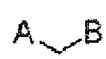

(Y-6)

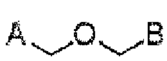

(Y-7)

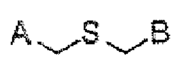

(Y-8)

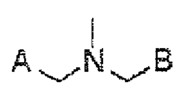

(Y-9)

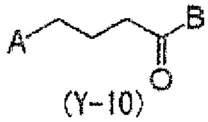
(Y-10)

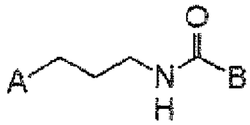
(Y-11)

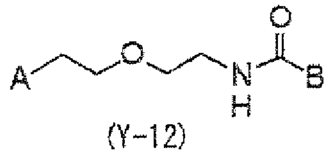
(Y-12)

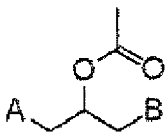
(Y-13)

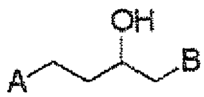
(Y-14)

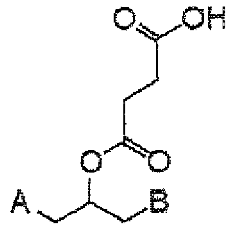
(Y-15)

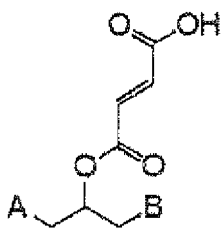
(Y-16)

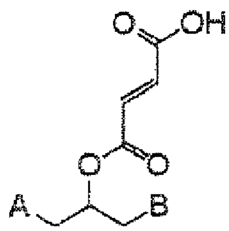
(Y-17)

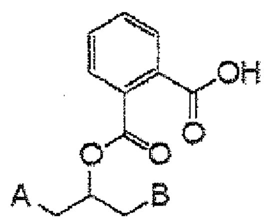
(Y-18)

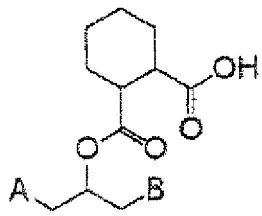
(Y-19)

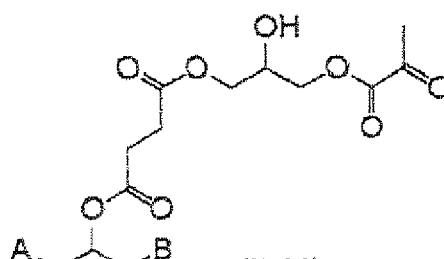
(Y-20)

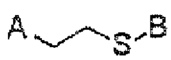
(Y-21)

In formulae (1) to (4), each of $Z^1$, $Z^2$, $Z^3$ and $Z^4$ independently represents a hydrogen atom or a monovalent substituent, and the structure of the substituent is not particularly limited. Specific examples thereof include an alkyl group, a hydroxyl group, an alkoxy group, an aryloxy group, a heteroaryloxy group, an alkylthloether group, an arylthioether group, a heteroarylthioether group and an amino group. Among these, from the standpoint of enhancing the dispersibility, those having a steric repulsion effect are preferred, and an alkyl group having a carbon number of 5 to 24 is preferred. Above all, a branched alkyl group having a carbon number of 5 to 24 or a cyclic alkyl group having a carbon number of 5 to 24 is preferred.

In formulae (1) to (4), each of n, m, p and q represents an integer of 1 to 500.

In formulae (1) and (2), each of j and k independently represents an integer of 2 to 8. In view of dispersion stability and developability, each of j and k in formulae (1) and (2) is preferably an integer of 4 to 6, and most preferably 5.

In formula (4), R represents a hydrogen atom or a monovalent organic group and is not particularly limited in its structure but is preferably a hydrogen atom, an alkyl group, an aryl group or a heteroaryl group, more preferably a hydrogen atom or an alkyl group. When R is an alkyl group, the alkyl group is preferably a linear alkyl group having a carbon number of 1 to 20, a branched alkyl group having a carbon number of 3 to 20, or a cyclic alkyl group having a carbon number of 5 to 20, more preferably a linear alkyl group having a carbon number of 1 to 20, still more preferably a linear alkyl group having a carbon number of 1 to 6.

As for R in formula (4), two or more R differing in the structure may be mixed and used in the specified resin.

In view of dispersion stability and developability, the structural unit represented by formula (1) is preferably a structural unit represented by the following formula (1A).

Also, in view of dispersion stability and developability, the structural unit represented by formula (2) is preferably a structural unit represented by the following formula (2A).

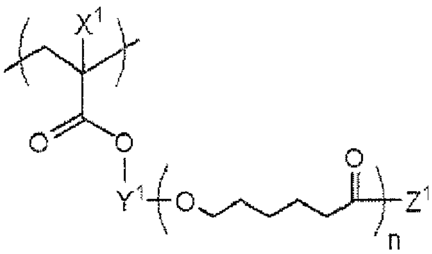
(1A)

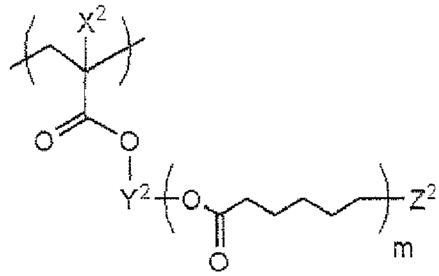
(2A)

In formula (1A), $X^1$; $Y^1$, $Z^1$ and n have the same meanings as $X^1$, $Y^1$, $Z^1$ and n in formula (1), and preferred ranges are also the same.

In formula (2A), $X^2$, $Y^2$, $Z^2$ and m have the same meanings as $X^2$, $Y^2$, $Z^2$ and m in formula (2), and preferred ranges are also the same.

Specific examples include the compounds illustrated below. In the compounds illustrated below, the numerical value attached to each structural unit (the numerical value attached to the repeating unit of the main chain) indicates the content [% by mass; shown as "At%"] of the structural unit. The numerical value attached to the repeating unit of the side chain indicates the number of repetitions of the repeating unit.

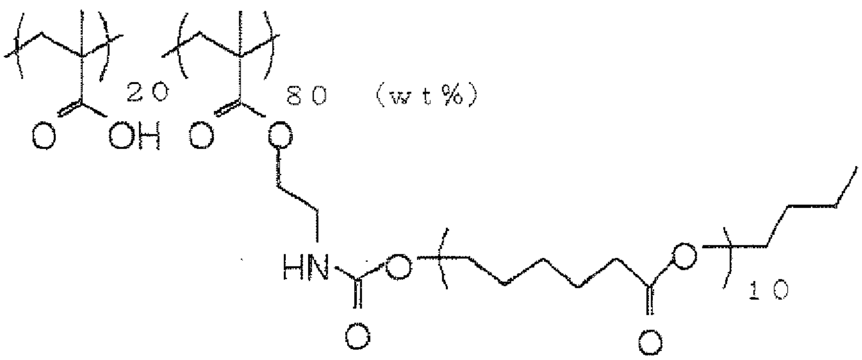
(Exemplified Compound 1)

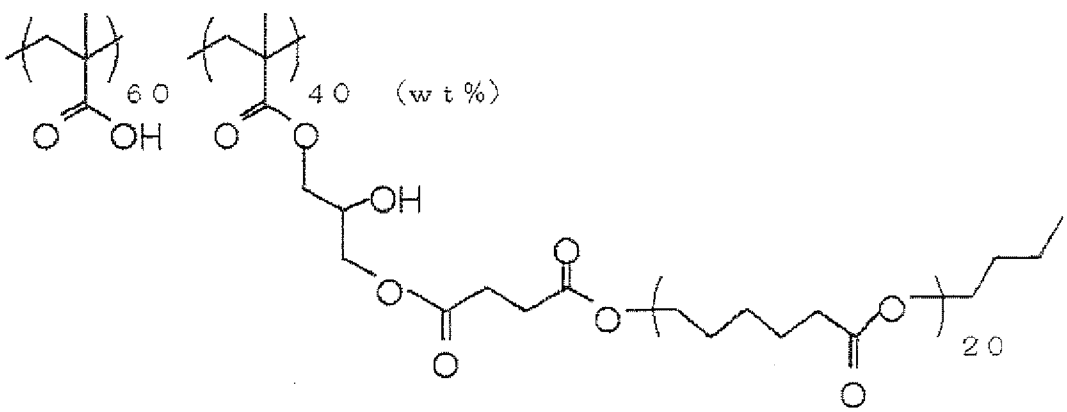
(Exemplified Compound 2)

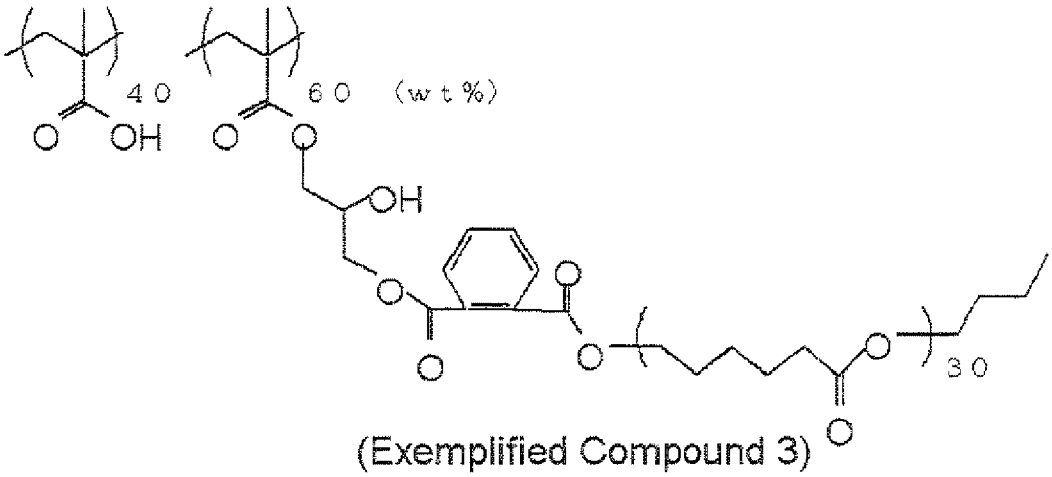

(Exemplified Compound 3)

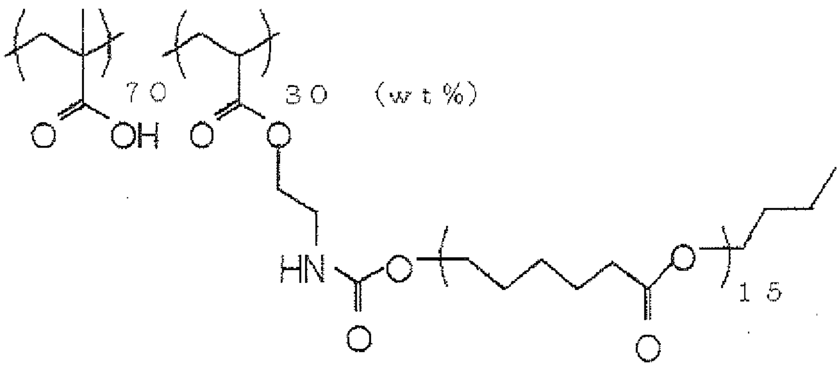

(Exemplified Compound 4)

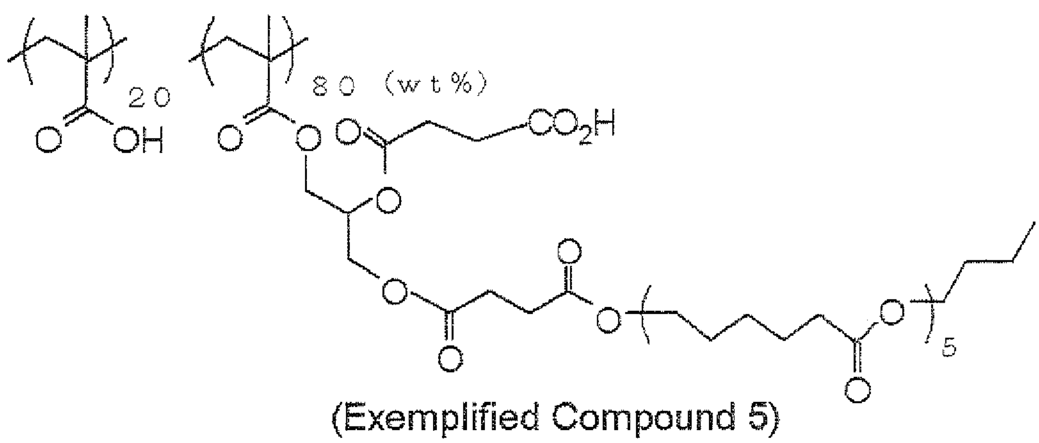

(Exemplified Compound 5)

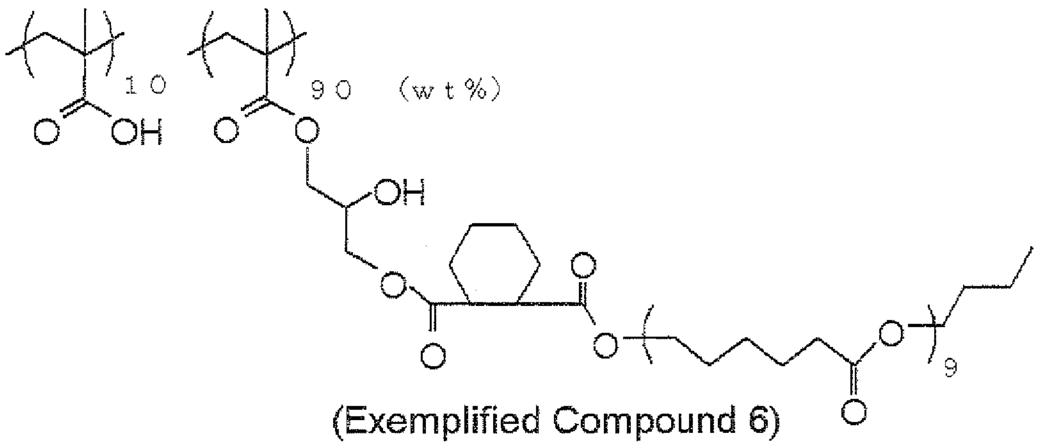

(Exemplified Compound 6)

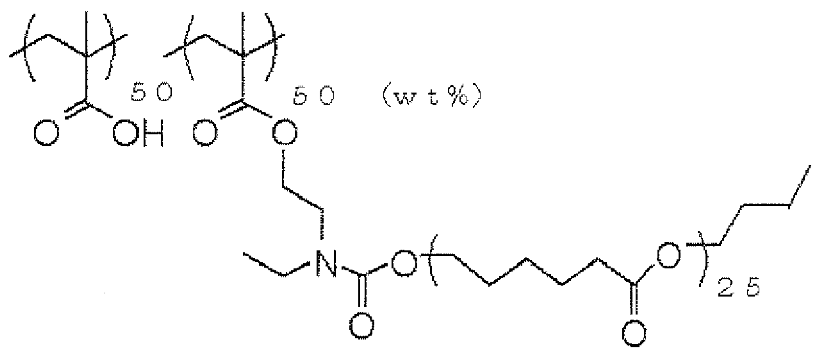

(Exemplified Compound 7)

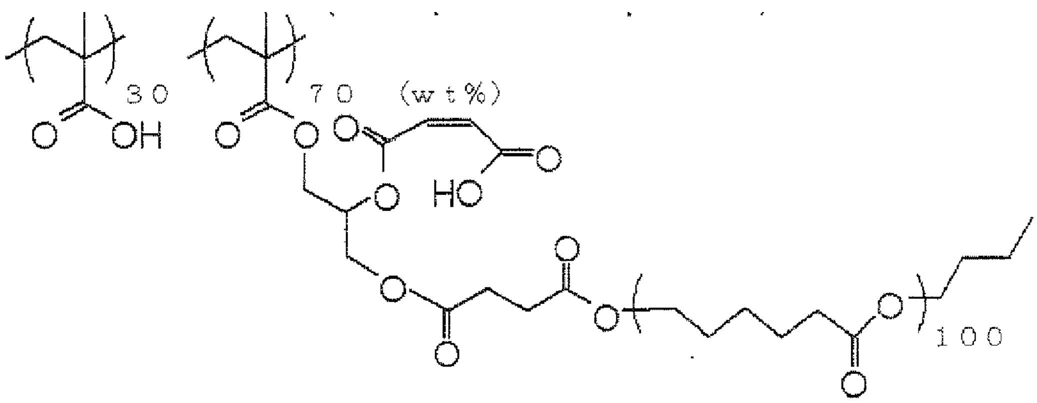

(Exemplified Compound 8)

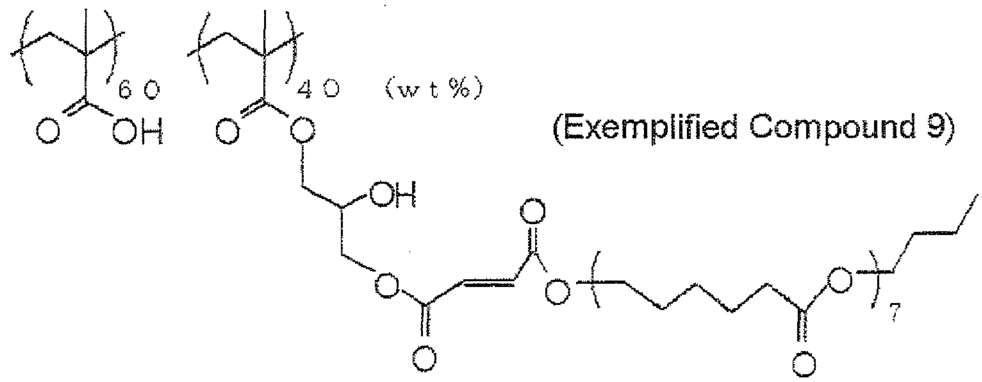

(Exemplified Compound 9)

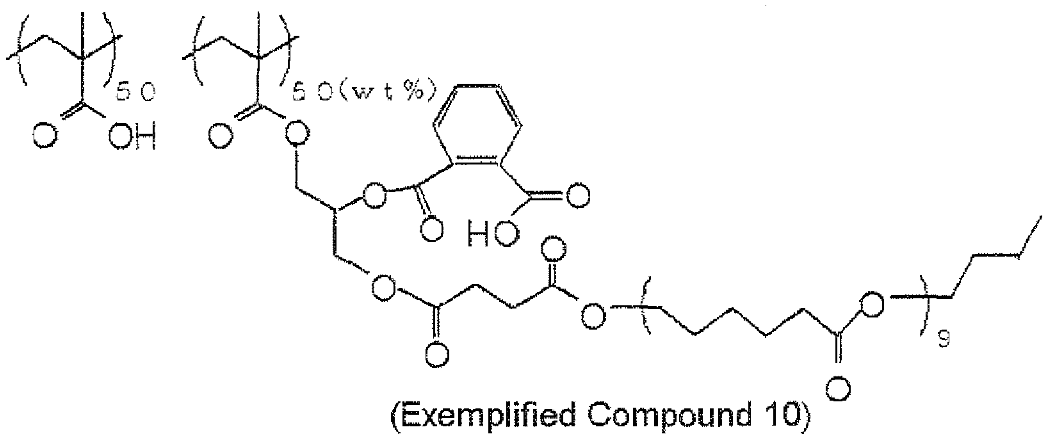

(Exemplified Compound 10)

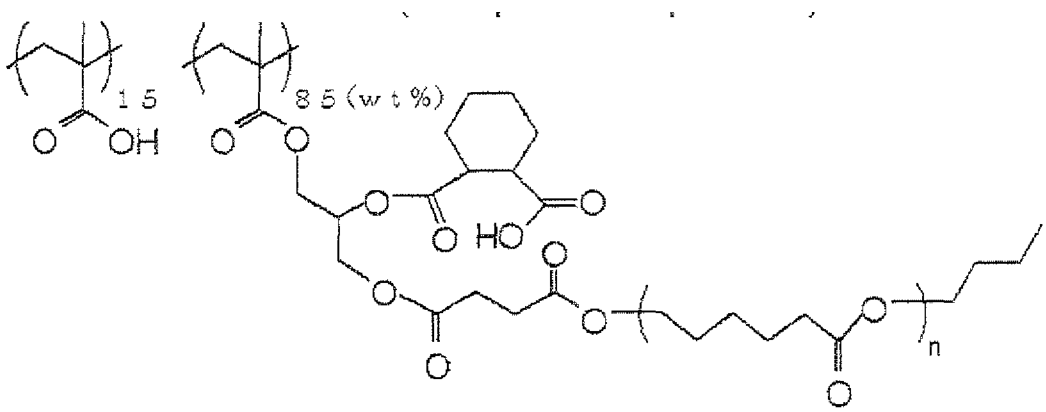

(Exemplified Compound 11) (n=5~20)

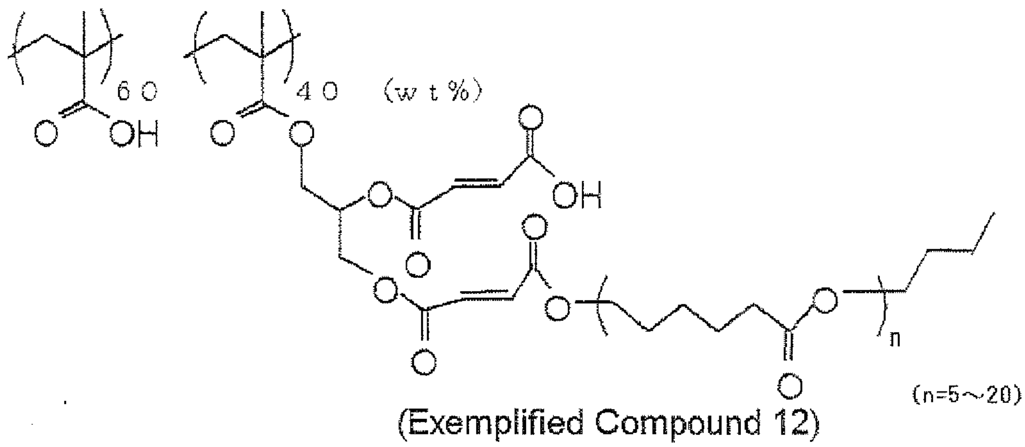

(Exemplified Compound 12)

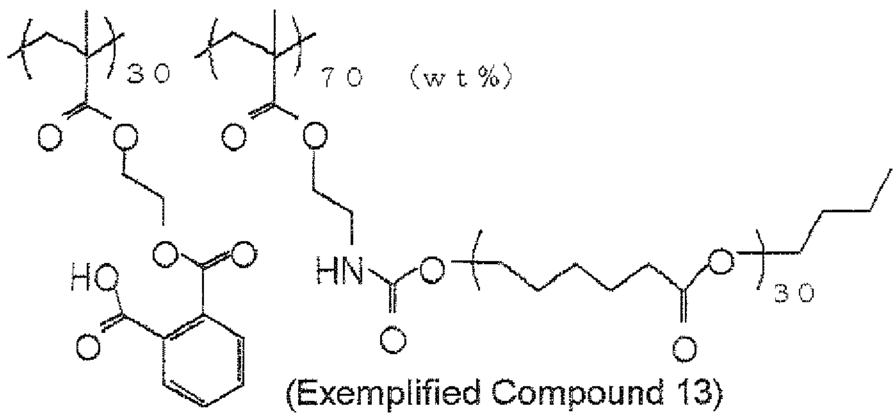

(Exemplified Compound 13)

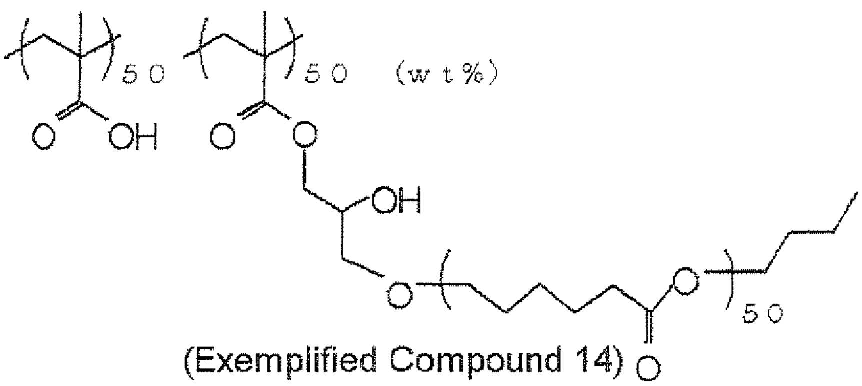

(Exemplified Compound 14)

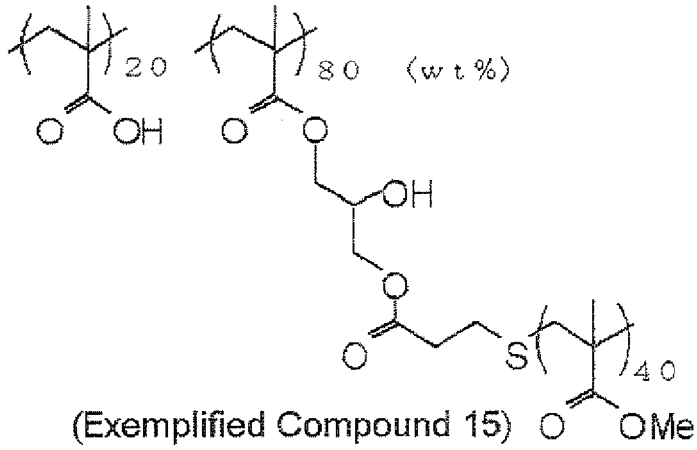

(Exemplified Compound 15)

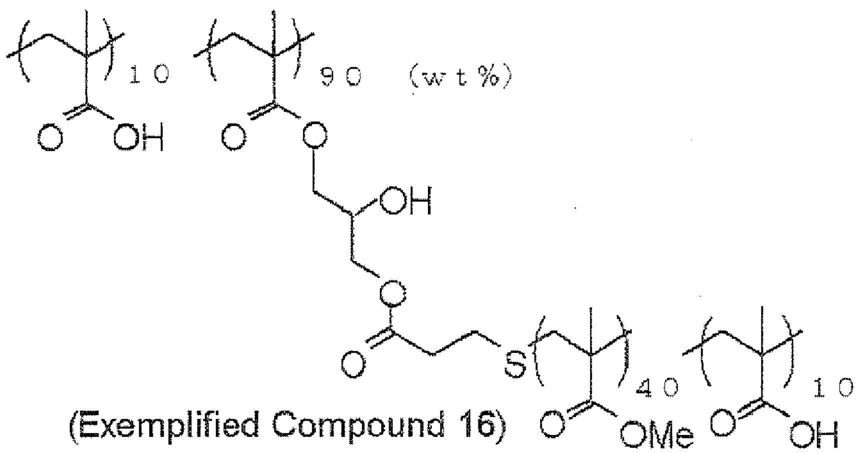

(Exemplified Compound 16)

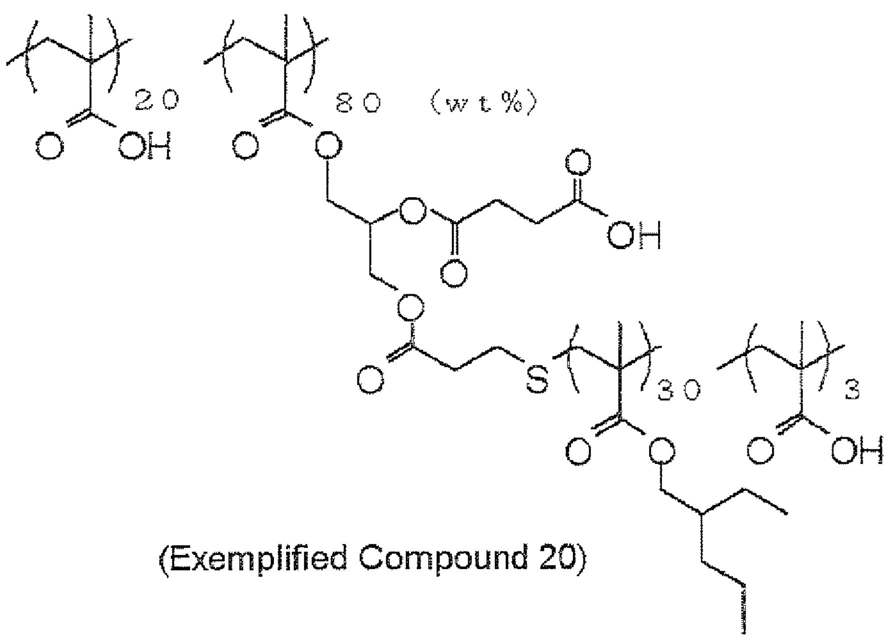

(Exemplified Compound 20)

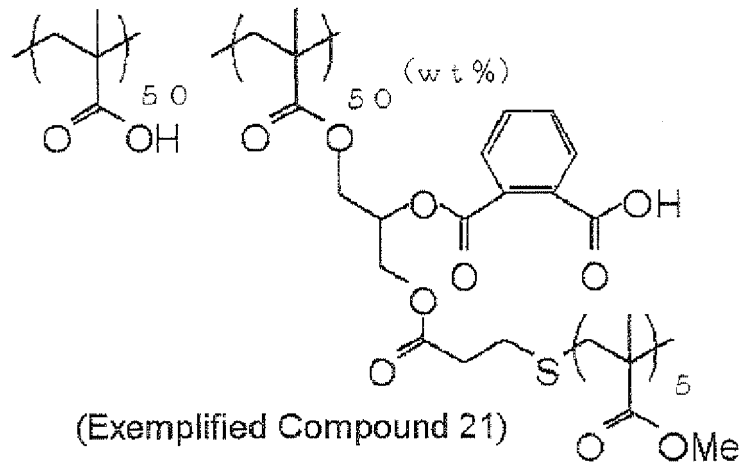

(Exemplified Compound 21)

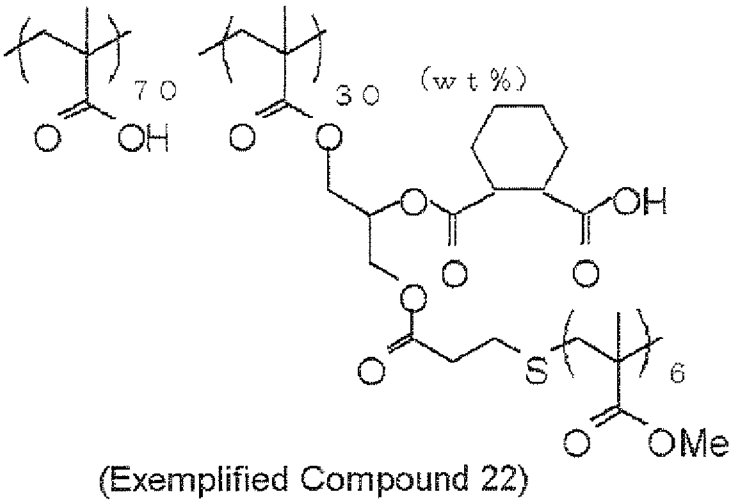

(Exemplified Compound 22)

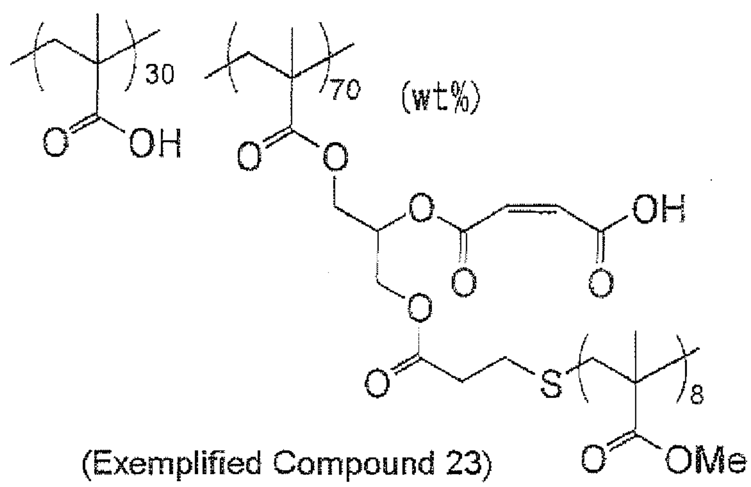

(Exemplified Compound 23)

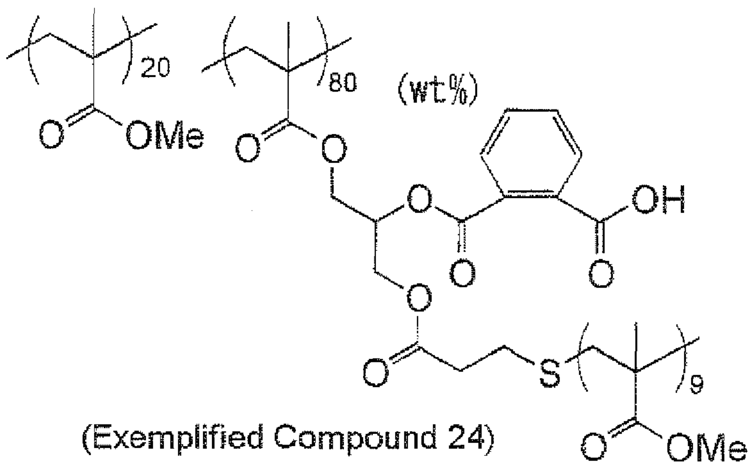

(Exemplified Compound 24)

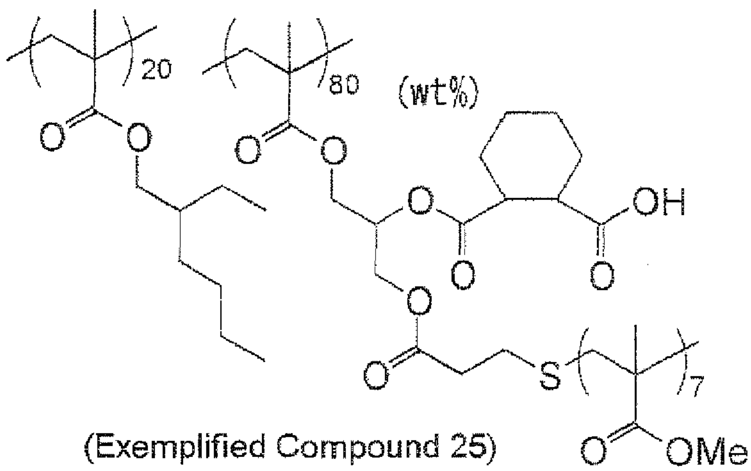

(Exemplified Compound 25)

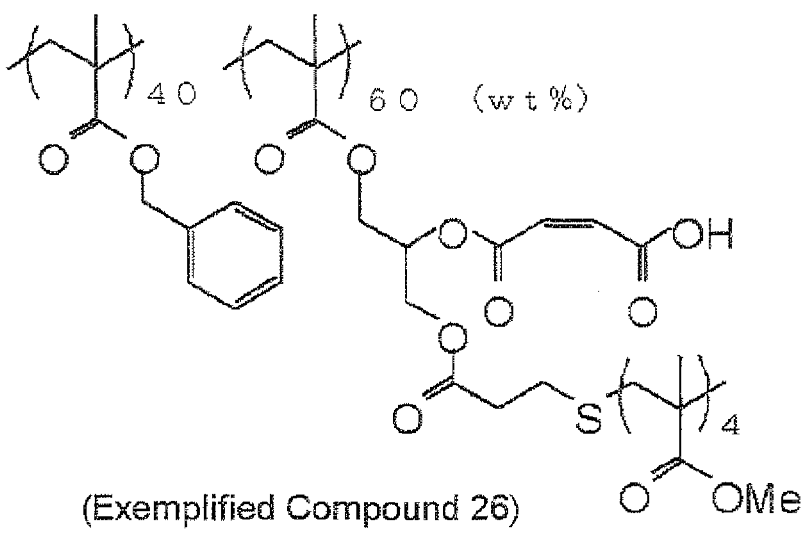

(Exemplified Compound 26)

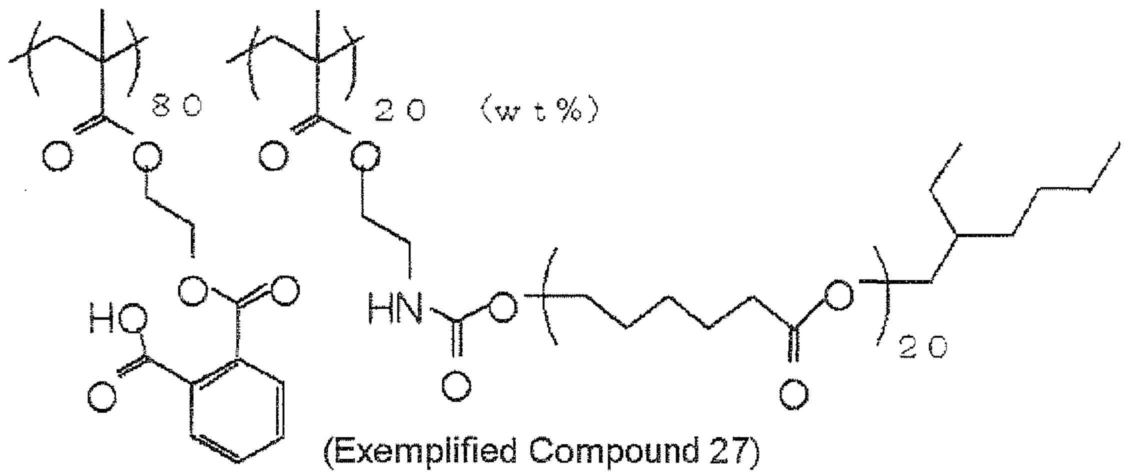

(Exemplified Compound 27)

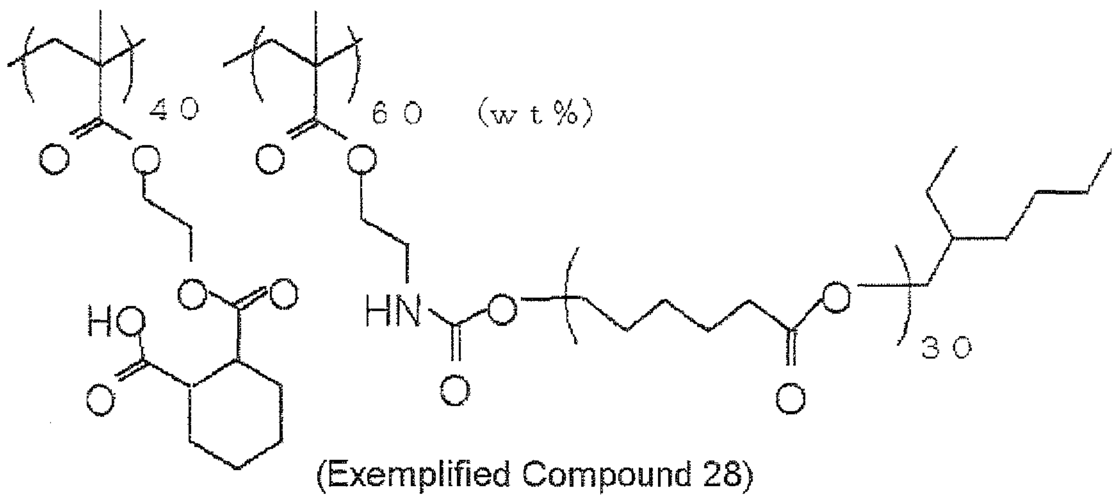

(Exemplified Compound 28)

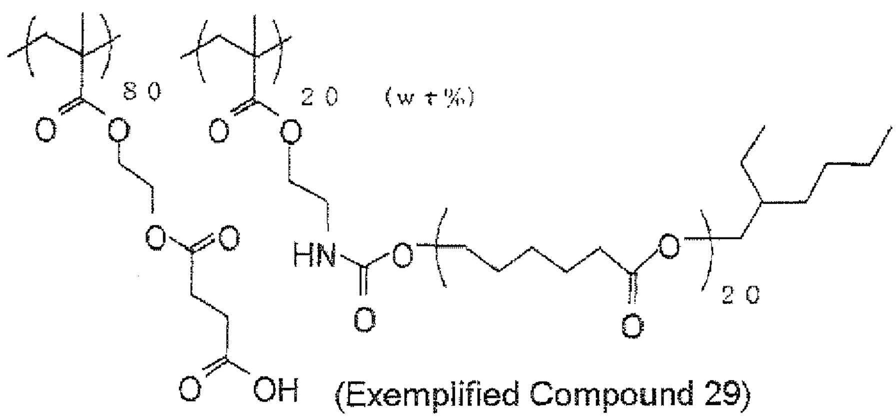

(Exemplified Compound 29)

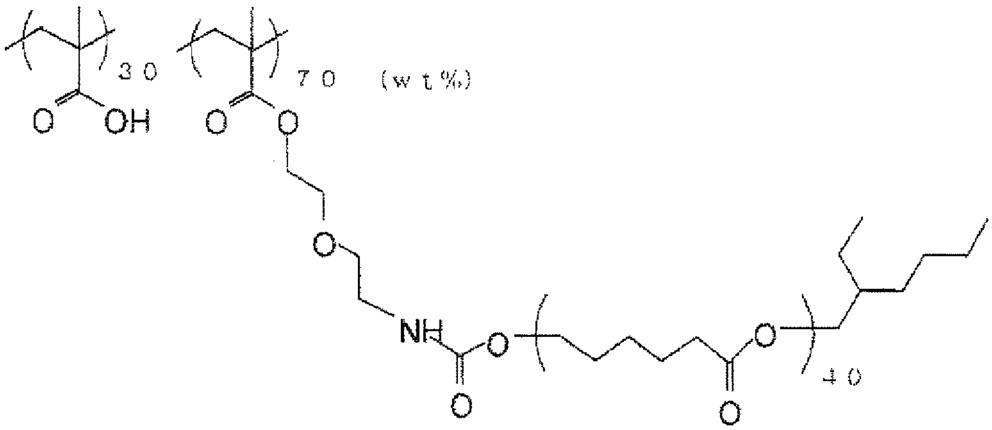

(Exemplified Compound 30)

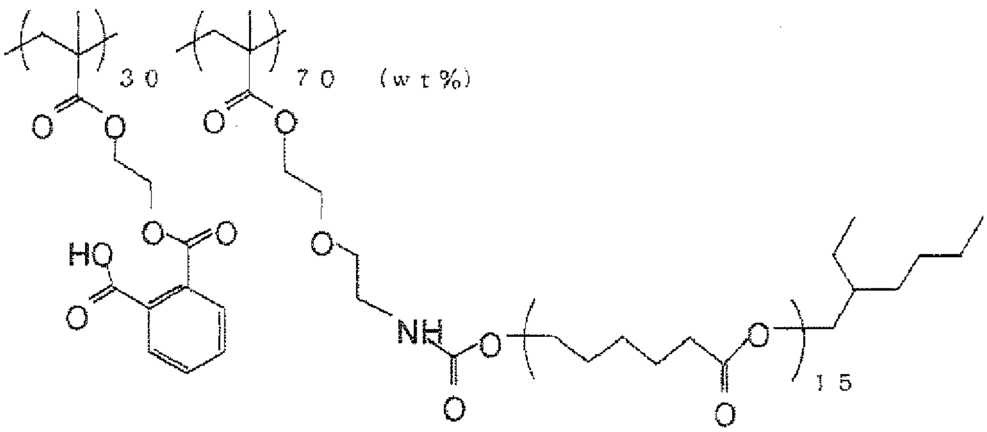

(Exemplified Compound 31)

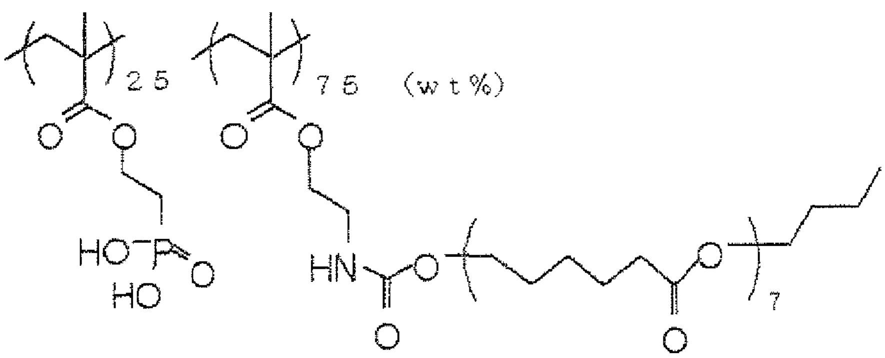

(Exemplified Compound 32)

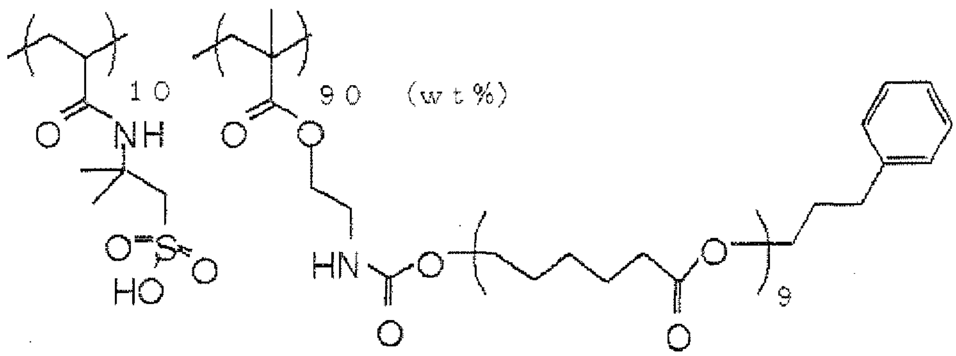

(Exemplified Compound 33)

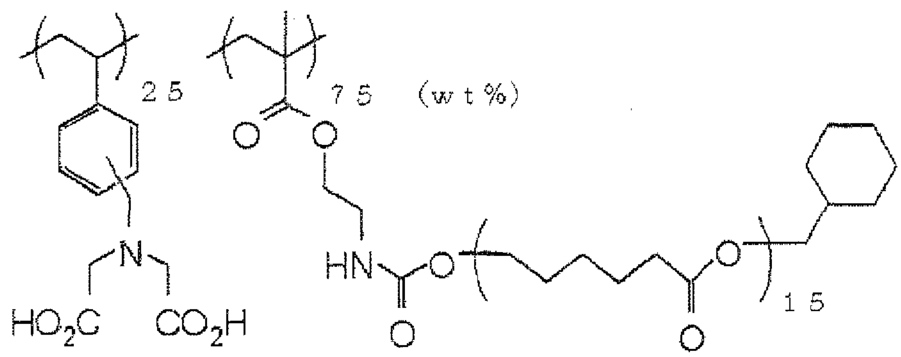

(Exemplified Compound 34)

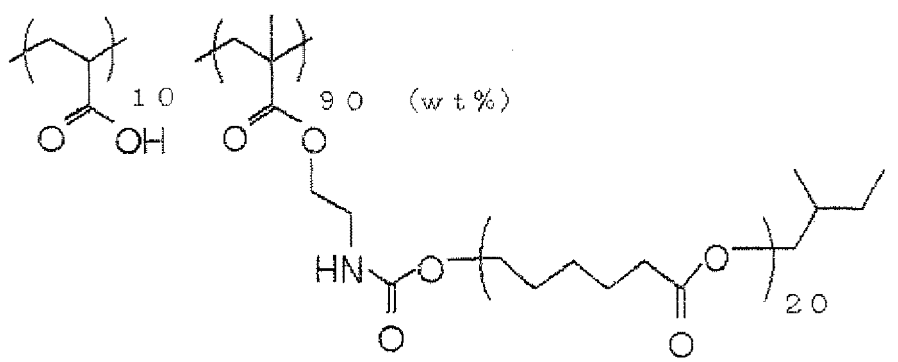

(Exemplified Compound 35)

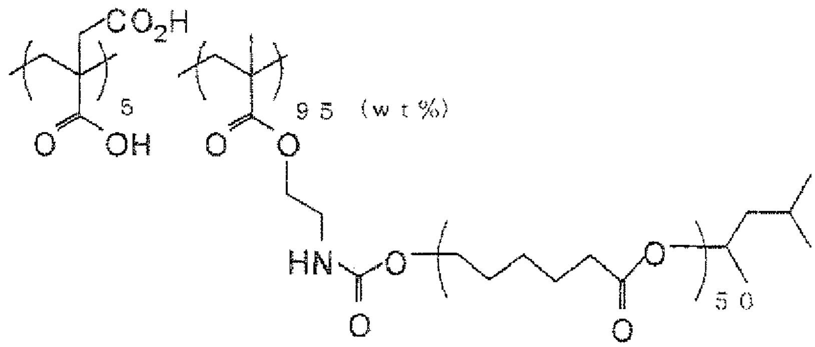

(Exemplified Compound 36)

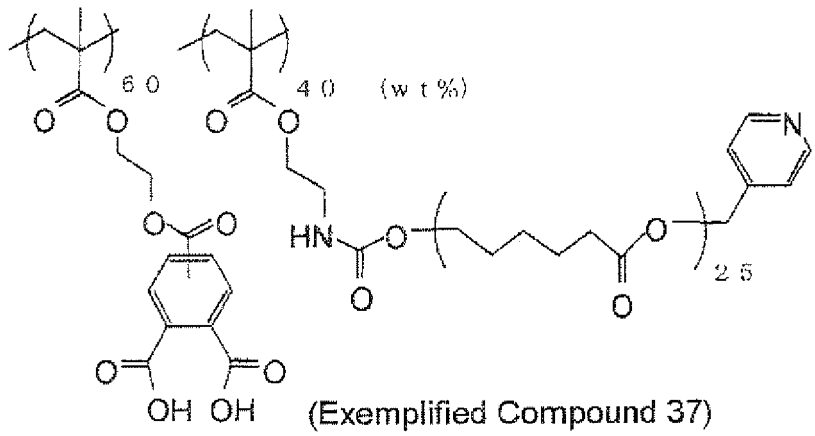

(Exemplified Compound 37)

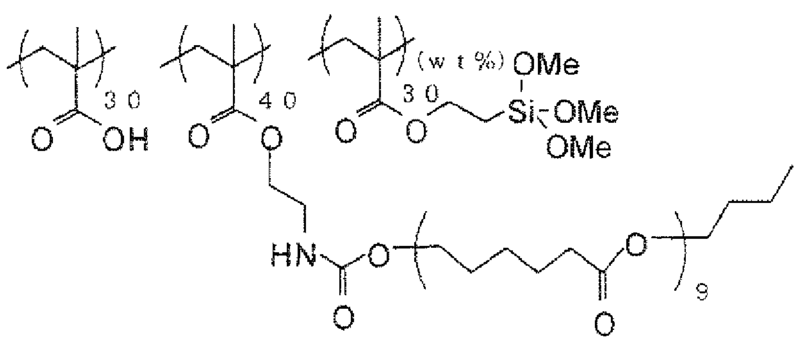

(Exemplified Compound 38)

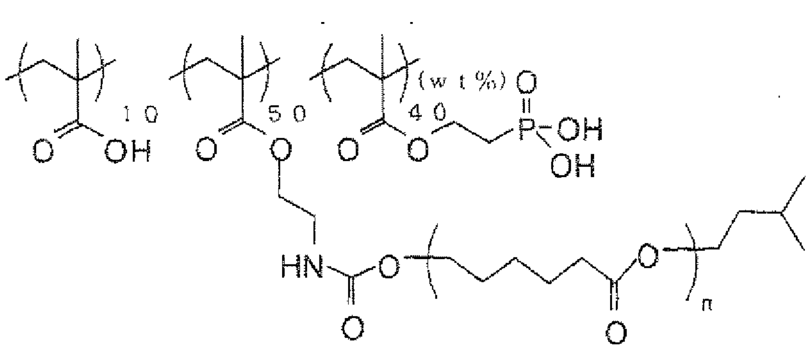

(Exemplified Compound 39) (n=5~20)

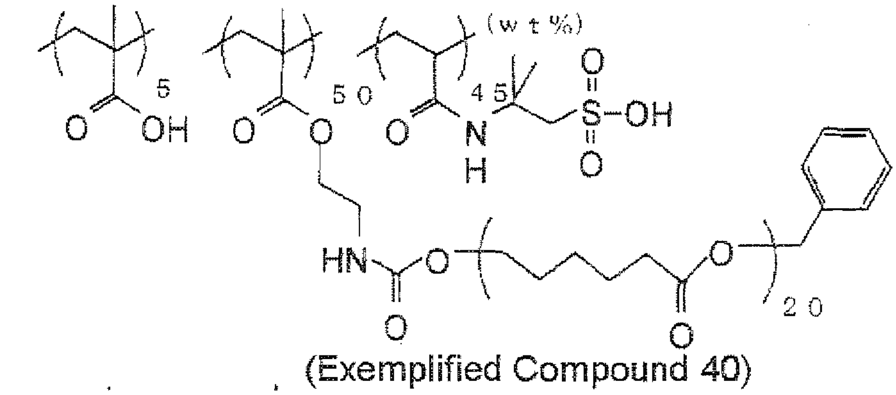

(Exemplified Compound 40)

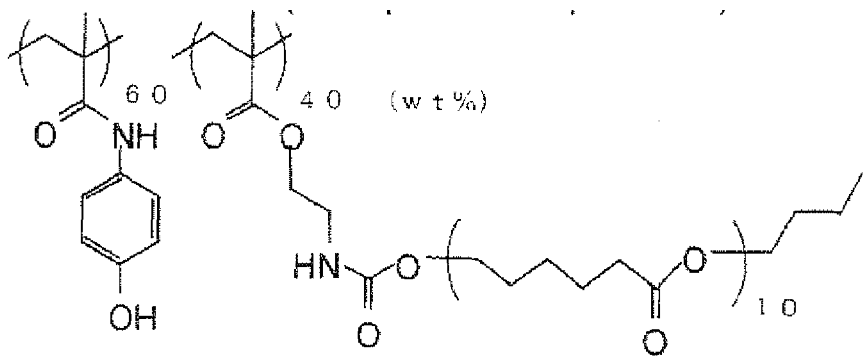

(Exemplified Compound 41)

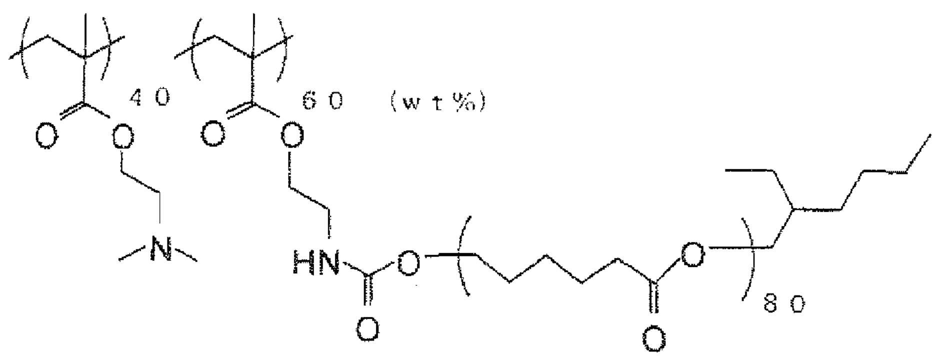

(Exemplified Compound 42)

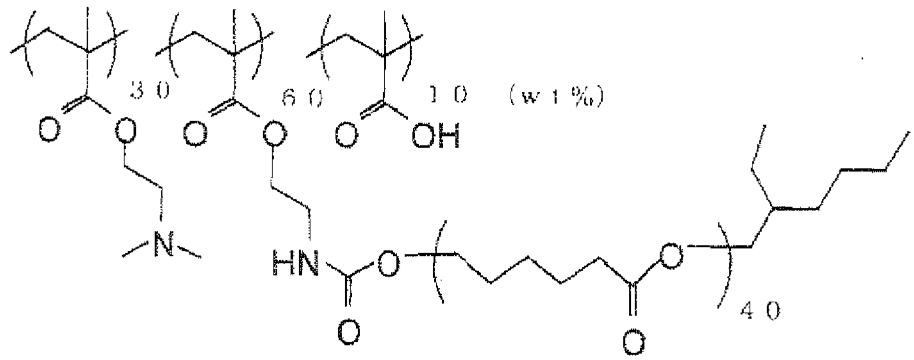

(Exemplified Compound 43)

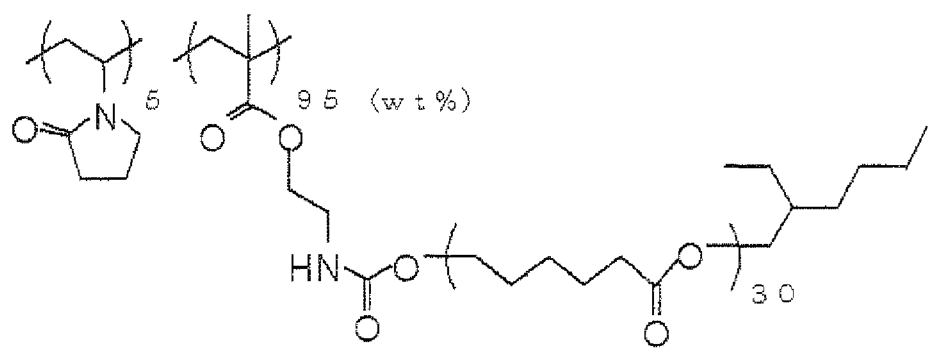

(Exemplified Compound 44)

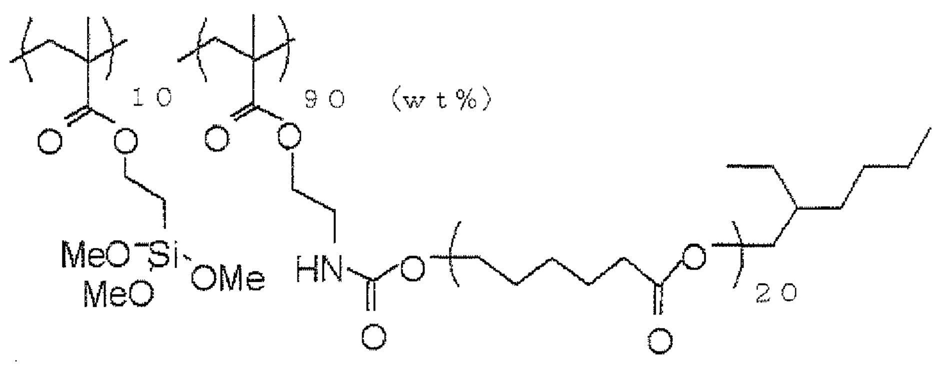

(Exemplified Compound 45)

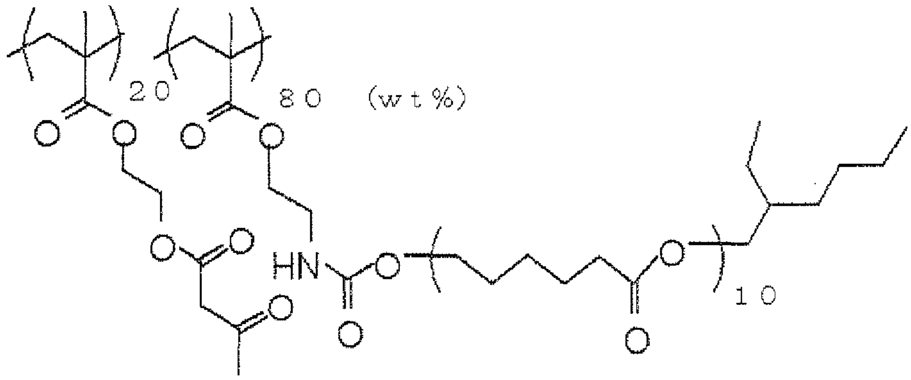

(Exemplified Compound 46)

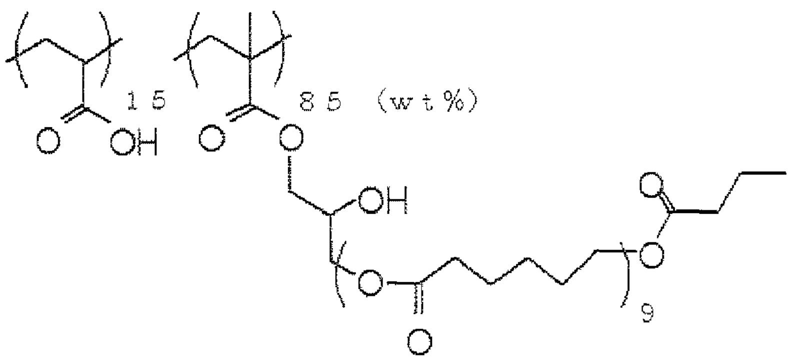

(Exemplified Compound 47)

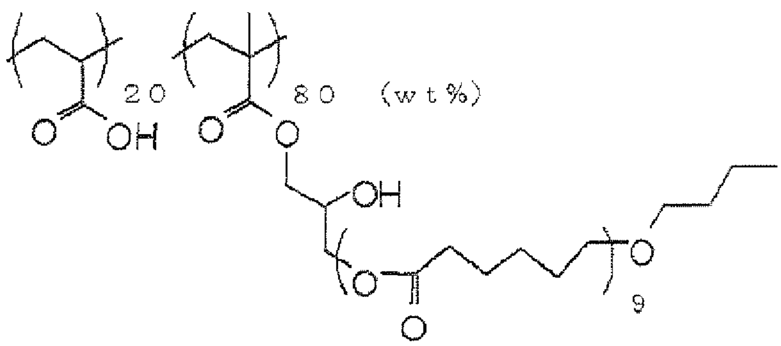

(Exemplified Compound 48)

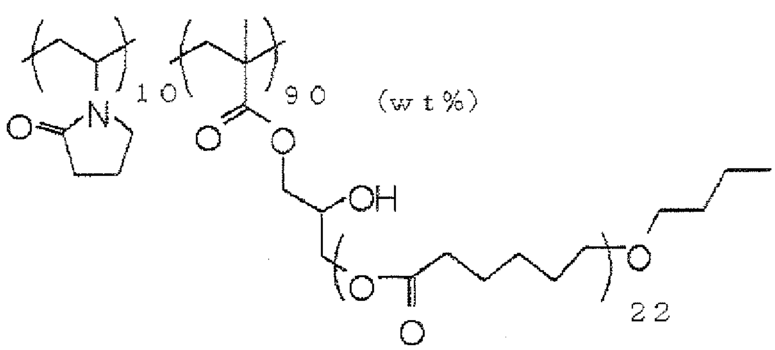

(Exemplified Compound 49)

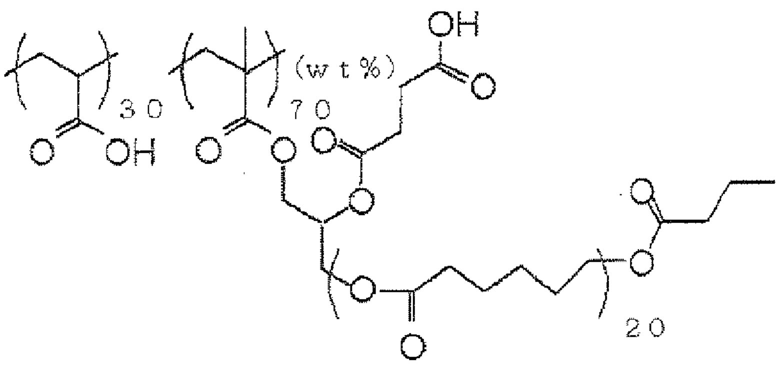

(Exemplified Compound 50)

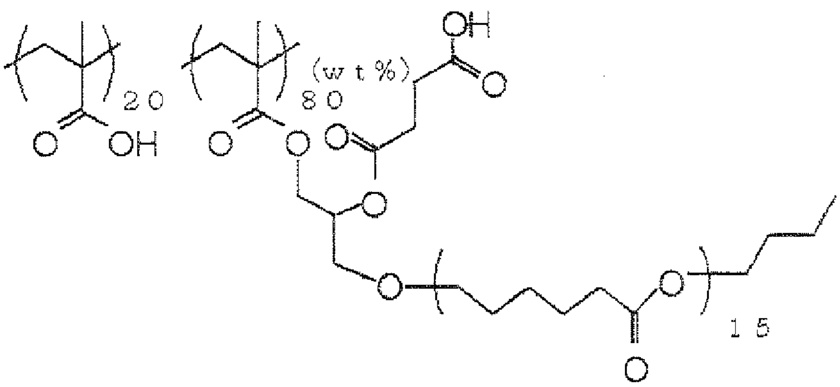

(Exemplified Compound 51)

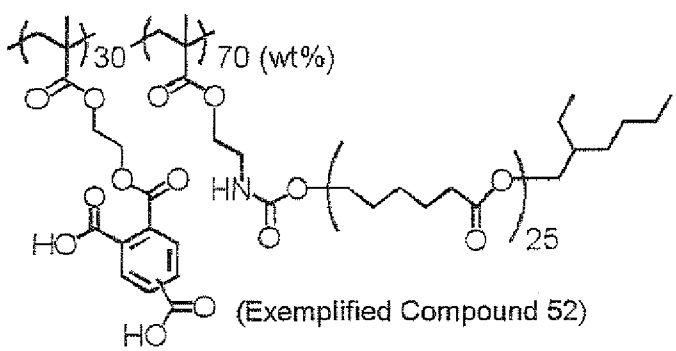

(Exemplified Compound 52)

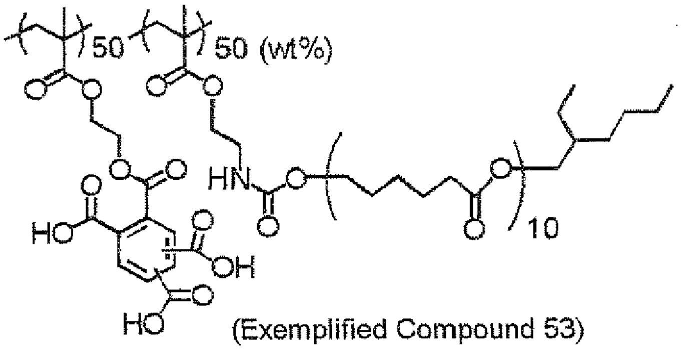

(Exemplified Compound 53)

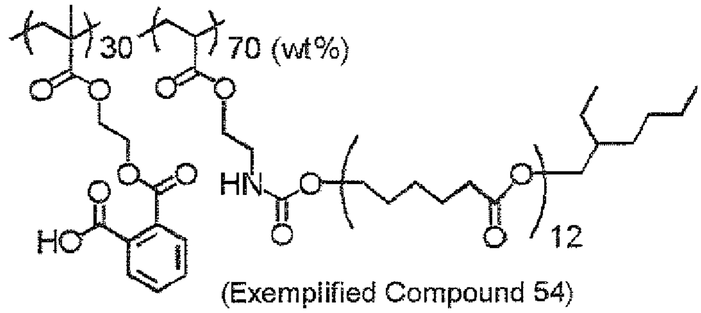

(Exemplified Compound 54)

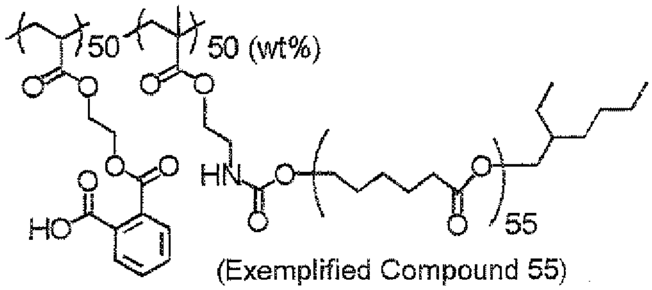

(Exemplified Compound 55)

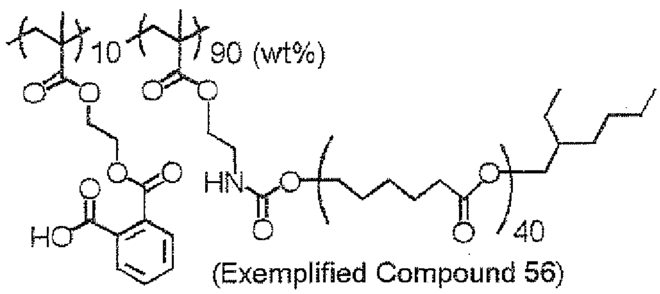

(Exemplified Compound 56)

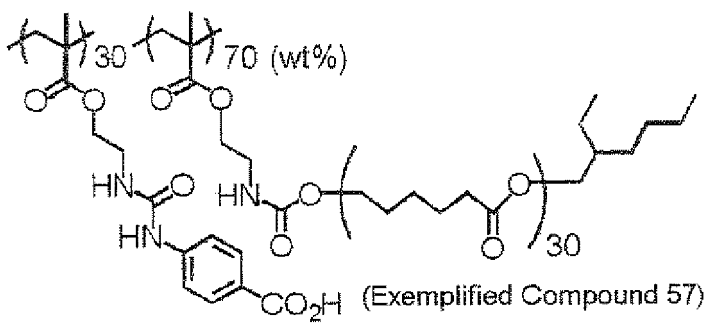

(Exemplified Compound 57)

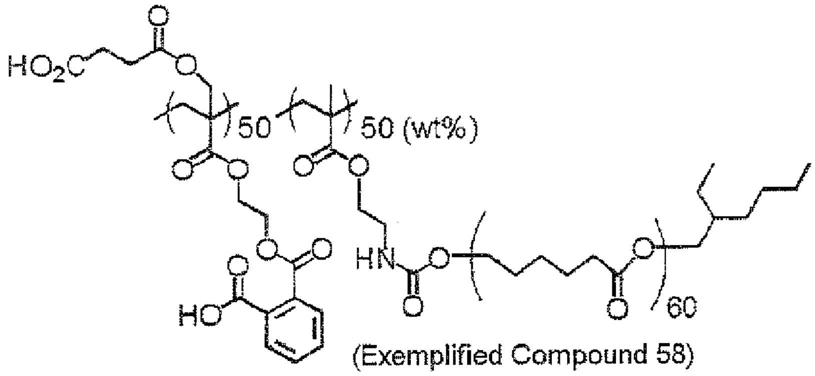

(Exemplified Compound 58)

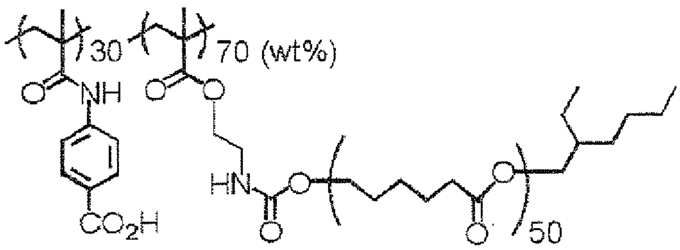

(Exemplified Compound 59)

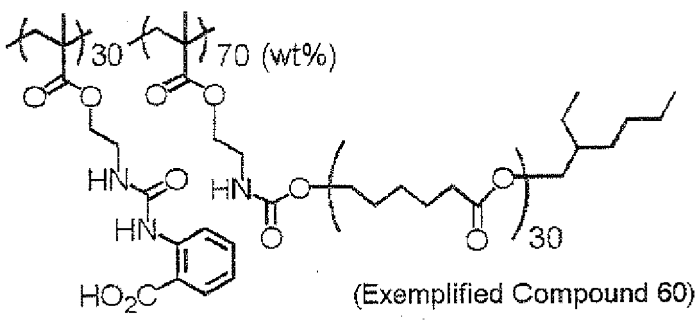

(Exemplified Compound 60)

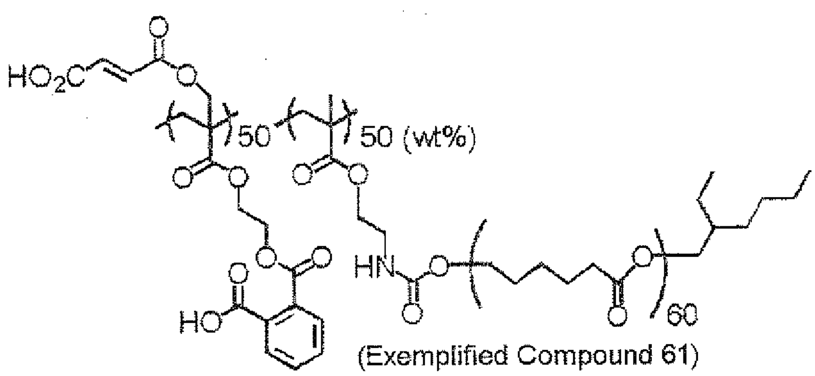

(Exemplified Compound 61)

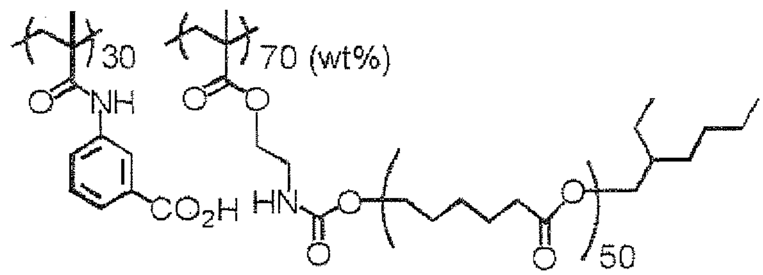

(Exemplified Compound 62)

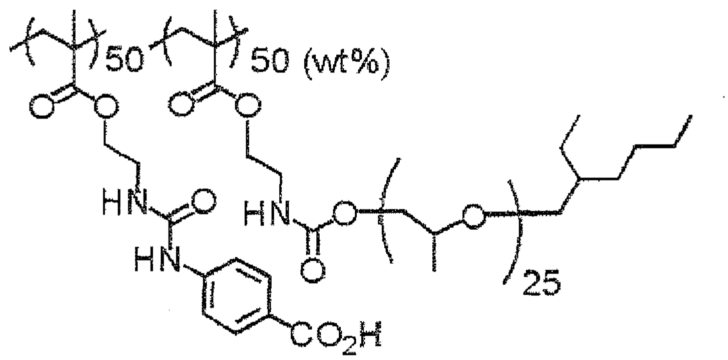

(Exemplified Compound 63)

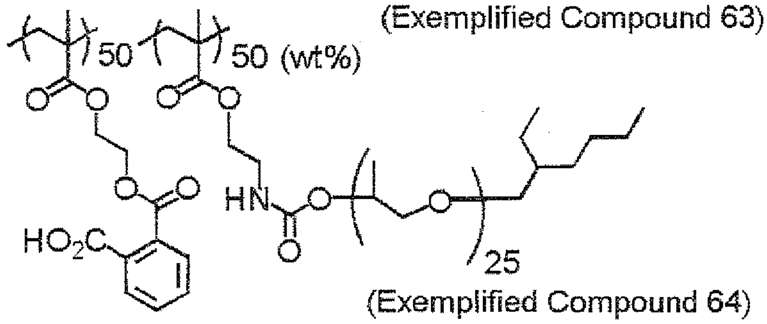

(Exemplified Compound 64)

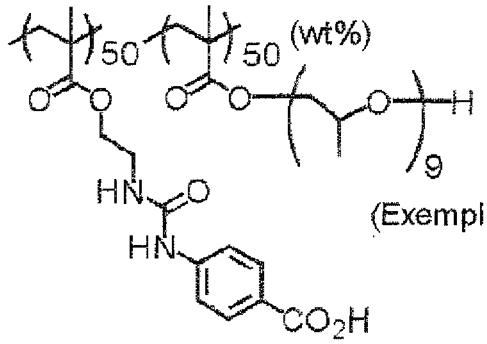

(Exemplified Compound 65)

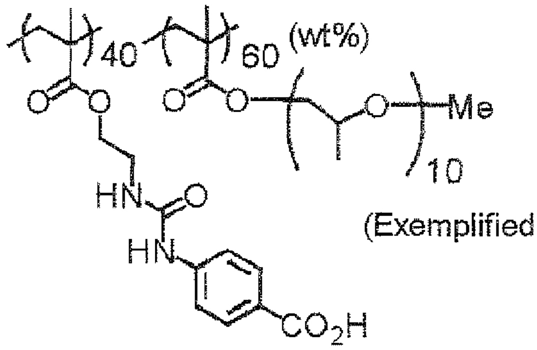

(Exemplified Compound 66)

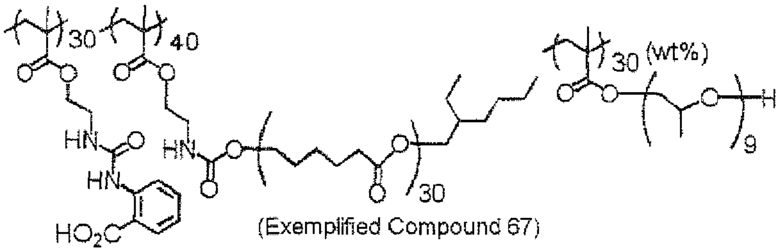

(Exemplified Compound 67)

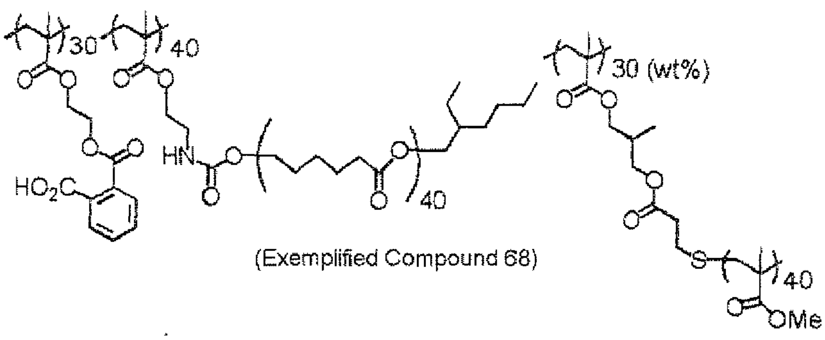

(Exemplified Compound 68)

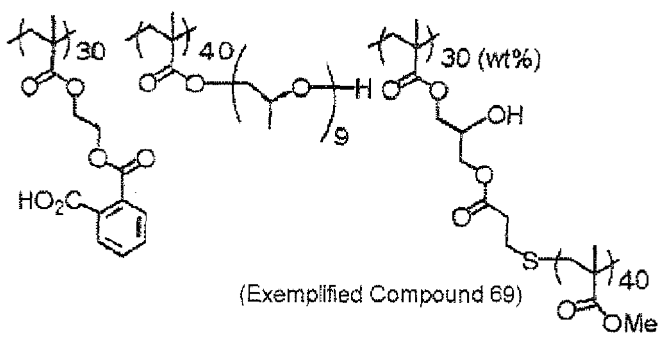

(Exemplified Compound 69)

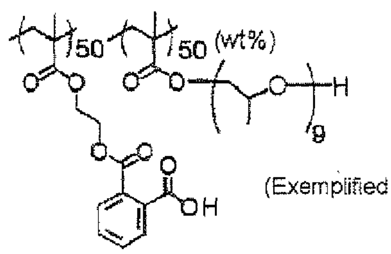

(Exemplified Compound 70)

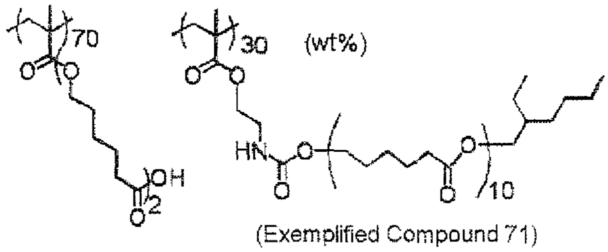

(Exemplified Compound 71)

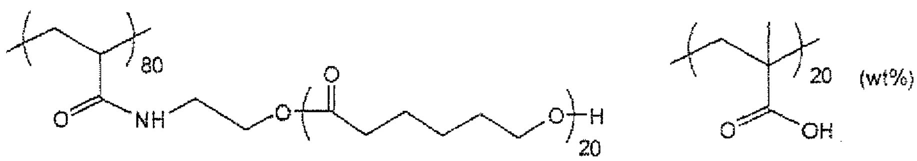

(Exemplified Compound 72)

In the case of using a dispersant, from the standpoint of enhancing the dispersibility, a dispersion composition is preferably prepared using the infrared-blocking material, a dispersant and an appropriate solvent and then blended in the curable composition.

The curable composition for a solid-state imaging device of the present invention may or may not contain a dispersant, but in the case of containing a dispersant, the content thereof in the dispersion composition is preferably from 1 to 90 mass%, more preferably from 3 to 70 mass%, based on the entire solid content by mass of the infrared-blocking material in the dispersion composition.

[6] Sensitizer

The curable composition for a solid-state imaging device of the present invention may contain a sensitizer for the purpose of enhancing the acid generation efficiency of the acid generator and shifting the photosensitive wavelength to a longer wavelength side. The sensitizer which can be used in the present invention is preferably a sensitizer capable of sensitizing the acid generator by an electron transfer mechanism or an energy transfer mechanism. The sensitizer usable in the present invention include those belonging to the compounds enumerated below and having an absorption wavelength in the wavelength region of 300 to 500 nm.

Preferred examples of the sensitizer include those belonging to the following compounds and having an absorption wavelength in the region of 330 to 500 nm.

Examples include polynuclear aromatics (e.g., phenanthrene, anthracene, pyrene, perylene, triphenylene, 9,10-dialkoxyanthracene), xanthenes (e.g., fluorescein, eosin, erythrosine, Rhodamine B, Rose Bengal), thioxanthones (isopropylthioxanthone, diethylthioxanthone, chlorothioxanthone), cyanines (e.g., thiacarbocyanine, oxacarbocyanine), merocyanines (e.g., merocyanine, carbomerocyanine), phthalocyanines, thiazines (e.g., thionine, methylene blue, toluidine blue), acridines (e.g., acridine orange, chloroflavin, acriflavin), anthraquinones (e.g., anthraquinone), squaryliums (e.g., squarylium), acridine orange, coumarins (e.g., 7-diethylamino-4-methylcoumarin), ketocoumarin, phenothiazines, phenazines, styryl benzenes, azo compounds, diphenylmethane, triphenylmethane, distyryl benzenes, carbazoles, porphyrin, spiro compounds, quinacridone, indigo, styryl, pyrylium compounds, pyromethene compounds, pyrazolotriazole compounds, benzothiazole compounds, barbituric acid derivatives, thiobarbituric acid derivatives, aromatic ketone compounds such as acetophenone, benzophenone, thioxanthone and Michler's ketone, and heterocyclic compounds such as N-aryl oxazolidinone.

Examples further include compounds described in European Patent 568,993, U.S. Patents 4,508,811 and 5,227,227, JP-A-2001-125255 and JP-A-11-271969.

The curable composition for a solid-state imaging device may or may not contain a sensitizer but in the case of containing a sensitizer, the content thereof is preferably from 0.01 to 10 mass%, more preferably from 0.1 to 4 mass%, based on the entire solid content by mass of the curable composition for a solid-state imaging device of the present invention.

[7] Curing accelerator

The curable composition for a solid-state imaging device of the present invention may further contain a curing accelerator so as to accelerate curing of the above-described crosslinking agent.

Examples of the curing accelerator which can be used include an amine compound (e.g., dicyandiamide, benzyldimethylamine, 4-(dimethylamino)-N,N-dimethylbenzylamine, 4-methoxy-N,N-dimethylbenzylamine, 4-methyl-N-,N-dimethylbenzylamine), a quaternary ammonium salt compound (e.g., triethylbenzylammonium chloride), a block isocyanate compound (e.g., dimethylamine), an imidazole derivative-bicyclic amidine compound and a salt thereof (e.g., imidazole, 2-methylimidazole, 2-ethylimidazole, 2-ethyl-4-methylimidazole, 2-phenylimidazole, 4-phenylimidazole, 1-cyanoethyl-2-phenylimidazole, 1-(2-cyanoethyl)-2-ethyl-4-methylimidazole), a phosphorus compound (e.g., triphenylphosphine), a guanamine compound (e.g., melamine, guanamine, acetoguanamine, benzoguanamine), and an S-triazine derivative (e.g., 2,4-diamino-6-methacryloyloxyethyl-S-triazine, 2-vinyl-2,4-diamino-S-triazine, 2-vinyl-4,6-diammo-S-triazine-isocyanuric acid adduct, 2,4-diamino-6-methacryloyloxyethyl-S-triazine-isocyanuric acid adduct). The curing accelerator is preferably melamine or dicyandiamine.

One of these curing accelerators may be used alone, or two or more thereof may be used in combination.

The curable composition for a solid-state imaging device may or may not contain a curing accelerator, but in the case of containing a curing accelerator, the content thereof is usually from 0.01 to 15 mass% based on the entire solid content of the curable composition.

[8] Filler

The curable composition for a solid-state imaging device of the present invention may further contain a filler. The filler which can be used in the present invention includes spherical silica surface-treated with a silane coupling agent.

The curable composition of the present preferably contains a filler, because a pattern having high durability is obtained (in particular, when higher durability is required of the solder resist, for example, when the wiring density of metal wiring covered with the solder resist is high, the above-described effect is prominent).

By using spherical silica surface-treated with a silane coupling agent, the thermal cycle test resistance and storage stability of the curable composition are enhanced, and the same good profile as that immediately after pattern formation can be maintained, for example, even through a harsh atmosphere such as thermal cycle test.

The term "spherical" in the spherical filler may be sufficient if the particle is not of a needle-like, columnar or amorphous shape but is rounded, and the shape need not be necessarily "truly spherical". However, the typical "spherical" form is "a truly spherical" shape.

Whether the filler is spherical can be confirmed by observing it though a scanning electron microscope (SEM).

The volume average primary particle diameter of the filler is not particularly limited and may be appropriately selected according to the purpose but is preferably from 0.05 to 3 μm, more preferably from 0.1 to 1 μm. When the volume average primary particle diameter of the filler is in the range above, this is advantageous in that impairment of the processability due to development of thixotropy is suppressed and the maximum particle diameter is kept from becoming large, as a result, generation of a defect attributable to attachment of an extraneous material to the cured film obtained or non-uniformity of the coating film can be reduced.

The volume average primary particle diameter of the filler can be measured by a dynamic light scattering particle diameter distribution measuring apparatus.

The filler can be dispersed using the above-described dispersant and binder. As stated earlier, in view of curability, a resin (preferably an alkali-soluble binder) having a crosslinking group in the side chain is preferred.

-Surface Treatment-

The surface treatment of the filler is described below. The surface treatment of the filler is not particularly limited and may be appropriately selected according to the purpose, but a treatment of covering silica with a silane coupling agent is preferred.

-Silane Coupling Agent-

The silane coupling agent used for the surface treatment of the filler is not particularly limited and may be appropriately selected according to the purpose but preferably contains at least one functional group selected from an alkoxysilyl group, a chlorosilyl group and an acetoxysilyl group (hereinafter, sometimes referred to as "first functional group") and at least one functional group selected from a (meth)acryloyl group, an amino group and an epoxy group (hereinafter, sometimes referred to as "second functional group). The second functional group is more preferably a (meth)acryloyl group or an amino group, and it is still more preferred that the second functional group is a (meth)acryloyl group. When the second functional group is a (meth)acryloyl group, this is advantageous in view of storage stability and TCT resistance.

A silane coupling agent containing, as a first functional group, at least one member selected from an alkoxysilyl group, a chlorosilyl group and an acetoxysilyl group and, as a second functional group, at least one member selected

from an imidazole group, an alkylimidazole group and a vinylimidazole group, described in JP-B-7-68256, can be also preferably used.

The silane coupling agent is not particularly limited, but preferred examples thereof include a γ-aminopropyltriethoxysilane, N-(β-aminoethyl)-γ-aminopropyltrimethoxysilane, N-(β-aminoethyl)-γ-aminopropylmethyldimethoxysilane, γ-glycidoxypropyltrimethoxysilane, γ-glycidoxypropylmethyldimethoxysilane, γ-methacryloxypropyltriethoxysilane, γ-methacryloxypropylmethyldimethoxysilane, α-[[3-(trimethoxysilyl)propoxy]methyl]-imidazole-1-ethanol described in JP-B-7-68256, 2-ethyl-4-methyl-α-[[3-(trimethoxysilyl)propoxy]methyl]-imidazole-1-ethanol, 4-vinyl-α-[[3-(trimethoxysilyl)propoxy]methyl]-imidazole-1-ethanol, 2-ethyl-4-methylimidazopropyltrimethoxysilane, and their salts, intramolecular condensates and intermolecular condensates. One of these compounds may be used alone, or two or more thereof may be used in combination.

The surface treatment of spherical silica with the silane coupling agent may be previously performed only for the spherical silica (in this case, hereinafter, sometimes referred to as "pretreatment") or may be performed together with a part or all of other fillers contained in the curable composition.

The method for performing the pretreatment is not particularly limited, and examples of the method include a dry method, an aqueous solution method, an organic solvent method and a spray method. The temperature at which the pretreatment is performed is not particularly limited but is preferably from ordinary temperature to 200˚C.

It is also preferred to add a catalyst when performing the pretreatment. The catalyst is not particularly limited, and examples thereof include an acid, a base, a metal compound, and an organic metal compound.

In the case of performing the pretreatment, the amount of the silane coupling agent added is not particularly limited but is preferably from 0.01 to 50 parts by mass, more preferably from 0.05 to 50 parts by mass, per 100 parts by mass of the spherical silica. When the amount added is in this range, a surface treatment enough to develop the effect is performed and at the same time, impairment of the handleability due to aggregation of spherical silica after treatment is reduced.

The above-described silane coupling agent has an action of enhancing the adherence between the base material and the photosensitive layer, because the first functional group reacts with an active group in the base material surface, spherical silica surface and binder and the second functional group reacts with a carboxyl group and an ethylenically unsaturated group of the binder. On the other hand, the silane coupling agent has high reactivity and if the silane coupling agent itself is added to the curable composition, mainly the second functional group sometimes undergoes reaction or deactivation during storage due to its diffusion action, leading to reduction in the shelf life or pot life.

However, when spherical silica pretreated with a silane coupling agent is used, the diffusion action is suppressed and the problem of shelf life or pot life is greatly improved, making it possible to take even a one-component system. Furthermore, in the case of applying the pretreatment to spherical silica, the conditions such as stirring condition, temperature condition and use of catalyst can be freely selected, so that compared to the addition without performing the pretreatment, the reaction ratio of the first functional group of the silane coupling agent with an active group in the spherical silica can be significantly increased. Accordingly, very good results are obtained in terms of required characteristics under harsh conditions such as electroless gold plating, electroless solder plating and moisture resistance load test. Also, by performing the pretreatment, the amount of the silane coupling agent used can be decreased, and the shelf life and pot life can be more improved.

Examples of the spherical silica surface-treated with a silane coupling agent, which can be used in the present invention, include FB and SFP Series of Denki Kagaku Kogyo Kabushiki Kaisha; 1-FX of Tatsumori Ltd.; HSP Series of Toagosei Co., Ltd.; and SP Series of Fuso Chemical Co., Ltd.

The curable composition for a solid-state imaging device of the present invention may or may not contain a filler, but in the case of containing a filler, the content thereof based on the entire solid content by mass of the curable composition is not particularly limited and may be appropriately selected according to the purpose, and the content is preferably from 1 to 60 mass%. When the amount added is in this range, sufficient reduction in the linear expansion coefficient is achieved and at the same time, the cured film formed can be kept from embrittlement, as a result, when wiring is formed using a permanent pattern, the function as a protective film for the wiring is adequately exerted.

[9] Elastomer

The curable composition for a solid-state imaging device of the present invention may further contain an elastomer.

By containing an elastomer, the adherence to the conductive layer of a printed wiring board when using the curable composition for a solder resist can be more improved and at the same time, heat resistance, thermal shock resistance, flexibility and toughness of the cured film can be more enhanced.

The elastomer which can be used in the present invention is not particularly limited and may be appropriately selected according to the purpose, and examples thereof include a styrene-based elastomer, an olefin-based elastomer, a urethane-based elastomer, a polyester-based elastomer, a polyamide-based elastomer, an acrylic elastomer, and a

silicone-based elastomer. Such an elastomer is composed of a hard segment component and a soft segment component, where in general, the former contributes to heat resistance and strength and the latter contributes to flexibility and toughness. Among these, a polyester-based elastomer is advantageous in view of compatibility with other materials.

Examples of the styrene-based elastomer include a styrene-butadiene-styrene block copolymer, a styrene-isoprene-styrene block copolymer, a styrene-ethylene-butylene-styrene block copolymer, and a styrene-ethylene-propylene-styrene block copolymer. As the component constituting the styrene-based elastomer, other than styrene, a styrene derivative such as α-methylstyrene, 3-methylstyrene, 4-propylstyrene and 4-cyclohexylstyrene can be used. Specific examples thereof include TUFPRENE, SOLPRENE T, ASAPRENE T, Tuftec (all produced by Asahi Kasei Corporation), Elastomer AR (produced by Aronkasei Co., Ltd.), Kraton G, Califlex (both produced by Shell in Japan), JSR-TR, TSR-SIS, Dynaron (all produced by JSR), Denka STR (produced Denki Kagaku Kogyo K.K.), Quintac (produced by ZEON Corporation), TPE-SB Series (produced by Sumitomo Chemical Co., Ltd.), Rabalon (produced by Mitsubishi Chemical Corporation), Septon, HYBRAR (both produced by Kuraray Co., Ltd.), Sumiflex (produced by Sumitomo Bakelite Co., Ltd.), Leostomer, and Actymer (both produced by Riken Vinyl Industry Co., Ltd.).

The olefin-based elastomer is a copolymer of α-olefin having a carbon number of 2 to 20, such as ethylene, propylene, 1-butene, 1-hexene and 4-methyl-pentene, and examples thereof include an ethylene-propylene copolymer (EPR) and an ethylene-propylene-diene copolymer (EPDM). Also, the olefm-based elastomer includes, for example, a copolymer of an α-olefin and a nonconjugated diene having a carbon number of 2 to 20, such as dicyclopentadiene, 1,4-hexadiene, cyclooctadiene, methylenenorbornene, ethylidenenorbornene, butadiene and isoprene, and an epoxidized polybutadiene. The olefin-based elastomer further includes, for example, carboxyl-modified NBR obtained by copolymerizing methacrylic acid with a butadiene-acrylonitrile copolymer. Other examples of the olefin-based elastomer include an ethylene-α-olefin copolymer rubber, an ethylene-α-olefin-nonconjugated diene copolymer rubber, a propylene-α-olefin copolymer rubber, and a butene-α-olefin copolymer rubber.

Specific examples of the olefin-based elastomer include Milastomer (produced by Mitsui Petrochemical Industries, Ltd.), EXACT (produced by Exxon Chemical), ENGAGE (produced by Dow Chemical), hydrogenated styrene-butadiene rubber "DYNABON HSBR" (produced by JSR), butadiene-acrylonitrile copolymer "NBR Series" (produced by JSR), butadiene-acrylonitrile copolymer modified at both ends with a carboxyl group having a crosslinking site "XER Series" (produced by JSR), and epoxidized polybutadiene obtained by partially epoxidizing polybutadiene "BF-1000" (produced by Nippon Soda Co., Ltd.).

The urethane-based elastomer consists of structural units, that is, a hard segment composed of low molecular (short chain) diol and diisocyanate, and a soft segment composed of polymer (long chain) diol and diisocyanate. Examples of the polymer (long chain) diol include polypropylene glycol, polytetramethylene oxide, poly(1,4-butylene adipate), poly (ethylene-1,4-butylene adipate), polycaprolactone, poly(1,6-hexylene carbonate), and poly(1,6-hexylene-neopentylene adipate). The number average molecular weight of the polymer (long chain) diol is preferably from 500 to 10,000. Examples of the low molecular (short chain) diol include ethylene glycol, propylene glycol, 1,4-butanediol, and bisphenol A. The number average molecular weight of the short chain diol has is preferably from 48 to 500. Specific examples of the urethane-based elastomer include PANDEX T-2185 and T-2983N (both produced by DIC Corporation), and Shirakutoran E790.

The polyester-based elastomer is obtained by polycondensing a dicarboxylic acid or a derivative thereof and a diol compound or a derivative thereof. Specific examples of the dicarboxylic acid include an aromatic dicarboxylic acid such as terephthalic acid, isophthalic acid and naphthalenedicarboxylic acid; an aromatic dicarboxylic acid where a hydrogen atom of the above-described aromatic ring is substituted with a methyl group, an ethyl group, a phenyl group or the like; an aliphatic dicarboxylic acids having a carbon number of 2 to 20, such as adipic acid, sebacic acid and dodecanedicarboxylic acid; and an alicyclic dicarboxylic acid such as cyclohexanedicarboxylic acid. One of these compounds or two or more thereof may be used. Specific examples of the diol compound include an aliphatic or alicyclic diol such as ethylene glycol, 1,3-propanediol, 1,4-butanediol, 1,6-hexanediol, 1,10-decanediol and 1,4-cyclohexanediol, bisphenol A, bis-(4-hydroxyphenyl)-methane, bis-(4-hydroxy-3-methylphenyl)-propane, and resorcin. One of these compounds or two or more thereof may be used. A multi-block copolymer using an aromatic polyester (e.g. polybutylene terephthalate) moiety for the hard segment component and an aliphatic polyester (e.g. polytetramethylene glycol) moiety for the soft segment component, can be used. The polyester-based elastomer includes various grades according to the kind, ratio and difference in the molecular weight of the hard segment and the soft segment. Specific examples of the polyester-based elastomer include Hytrel (produced by Du Pont-Toray Co., Ltd.), PELPRENE (produced by Toyobo Co., Ltd.), and ESPEL (produced by Hitachi Chemical Co., Ltd.).

The polyamide-based elastomer consists of a hard segment composed of polyamide and a soft segment composed of polyether or polyester and is roughly classified into two types, that is, a polyether block amide type and a polyether ester block type. Examples of the polyamide include polyamide-6, polyamide-11, and polyamide-12. Examples of the polyether include polyoxyethylene, polyoxypropylene, and polytetramethylene glycol. Specific examples of the polyamide-based elastomer include UBE Polyamide Elastomer (produced by Ube Industries, Ltd.), DAIAMID (produced by Daicel-Huels), PEBAX (produced by Toray Industries, Inc.), Grilon ELY (EMS Japan), Novamid (produced by Mitsubishi Chemical Corporation), and Grilax (produced by DIC Corporation).

The acrylic elastomer is obtained by copolymerizing an acrylic acid ester such as ethyl acrylate, butyl acrylate, methoxyethyl acrylate and ethoxyethyl acrylate, an epoxy group-containing monomer such as glycidyl methacrylate and alkyl glycidyl ether, and/or a vinyl-based monomer such as acrylonitrile and ethylene. Examples of the acrylic elastomer include an acrylonitrile-butyl acrylate copolymer, an acrylonitrile-butyl acrylate-ethyl acrylate copolymer, and an acrylonitrile-butyl acrylate-glycidyl methacrylate copolymer.

The silicone-based elastomer is mainly composed of an organopolysiloxane and can be classified into a polydimethylsiloxane type, a polymethylphenylsiloxane type and a polydiphenylsiloxane type. An organopolysiloxane partially modified with a vinyl group, an alkoxy group or the like may be also used. Specific examples of the silicone-based elastomer include KE Series (produced by Shin-Etsu Chemical Co., Ltd.), SE Series, CY Series and SH Series (all produced by Dow Corning Toray Silicone Co., Ltd.).

Other than the elastomers described above, a rubber-modified epoxy resin may be used. The rubber-modified epoxy resin is obtained by modifying a part or all of epoxy groups in the above-described bisphenol F-type epoxy resin, bisphenol A-type epoxy resin, salicylaldehyde-type epoxy resin, phenol novolak-type epoxy resin, cresol novolak-type epoxy resin or the like with, for example, a both-terminal carboxylic acid-modified butadiene-acrylonitrile rubber or a terminal amino-modified silicone rubber.

Among the elastomers, in view of shear adherence and thermal shock resistance, a both-terminal carboxyl group-modified butadiene-acrylonitrile copolymer, and ESPEL that is a polyester-based elastomer having a hydroxyl group (ESPEL 1612 and 1620, produced by Hitachi Chemical Co., Ltd.), and epoxidized polybutadiene are preferred.

The curable composition for a solid-state imaging device of the present invention may or may not contain an elastomer, but in the case of containing an elastomer, the content thereof based on the entire solid content by mass of the curable composition is not particularly limited and may be appropriately selected according to the purpose. The content is preferably from 0.5 to 30 mass%, more preferably from 1 to 10 mass%, still more preferably from 3 to 8 mass%, based on the solid content. When the content is in this preferred range, the shear adherence and thermal shock resistance can be advantageously more enhanced.

[10] Surfactant

From the standpoint of more enhancing the coatability, in the curable composition for a solid-state imaging device of the present invention, various surfactants may be added. As the surfactant, a variety of surfactants such as fluorine-containing surfactant, nonionic surfactant, cationic surfactant, anionic surfactant and silicone-containing surfactant may be used.

In particular, when the curable composition for a solid-state imaging device of the present invention contains a fluorine-containing surfactant, the liquid characteristics (particularly, fluidity) of a coating solution prepared can be more enhanced and therefore, uniformity of the coating thickness and liquid saving performance can be more improved.

That is, in the case of forming a film by using a coating solution to which a curable composition for a solid-state imaging device containing a fluorine-containing surfactant is applied, the interfacial tension between the surface to be coated and the coating solution is lowered, whereby wettability of the surface to be coated is improved and coatability on the surface to be coated is enhanced. This is effective in that even when a thin film on the order of several $\mu$m is formed with a small amount of solution, a film being reduced in the thickness unevenness and having a uniform thickness can be more successfully performed.

The fluorine content of the fluorine-containing surfactant is preferably from 3 to 40 mass%, more preferably from 5 to 30 mass%, still more preferably from 7 to 25 mass%. The fluorine-containing surfactant having a fluorine content in this range is effective in view of thickness uniformity of the coated film or liquid saving performance and also exhibits good solubility in the curable composition for a solid-state imaging device.

Examples of the fluorine-containing surfactant include Megaface F171, Megaface F172, Megaface F173, Megaface F176, Megaface F177, Megaface F141, Megaface F142, Megaface F143, Megaface F144, Megaface R30, Megaface F437, Megaface F475, Megaface F479, Megaface F482, Megaface F554, Megaface F780, Megaface F781 (all produced by DIC Corporation), Fluorad FC430, Fluorad FC431, Fluorad FC171 (all produced by Sumitomo 3M Ltd.), Surflon S-382, Surflon SC-101, Surflon SC-103, Surflon SC-104, Surflon SC-105, Surflon SC-1068, Surflon SC-381, Surflon SC-383, Surflon S-393, and Surflon KH-40 (all produced by Asahi Glass Co., Ltd.).

Specific examples of the nonionic surfactant include polyoxyethylene lauryl ether, polyoxyethylene stearyl ether, polyoxyethylene oleyl ether, polyoxyethylene octylphenyl ether, polyoxyethylene nonylphenyl ether, polyethylene glycol dilaurate, polyethylene glycol distearate, and a sorbitan fatty acid ester (Pluronic L10, L31, L61, L62, 10R5, 17R2 and 25R2, and Tetronic 304, 701, 704, 901, 904 and 150R1, produced by BASF), and Solsperse 20000 (produced by The Lubrizol Corporation)).

Specific examples of the cationic surfactant include a phthalocyanine derivative (EFKA-745, trade name, produced by Morishita Sangyo K.K.), organosiloxane polymer KP341 (produced by Shin-Etsu Chemical Co., Ltd.), (meth)acrylic acid (co)polymers POLYFLOW No. 75, No. 90 and No. 95 (produced by Kyoeisha Chemical Co., Ltd.), and W001 (produced by Yusho Co., Ltd.).

Specific examples of the anionic surfactant include W004, W005 and W017 (produced by Yusho Co Ltd.).

Examples of the silicone-containing surfactant include "TORAY SILICONE DC3PA", "TORAY SILICONE SH7PA", "TORAY SILICONE DC11PA", "TORAY SILICONE SH21PA", "TORAY SILICONE SH28PA", "TORAY SILICONE SH29PA", "TORAY SILICONE SH30PA" and "TORAY SILICONE SH8400" produced Dow Coming Toray Silicone Co., Ltd.; "TSF-4440", "TSF-4300", "TSF-4445", "TSF-4460" and "TSF-4452" produced by Momentive Performance Materials Inc.; "KP341", "KF6001" and "KF6002" produced by Shin-Etsu Silicone; and "BYK-323" and "BYK-330" produced by BYK Chemie.

As the surfactant, one kind of a surfactant may be used, or two or more kinds of surfactants may be used in combination.

The curable composition for a solid-state imaging device may or may not contain a surfactant, but in the case of containing a surfactant, the content thereof is preferably from 0.001 to 1 mass%, more preferably from 0.01 to 0.1 mass%, based on the entire solid content by mass of the curable composition of the present invention.

[11] Other components

In the curable composition for a solid-state imaging device of the present invention, in addition to the above-described essential components and preferred additives, other components may be appropriately selected and used according to the purpose as long as the effects of the present invention are not impaired.

Examples of other components which can be used in combination include a heat curing accelerator, a thermal polymerization inhibitor, a plasticizer, and a colorant (colored pigment or dye). Furthermore, an adherence promoter to the base material and other auxiliary agents (for example, an electrically conductive particle, a filler, a defoaming agent, a flame retardant, a leveling agent, a release promoter, an antioxidant, a perfume, a surface tension adjusting agent and a chain transfer agent) may be also used in combination.

By appropriately incorporating these components, the properties of the solder resist, such as stability, photographic property and film property, can be adjusted in a targeted manner.

The thermal polymerization inhibitor is described in detail, for example, in paragraphs [0101] and [0102] of JP-A-2008-250074.

The plasticizer is described in detail, for example, in paragraphs [0103] and [0104] of JP-A-2008-250074.

The colorant is described in detail, for example, in paragraphs [0105] and [0106] of JP-A-2008-250074 and paragraphs [0038] and [0039] of JP-A-2009-205029.

The adherence promoter is described in detail, for example, in paragraphs [0107] to [0109] of JP-A-2008-250074.

All of the additives described in these patent publications are usable for the curable composition for a solid-state imaging device of the present invention.

The solid content concentration of the thus-obtained curable composition for a solid-state imaging device of the present invention is preferably from 5 to 90 mass%, more preferably from 20 to 80 mass%, and most preferably from 40 to 60 mass%.

The use application of the curable composition for a solid-state imaging device of the present invention is not particularly limited, but examples thereof include a solder resist, a light-blocking film for back surface of a silicon substrate in a solid-state imaging device, and a light-blocking film for wafer-level lens, with a solder resist being preferred.

In the case where the curable composition for a solid-state imaging device of the present invention is used for a solder resist, in order to form a coating film having a relatively large thickness, the solid content concentration is preferably from 30 to 80 mass%, more preferably from 35 to 70 mass%, and most preferably from 40 to 60 mass%.

The viscosity of the curable composition for a solid-state imaging device of the present invention is preferably from 1 to 3,000 mPa•s, more preferably from 10 to 1,500 mPa•s, and most preferably from 200 to 1,000 mPa•s.

As for the method to obtain the desired viscosity, for example, a liquid dispersion prepared by dispersing at least either one of a filler and an elastomer is previously adjusted to a viscosity of 100 to 60,000 mPa•s, and other components are added thereto, whereby a curable composition for a solid-state imaging device having a desired viscosity can be obtained.

The present invention also relates to a photosensitive layer formed of the curable composition for a solid-state imaging device of the present invention. Since the photosensitive layer is formed of the curable composition for a solid-state imaging device of the present invention, this is a photosensitive layer capable of forming a pattern having high light-blocking effect in the infrared region and excellent durability (for example, heat/cold shock resistance and adherence to substrate) as well as having a desired rectangular profile, by alkali development.

The present invention also relates to a permanent pattern formed using the curable composition for a solid-state imaging device of the present invention. The permanent pattern of the present invention is obtained by applying

exposure and alkali development to the photosensitive layer formed of the curable composition for a solid-state imaging device of the present invention and thanks to use of the curable composition for a solid-state imaging device of the present invention, the pattern formed by alkali development is a pattern having high light-blocking effect in the infrared region and excellent durability (for example, heat/cold shock resistance and adherence to substrate) as well as having a desired rectangular profile.

Furthermore, the present invention also relates to a pattern forming method comprising, in order, a step of forming a photosensitive layer by using the curable composition for a solid-state imaging device of the present invention, a step of patternwise exposing the photosensitive layer to cure the exposed area, and a step of removing the unexposed area by alkali development to form a permanent pattern.

The method for forming a permanent pattern by using the curable composition for a solid-state imaging device of the present invention is described in detail below by referring, for example, to a patterned solder resist. However, the following descriptions regarding the kind and amount used of the solvent for preparation of a coating solution, the method for applying the coating solution, the thickness of the photosensitive layer, and the exposure step or other steps are not limited to the application to a solder resist. Here, a case of forming a photosensitive layer (curable composition layer) by using the curable composition for a solid-state imaging device is described, for example.

-Photosensitive Layer-

In order to form a patterned solder resist (solder resist pattern), a photosensitive layer is first formed using the curable composition for a solid-state imaging device of the present invention. The photosensitive layer is not particularly limited as long as it is a layer formed by containing the curable composition, and the film thickness, laminate structure and the like can be appropriately selected according to the purpose.

The method forming the photosensitive layer includes a method comprising dissolving, emulsifying or dispersing the curable composition of the present invention in water or a solvent to prepare a coating solution, applying the coating solution directly on a support, and drying the coating to form the photosensitive layer.

The solvent for preparation of the coating solution is not particularly limited and may be appropriately selected according to the purpose from those capable of uniformly dissolving or dispersing respective components of the curable composition of the present invention. Examples thereof include alcohols such as methanol, ethanol, normal propanol, isopropanol, normal butanol, secondary butanol and normal hexanol; ketones such as acetone, methyl ethyl ketone, methyl isobutyl ketone, cyclohexanone and diisobutyl ketone; esters such as ethyl acetate, butyl acetate, normal amyl acetate, methyl sulfate, ethyl propionate, dimethyl phthalate, ethyl benzoate, propylene glycol monomethyl ether acetate and methoxy propyl acetate; aromatic hydrocarbons such as toluene, xylene, benzene and ethylbenzene; halogenated hydrocarbons such as carbon tetrachloride, trichloroethylene, chloroform, 1,1,1-trichloroethane, methylene chloride and monochlorobenzene; ethers such as tetrahydrofuran, diethyl ether, ethylene glycol monomethyl ether, ethylene glycol monoethyl ether, 1-methoxy-2-propanol and propylene glycol monomethyl ether; dimethylformamide, dimethylacetamide, dimethylsulfoxide and sulfolane. One of these solvents may be used alone, or two or more thereof may be used in combination. Also, a known surfactant may be added.

The method for applying the coating solution on a support is not particularly limited and may be appropriately selected according to the purpose, and examples thereof include a coating method using a spin coater, a slit spin coater, a roll coater, a die coater or a curtain coater.

The conditions when drying the coating vary depending on respective components, the kind of solvent, the ratio used and the like but are usually a temperature of 60 to 150°C and from 30 seconds to 15 minutes.

The thickness of the photosensitive layer is not particularly limited and may be appropriately selected according to the purpose but, for example, is preferably from 1 to 100 μm, more preferably from 2 to 50 μm, still more preferably from 4 to 30 μm.

(Solder Resist Pattern Forming Method)

The method for forming a solder resist permanent pattern by using the curable composition for solder resist of a solid-state imaging device of the present invention comprises at least a exposure step and usually, further comprises a development step under conditions appropriately selected as needed and other steps. The term "exposure" as used in the present invention includes not only exposure to light at various wavelengths but also irradiation with radiation such as electron beam and i-ray.

<Exposure Step>

The exposure step is a step of exposing the photosensitive layer formed of the curable composition for a solid-state imaging device layer, through a mask and in this step, only the region irradiated with light is cured.

The exposure is preferably performed by the irradiation with radiation, and the radiation which can be used for exposure is preferably an electron beam, KrF, ArF, ultraviolet ray such as g-line, h-line and i-line, or visible light. Among these, KrF, g-line, h-line and i-line are preferred.

The exposure system includes, for example, stepper exposure and exposure using a high-pressure mercury lamp.

The exposure dose is preferably from 5 to 3,000 mJ/cm$^2$ more preferably from 10 to 2,000 mJ/cm$^2$, and most preferably from 50 to 1,000 mJ/cm$^2$.

<Heating Step>

In order to enhance the resolution and adherence, a heating step can be performed between the exposure step and the development step. The temperature in the heating step is preferably from 70 to 160˚C, more preferably from 80 to 130˚C. If the heating temperature is less than 70˚C, the curing reaction does not proceed sufficiently and the resolution and adherence cannot be enhanced, whereas if the heating temperature exceeds 160˚C, developability of the non-image is insufficient and a scum is disadvantageously liable to be generated.

The heating time is preferably from 10 seconds to 15 minutes, more preferably from 30 seconds to 7 minutes.

<Other Steps>

Other steps are not particularly limited and may be appropriately selected according to the purpose. Examples thereof include a step of surface-treating a base material, a development step, a curing treatment step and a post-exposure step.

<Development Step>

Following the exposure step, alkali development (development step) is performed, whereby the portion not irradiated with light in the exposure step is dissolved out into an aqueous alkali solution. As a result, only the photocured portion remains, and a patterned solder resist having light-blocking effect is formed.

The developer is preferably an organic alkali developer that does not damage the underlying circuit. The development temperature is usually from 20 to 40˚C, and the development time is from 10 to 300 seconds.

As for the alkali used in the developer, for example, an aqueous alkaline solution obtained by diluting an organic alkaline compound such as aqueous ammonia, ethylamine, diethylamine, dimethylethanolamine, tetramethylammonium hydroxide, tetraethylammonium hydroxide, choline, pyrrole, piperidine and 1,8-diazabicyclo-[5,4,0]-7-undecene with pure water to a concentration of from 0.001 to 10 mass%, preferably from 0.01 to 1 mass%, is used. In the case of using a developer composed of such an aqueous alkaline solution, the film after development is generally washed (rinsed) with pure water.

Each of the development step and the rinsing step can be performed a plurality of times.

<Curing Treatment Step>

The curing treatment step is a step of, after the development step is performed, if desired, applying a curing treatment to the photosensitive layer in the formed pattern, and by performing this treatment, the mechanical strength of the permanent pattern is enhanced.

The curing treatment step is not particularly limited and may be appropriately selected according to the purpose, but examples thereof include an entire surface exposure treatment and an entire surface heating treatment.

The method for the entire surface exposure treatment includes, for example, a method of, after the development step, exposing the entire surface of the laminate having the patterned photosensitive layer formed. By the entire surface exposure, curing of the polymerization components in the curable composition forming the photosensitive layer is promoted, and cuing of the permanent pattern further proceeds, whereby the mechanical strength and durability are improved.

The apparatus used for performing the entire surface exposure is not particularly limited and may be appropriately selected according to the purpose. Preferred examples thereof include an UV exposure machine such as ultrahigh-pressure mercury lamp.

The method for the entire surface heating treatment includes a method of, after the development step, heating the entire surface of the laminate having the patterned photosensitive layer formed. By the entire surface heating, the film strength of the pattern is increased.

The heating temperature in the entire surface heating is preferably from 120 to 250˚C, more preferably from 120 to 200˚C. When the heating temperature is 120˚C or more, the film strength is increased by the heating treatment,

and when it is 250˚C or less, the film quality can be prevented from becoming weak and brittle due to decomposition of the resin in the curable composition.

The heating time in the entire surface heating is preferably from 3 to 180 minutes, more preferably from 5 to 120 minutes.

The apparatus used for performing the entire surface heating is not particularly limited and may be appropriately selected according to the purpose from conventional apparatuses. Examples thereof include a dry oven, a hot plate and an IR heater.

The thus-formed patterned resist has an excellent infrared-blocking effect and therefore, has a wide range of application. The curable composition of the present invention has an excellent light-blocking effect in the infrared region and light transparency in the ultraviolet to visible region, so that a pattern having an excellent profile can be formed. At the same time, the pattern (cured film) formed has an excellent infrared-blocking effect and in turn, is useful in forming a solder resist for a device with a photodiode having sensitivity even to the infrared region, particularly, a solid-state imaging device.

As described above, the curable composition of the present invention is useful for the formation of not only a solder resist but also a light-blocking film for back surface of a silicon substrate in a solid-state imaging device, or a light-blocking film for wafer-level lens.

In this way, the present invention also relates to a solid-state imaging device having a permanent pattern formed of the curable composition of the present invention.

The solid-state imaging device according to an embodiment of the present invention is described below by referring to Figs. 1 and 2, but the present invention is not limited the following specific example.

Incidentally, common numerical references are used for the portions common between Fig. 1 and Fig. 2.

Also, in the description, the "top", "above" and "upper side" indicate the side father from the silicon substrate 10, and the "bottom", "below" and "lower side" indicate the side closer to the silicone substrate 10.

Fig. 1 is a schematic cross-sectional view showing a configuration of a camera module having a solid-state imaging device according to a specific example of the one embodiment above.

In Fig. 1, the camera module 200 is connected to a circuit substrate 70 as a package substrate through a solder ball 60 as a connection member.

In detail, the camera module 200 is configured to include a solid-state imaging device substrate 100 having an imaging element part on the first major surface of a silicon substrate, a glass substrate 30 (light transmitting substrate) disposed above the first major surface of the solid-state imaging device substrate 100, an infrared cut filter 42 disposed above the glass substrate 30, a lens holder 50 being disposed above the glass substrate 30 and the infrared cut filter 42 and having an imaging lens 40 in the internal space, and a light-blocking and electromagnetic shield 44 disposed to surround the peripheries of the solid-state imaging device substrate 100 and the glass substrate 30. Each member is bonded through an adhesive 20, 41, 43 or 45.

In the camera module 200, incident light hv from the outside sequentially passes through the imaging lens 40, the infrared cut filter 42 and the glass substrate 30 and reaches the imaging device part of the solid-state imaging device substrate 100.

Also, the camera module 200 is connected to a circuit substrate 70 through a solder ball 60 (connection material) on the second major surface side of the solid-state imaging device substrate 100.

Fig. 2 is a cross-sectional view on an enlarged scale showing the solid-state imaging device substrate 100 in Fig. 1.

The solid-state imaging device substrate 100 is configured to include a silicon substrate 10 as a base body, an imaging element 12, an interlayer insulating film 13, a base layer 14, a red color filter 15R, a green color filter 15G, a blue color filter 15B, an overcoat 16, a microlens 17, a light-blocking film 18, an insulating film 22, a metal electrode 23, a solder resist layer 24, an internal electrode 26, and a device surface electrode 27.

The solder resist layer 24 may be omitted.

First, the configuration on the first major surface side of a solid-state imaging device substrate 100 is mainly described.

As shown in Fig. 2, an imaging element part where a plurality of imaging elements 12 such as CCD and CMOS are two-dimensionally arranged is provided on the first major surface side of a silicon substrate 10 that is the base body of the solid-state imaging device substrate 100.

An interlayer insulating film 13 is formed on the imaging element 12 in the imaging element part, and a base layer 14 is formed on the interlayer insulating film 13. Furthermore, a red color filter 15R, a green color filter 15G and a blue color filter 15B (hereinafter sometimes collectively referred to as "color filter 15") are disposed on the base layer 14 to correspond to respective imaging elements 12.

A light-blocking film not shown may be provided in the boundaries of the red color filter 15R, the green color filter 15G and the blue color filter 15B and in the peripheries of the imaging element part. This light-blocking film can be produced, for example, by using a known black color resist.

An overcoat 16 is formed on the color filter 15, and a microlens 17 is formed on the overcoat 16 to correspond to the imaging element 12 (color filter 15).

A peripheral circuit (not shown) and an internal electrode 26 are provided in the periphery of the imaging element part on the first major surface side, and the internal electrode 26 is electrically connected to the imaging element 12 through the peripheral circuit.

Furthermore, a device surface electrode 27 is formed on the internal electrode 26 through the interlayer insulating film 13, and in the interlayer insulating film 13 between the internal electrode 26 and the device surface electrode 27, a contact plug (not shown) for electrically connecting these electrodes is formed. The device surface electrode 27 is used, for example, for applying a voltage or reading a signal through the contact plug and the internal electrode 26.

A base layer 14 is formed on the device surface electrode 27, and an overcoat 16 is formed on the base layer 14. The base layer 14 and the overcoat 16 formed on the deice surface electrode 27 are opened to form a pad opening part, and a part of the device surface electrode 27 is thereby exposed.

This is the configuration on the first major surface side of the solid-state imaging device substrate 100.

On the first major surface side of the solid-state imaging device substrate 100, an adhesive 20 is provided in the periphery of the imaging element part, and the solid-state imaging device substrate 100 and the glass substrate 30 are bonded through the adhesive 20.

Also, the silicon substrate 10 has a through hole penetrating the silicon substrate 10, and a through-electrode as a part of a metal electrode 23 is provided inside the through hole. The imaging element part and a circuit substrate 70 are electrically connected by the through-electrode.

The configuration on the second major surface side of the solid-state imaging device substrate 100 is mainly described below.

On the second major surface side, an insulating film 22 is formed over an area from the second major surface to the inner wall of the through hole.

A metal electrode 23 patterned to extend from the region on the second major surface of the silicon substrate 10 to the inside of the through hole is provided on the insulating film 22. The metal electrode 23 is an electrode for connection between the imaging element part in the solid-state imaging device substrate 100 and a circuit substrate 70.

Out of this metal electrode 23, the portion formed inside the through hole is the through-electrode. The through-electrode penetrates a part of the silicon substrate 10 and the interlayer insulating film to reach below the internal electrode 26 and electrically connected to the internal electrode 26.

Furthermore, on the second major surface side, a solder resist layer 24 (protective insulating film) covering the second major surface on which the metal electrode 23 is formed, and having an opening part exposing a part of the metal electrode 23, is provided.

In addition, on the second major surface side, a light-blocking film 18 covering the second major surface on which the solder resist layer 24 is formed, and having an opening part exposing a part of the metal electrode 23, is provided.

In this configuration, (1) a light-blocking solder resist layer where the light-blocking film 18 and the solder resist layer 24 are united into a single layer may be formed of the curable composition of the present invention, or (2) while the light-blocking layer 28 and the solder resist layer 24 are separate layers, the light-blocking film 18 may be formed of the curable composition of the present invention (in this case, the solder resist layer may be formed of a known solder resist composition).

Incidentally, in Fig. 2, the light-blocking film 18 is patterned to cover a part of the metal electrode 23 and expose the remaining portion but may be patterned to expose the entirety of the metal electrode 23 (the same applies to the patterning of the solder resist layer 24).

Also, the solder resist layer 24 may be omitted, or the light-blocking film 18 may be formed directly on the second major surface where the metal electrode 23 is formed.

A solder ball 60 as a connection member is provided on the exposed metal electrode 23, and the metal electrode 23 of the solid-state imaging device substrate 100 and the connection electrode not shown of the circuit substrate 70 are electrically connected through the solder ball 60.

In the above, the configuration of the solid-state device substrate 100 is described, but each part except for the light-blocking film 18 of the solid-state imaging device substrate 100 can be formed by a known method such as method described in paragraphs 0033 to 0068 of JP-a-2009-158863 and method described in paragraphs 0036 to 0065 of JP-A-2009-99591.

The light-blocking film 18 can be formed by the above-described production method for the light-blocking film of the present invention.

The interlayer insulating film 13 is formed, for example, as an $SiO_2$ film or an SiN film by sputtering, CVD (chemical vapor deposition) or the like.

The color filter 15 is formed, for example, by photolithography using a known color resist.

The overcoat 16 and the base layer 14 are formed, for example, by photolithography using a known resist for organic interlayer film formation.

The microlens 17 is formed, for example, by photolithography using a styrene-based resin or the like.
In the case where the solder resist layer 24 and the light-blocking layer 18 are combined to form a light-blocking solder resist layer as a single layer, the layer is preferably formed of the curable composition of the present invention.
On the other hand, when the solder resist layer 24 and the light-blocking film 18 are separate layers, the solder resist layer 24 is preferably formed, for example, by photolithography using a known solder resist containing a phenolic resin, a polyimide-based resin or an amine-based resin.
The solder ball 60 is formed, for example, using Sn-Pb (eutectic), 95Pb-Sn (high-lead high-melting-point solder) or a Pb-free solder such as Sn-Ag, Sn-Cu and Sn-Ag-Cu. The solder ball 60 is formed, for example, as a sphere having a diameter of 100 to 1,000 $\mu$m (preferably a diameter of 150 to 700 $\mu$m).
The internal electrode 26 and the device surface electrode 27 are formed as a metal electrode such as Cu, for example, by CMP (chemical mechanical polishing), photolithography or etching.
The metal electrode 23 is formed as a metal electrode such as Cu, Au, Al, Ni, W, Pt, Mo, Cu compound, W compound and Mo compound, for example, by sputtering, photolithography, etching or electrolytic plating. The metal electrode 23 may be in a single-layer configuration or a multilayer configuration consisting of two or more layers.
The film thickness of the metal electrode 23 is, for example, from 0.1 to 20 $\mu$m (preferably from 0.1 to 10 $\mu$m). The silicon substrate 10 is not particularly limited, but a silicon substrate reduced in the thickness by shaving the back surface of the substrate may be used. The thickness of the substrate is not limited, but, for example, a silicon wafer having a thickness of 20 to 200 $\mu$m (preferably from 30 to 150 $\mu$m) is used.
The through hole of the silicon substrate 10 is formed, for example, by photolithography and RIE (reactive ion etching).
In the forgoing pages, the solid-state imaging device substrate 100 as a specific example of the above-described one embodiment is described by referring to Figs. 1 and 2, but the one embodiment is not limited to the mode of Fig. 1 and Fig. 2, and the configuration of the embodiment is not particularly limited as long as it is a configuration having a metal electrode and a light-blocking film on the back surface side.
Next, an example where the permanent pattern obtained using the curable composition of the present invention is applied to the light-blocking film of a wafer-level lens is described below by referring to the drawings.
Fig. 3 is a plan view showing one example of the configuration of a wafer-level lens array having a plurality of wafer-level lenses.
As shown in Fig. 3, the wafer-level lens array has a substrate 410 and lenses 412 arranged on the substrate 410. Here, in Fig. 3, a plurality of lenses 412 are two-dimensionally arranged with respect to the substrate 410 but may be one-dimensionally arranged.
Fig. 4 is a cross-sectional view along line A-A in Fig. 3.
As shown in Fig. 4, in the waver-level lens array, a light-blocking film 414 for preventing light transmission through a portion except for the lens 412 is provided between a plurality of lenses 412 arranged on the substrate 410.
The wafer-level lens is composed of one lens 412 present on the substrate 410 and a light-blocking film 414 provided in the circumferential periphery thereof. The curable composition of the present invention is used for formation of this light-blocking film 414.
The wafer-level lens is described below by referring, for example, to a configuration where, as shown in Fig. 3, a plurality of lenses 412 are two-dimensionally arranged with respect to a substrate 410.
The lens 412 is generally composed of the same material as the substrate 410 and is molded integrally on the substrate 410 or is molded as a separate structure and fixed on the substrate. Here, an example is described, but the wafer-level lens is not limited to this embodiment and may take various embodiments such as a wafer-level lens having a multilayer structure or a wafer-level lens separated into a lens module by dicing.
The material forming the lens 412 includes, for example, glass. There are an abundant variety of glasses, and since glass having a high refractive index can be selected, this is suitable as the material of the lens. Also, the glass is excellent in the heat resistance and has the advantage of withstanding the reflow mounting on an imaging unit or the like.
Other materials for forming the lens 412 include a resin. The resin is excellent in the processability and is suitable for simply and inexpensively forming a lens surface by a mold or the like.
In this case, an energy-curable resin is preferably used for formation of the lens 412. The energy-curable resin may be either a resin capable of curing by heat or a resin capable of curing by irradiation with an active energy ray (for example, irradiation with heat, ultraviolet ray or electron beam).
As the energy-curable resin, all of known resins may be used, but in consideration of reflow mounting of the imaging unit, a resin having a relatively high softening point, for example, a softening point of 200˚C or more is preferred. A resin having a softening point of 250˚C or more is more preferred.
The mode and production of the wafer-level lens are specifically described below by referring, for example, to the production method of a wafer-level lens array based on Figs. 5 to 10.

[Mode and Production (1) of Wafer-Level Lens]

-Formation of Lens-

The method for forming a lens 412 on a substrate 410 is described by referring to Fig. 5 and Figs. 6A to 6C.
Fig. 5 is a view showing how a molding material (indicated by M in Fig. 5) as a resin composition for lens formation is supplied to a substrate 410.
Also, Figs. 6A to 6C are views showing the procedure of molding a lens 412 on a substrate 410 by using a mold 460.
As shown in Fig. 5, a molding material M is dropped on a lens 412 molding site of a substrate 410 by using a dispenser 450. Here, a molding material M in an amount corresponding to one lens 412 is supplied to one site to be fed.
After supplying the molding material M to the substrate 410, as shown in Fig. 6A, a mold 460 for molding lenses 412 is disposed on the substrate 410 surface side to which the molding material M is supplied.
In the mold 460, concaves 462 for transferring the lens 412 shape are provided according to the desired number of lenses 412.
As shown in Fig. 6B, the mold 460 is pressed against the molding material M on the substrate 410 to deform the molding material M along the lines of the concave 462 shape. In the state of the mold 460 being pressed against the molding material M, when the molding material M is a thermosetting resin or an ultraviolet-curable resin, the mold 460 is eternally irradiated with heat or ultraviolet ray to cure the molding material M.
After curing the molding material M, as shown in Fig. 6C, the substrate 410 and lenses 412 are separated from the mold 460.

-Formation of Light-Blocking Film-

The method for forming a light-blocking film 414 in the circumferential periphery of the lens 412 is described below by referring to Figs. 7A to 7C.
Figs. 7A to 7C are schematic cross-sectional views showing the process of providing a light-blocking film 414 on the substrate 410 having molded thereon lenses 412.
The method for forming the light-blocking film 414 includes a light-blocking coating layer forming step of coating the curable composition of the present invention on a substrate 410 to form a light-blocking coating layer 414A (see, Fig. 7A), an exposure step of pattern-exposing the light-blocking coating layer 414A through a mask 470 (see, Fig. 7B), and a development step of developing the light-blocking coating layer 414A after exposure to remove the uncured area and form a patterned light-blocking film 414 (see, Fig. 7C).
Incidentally, formation of the light-blocking film 414 can be arbitrarily performed before producing the lens 412 or after the lens 412 is produced, but here, the method of performing the formation after production of the lens 412 is described in detail.
The steps in the method of forming the light-blocking film 414 are described below.

<Light-Blocking Coating Layer Forming Step>

In the light-blocking coating layer forming step, as shown in Fig. 7A, a curable composition is coated on a substrate 410 to form a light-blocking coating layer 414A having low optical reflectance and being composed of the curable composition. At this time, the light-blocking coating layer 414A is formed to cover all of the substrate 410 surface and the lens surface 412a and lens edge 412b surface of the lens 412.
The substrate 410 which can be used in this step is not particularly limited. Examples thereof include soda glass, alkali-free glass, Pyrex (registered trademark) glass, quartz glass and transparent resin.
The substrate 410 as used herein indicates an embodiment containing both the lens 412 and the substrate 410 in the case of integrally forming the lens 412 and the substrate 410.
On the substrate 410, if desired, an undercoat layer may be provided so as to improve adherence to an overlying layer, prevent diffusion of the material, or flatten the substrate 410 surface.
As the method for coating the curable composition on the substrate 410 and the lens 412, various coating methods such as slit coating, spray coating, inkjet printing, spin coating, cast coating, roll coating and screen printing may be applied.
In view of thickness uniformity of the coated film and easy drying of the coating solvent, the film thickness immediately after coating of the curable composition is preferably from 0.1 to 10 μm, more preferably from 0.2 to 5 μm, still more preferably from 0.2 to 3 μm.
Drying (prebaking) of the light-blocking coating layer 414A coated on the substrate 410 may be performed using a hot plate, an oven or the like at a temperature of 50 to 140˚C for 10 to 300 seconds.

The thickness of the coated film after drying of the curable composition (hereinafter, sometimes referred to as "dry thickness") may be arbitrarily selected by taking into consideration the performance such as desired light-blocking effect and is generally from 0.1 μm to less than 50 μm.

<Exposure Step>

In the exposure step, the light-blocking coating layer 414A formed in the light-blocking coating layer forming step is pattern-exposed. The pattern exposure may be scanning exposure, but an embodiment of, as shown in Fig. 7B, performing the exposure through a mask 470 having a predetermined mask pattern is preferred.

As for the exposure in this step, the pattern exposure of the light-blocking coating layer 414A is performed by exposure through a predetermined mask pattern, where only the portion irradiated with light out of the light-blocking coating layer 414A is cured by the exposure. In this exposure, a mask pattern allowing for irradiation with light on the lens edge 412b surface and the substrate 410 surface between lenses 412 is used. By using such a mask pattern, the light-blocking coating layer 414A only in the region excluding the lens surface 412a is cured by the irradiation with light, and the cured region forms the light-blocking film 414.

The radiation which can be used for exposure is preferably an ultraviolet ray such as g-line, h-line and i-line. For this radiation, a light source having a single wavelength may be used, or a light source containing all wavelengths, such as high-pressure mercury lamp, may be used.

<Development Step>

Subsequently, alkali development (development step) is performed, whereby the portion not irradiated with light in the exposure, that is, the uncured region of the light-blocking coating layer 414A, is dissolved out into an aqueous alkali solution and only the region cured by the irradiation with light is allowed to remain.

Specifically, by developing the light-blocking coating layer 414A exposed as shown in Fig. 7B, only the light-blocking coating layer 414A formed on the lens surface 12a is, as shown in Fig. 7C, removed and a light-blocking film 414 cured is formed in other regions.

As the alkali agent contained in the developer (aqueous alkaline solution) used in the development step, all of an organic alkali agent, an inorganic alkali agent and a combination thereof may be used. For the light-blocking film formation in the present invention, an organic alkali agent is preferably used, because it scarcely damages the neighboring circuit or the like.

Examples of the alkali agent used in the developer include an organic alkaline compound (organic alkali agent) such as aqueous ammonia, ethylamine, diethylamine, dimethylethanolamine, tetramethylammonium hydroxide, tetraethylammonium hydroxide, choline, pyrrole, piperidine and 1,8-diazabicyclo-[5,4,0]-7-undecene, and an inorganic compound (inorganic alkali agent) such as sodium hydroxide, potassium hydroxide, sodium hydrogencarbonate and potassium hydrogencarbonate. An aqueous alkaline solution obtained by diluting such an alkali agent with pure water to a concentration of 0.001 to 10 mass%, preferably from 0.01 to 1 mass%, is preferably used as the developer.

The development temperature is usually from 20 to 30˚C, and the development time is from 20 to 90 seconds.

In the case of using a developer composed of such an aqueous alkaline solution, after removing the unexposed area of the coated film with a developer, the film is generally washed (rinsed) with pure water. That is, after the development, the film is thoroughly washed with pure water to remove the excess developer and then further subjected to a drying step.

Incidentally, after performing the above-described light-blocking coating layer forming step, exposure step and development step, a curing step of curing the formed light-blocking film (light-blocking pattern) by heating (post-baking) and/or exposure may be provided, if desired.

The post-baking is a heating treatment after development so as to achieve complete curing, and a thermal curing treatment usually at 100 to 250˚C is performed. The conditions of post-baking, such as temperature and time, may be appropriately set according to the material of the substrate 410 or lens 412. For example, when the substrate 410 is glass, out of the temperature range above, a temperature of 180 to 240˚C is preferably used.

This post-baking treatment is applied to the light-blocking film 414 formed after development and can be performed in a continuous system or a batch system by using a heating device such as hot plate, convection oven (hot air circulating drier) and high-frequency heater to establish the above-described conditions.

The procedure above is described by referring, for example, a case where the lens 412 has a concave shape, but the shape is not particularly limited and may be convex or aspheric. Also, the procedure above is described by referring, for example, a wafer-level lens where a plurality of lenses 412 are molded on one surface of a substrate 410, but a configuration where a plurality of lenses 412 are molded on both surfaces of a substrate 410 may be also employed and in this case, the patterned light-blocking film 414 is formed on both surfaces in the regions excluding lens surfaces.

[Mode and Production (2) of Wafer-Level Lens]

Fig. 8 is a view showing another configuration example of the wafer-level lens array.

The wafer-level lens shown in Fig. 8 is in a configuration (monolithic type) where the substrate 410 and the lens 412 are simultaneously molded using the same molding material.

As the molding material for the preparation of such a wafer-level lens, the same as those described above may be used. Also, in this example, a plurality of concave lenses 412 are formed on one surface (surface on the upper side in the Figure) of a substrate 410, and a plurality of convex lenses 420 are formed on another surface (surface on the lower side in the Figure). Furthermore, a patterned light-blocking film 414 is formed in the regions excluding lens surfaces 412a of the substrate 410, that is, formed on the substrate 410 surface and the lens edge 412b surface. As the patterning method when forming the light-blocking film 414, the above-described procedure may be applied.

[Mode and Production (3) of Wafer-Level Lens]

Still another configuration example of the wafer-level lens array and the production procedure therefor are described below by referring to Figs. 9A to 9C and Figs. 10A to 10C.

Figs. 9A to 9C are schematic views showing another process of forming a patterned light-blocking film 414.

Figs. 10A to 10C are schematic views showing the process of first forming a patterned light-blocking film 414 and next molding a lens 412.

In the example of the wafer-level lens array shown in Figs. 5 to 8, a patterned light-blocking film 414 is formed on a substrate 410 having provided thereon a lens 412, but in the following procedure, a patterned light-blocking film 414 is first formed on a substrate 410 and a lens 412 is then molded on the substrate 410.

-Formation of Light-Blocking Film-

As shown in Fig. 9A, first, a light-blocking coating layer forming step of coating a curable composition on a substrate 410 to form a light-blocking coating layer 414A is performed.

Thereafter, drying of the light-blocking coating layer 414A formed on the substrate 410 is performed using a hot plate, an oven or the like at a temperature of 50 to 140˚C for 10 to 300 seconds. The dry thickness of the curable composition may be arbitrarily selected according to the performance such as desired light-blocking effect but is generally from 0.1 μm to less than 50 μm.

Next, as shown in Fig. 9B, an exposure step of patternwise exposing the light-blocking coating layer 414A formed in the light-blocking coating layer forming step, through a mask 470 is performed. The mask 470 has a predetermined mask pattern.

In the exposure of this step, the light-blocking coating layer 414 is pattern-exposed, whereby only the portion irradiated with light out of the light-blocking coating layer 414A is cured. Here, a mask pattern allowing for irradiation with light only on the light-blocking coating layer 414A in the region excluding the site working out to a lens opening 414a of a lens 412 when the lens 412 is molded in the later step, is used. By this method, the light-blocking coating layer 414A only in the region excluding the site working out to a lens opening 414a of a lens 412 is cured by the irradiation with light. As for the radiation which can be used for the exposure, an ultraviolet ray such as g-line, h-line and i-line is preferably used, similarly to the procedure described earlier.

Subsequently, alkali development (development step) is performed, whereby the light-blocking coating layer 414A only in the region corresponding to a lens opening 414a of a lens 412, which is the light-blocking coating layer 414A region uncured in the pattern exposure above, is dissolved out into an aqueous alkali solution. At this time, as shown in Fig. 9C, the photocured light-blocking coating layer 414A in the region excluding the region for a lens opening 414a of a lens 412 remains on the substrate 410 and forms a light-blocking film 414.

As for the alkali agent in the aqueous alkali solution that is the developer, the same as in the procedure described earlier may be used.

After the development, the excess developer is removed by washing, and the film is then dried.

Also in this embodiment, after performing the above-described light-blocking coating layer forming step, exposure step and development step, a curing step of curing the formed light-blocking film by post-baking and/or exposure may be provided, if desired.

The curable composition of the present invention can be easily cleaned and removed with a known cleaning solution even when it attaches, for example, to a nozzle at the discharge port of the coating apparatus, a piping area of the coating apparatus, or the interior of the coating apparatus. In this case, in order to more efficiently perform the cleaning and removal, a solvent described above as the solvent contained in the curable composition of the present

invention is preferably used for the cleaning solution.

Furthermore, cleaning solutions described, for example, in JP-A-7-128867, JP-A-7-146562, JP-A-8-278637, JP-A-2000-273370, JP-A-2006-85140, JP-A-2006-291191, JP-A-2007-2101, JP-A-2007-2102 and JP-A-2007-281523 may be also suitably used as the cleaning solution for cleaning and removing the curable composition of the present invention.

As the cleaning solution, an alkylene glycol monoalkyl ether carboxylate or an alkylene glycol monoalkyl ether is preferably used.

One of these solvent usable as the cleaning solution may be used alone, or two or more thereof may be mixed and used.

In the case of mixing two or more solvents, a mixed solvent obtained by mixing a hydroxyl group-containing solvent and a hydroxyl group-free solvent is preferred. The mass ratio between the hydroxyl group-containing solvent and the hydroxyl group-free solvent is from 1/99 to 99/1, preferably from 10/90 to 90/10, more preferably from 20/80 to 80/20. The mixed solvent is preferably a mixed solvent of propylene glycol monomethyl ether acetate (PGMEA, another name: 1-methoxy-2-acetoxypropane) and propylene glycol monomethyl ether (PGME, another name: 1-methoxy-2-propanol) in a ratio of 60/40.

Incidentally, in order to enhance the permeability of the cleaning solution into the curable composition, a surfactant described above as the surfactant which can be incorporated into the curable composition may be added to the cleaning solution.

-Formation of Lens-

A step of forming a lens 412 after the formation of the light-blocking film 414 is described below.

As shown in Fig. 10A, a molding material M constituting the lens 412 is dropped by a dispenser 450 on the substrate 410 having formed thereon the patterned light-blocking film 414. The molding material M is supplied to cover the region corresponding to a lens opening 414a of a lens 412, including a part of the light-blocking film 414 edge adjacent to the opening.

After supplying the molding material M to the substrate 410, as shown in Fig. 10B, a mold 480 for molding lenses is disposed on the substrate 410 surface side to which the molding material M is supplied. In the mold 480, concaves 482 for transferring the lens 412 shape are provided according to the desired number of lenses 412.

The mold 480 is pressed against the molding material M on the substrate 410 to deform the molding material M along the lines of the concave shape. In the state of the mold 480 being pressed against the molding material M, when the molding material M is a thermosetting resin or an ultraviolet-curable resin, the mold is externally irradiated with heat or ultraviolet ray to cure the molding material M.

After curing the molding material M, the substrate 410 and lenses 412 are separated from the mold 480 to obtain a wafer-level lens having, as shown in Fig. 10C, a patterned light-blocking film 414 on a substrate 410.

In this way, the wafer-level lens may have not only a configuration where the patterned light-blocking film 414 is provided, as shown in Fig. 7, in the region excluding a lens surface 412a of a lens 412, but also a configuration where the light-blocking film 414 is provided, as shown in Fig. 10C, in the region excluding a lens opening 414a of a lens 412.

In the wafer-level lens, the light-blocking film 414 being patternwise formed on at least one surface of the substrate 410 sufficiently blocks light in the regions excluding the lens surface 412a or lens opening 414a of the 412 and at the same time, suppress the generation of reflected light. Accordingly, when the wafer-level lens is applied to an imaging module with a solid-state imaging device, a trouble such as ghost or flare associated with reflected light can be prevented from occurring during imaging.

Also, the light-blocking film 414 is provided on the substrate surface, eliminating the need to fix a separate light-blocking member or the like on the wafer-level lens, and the rise in the production cost can be suppressed.

Incidentally, in the case of a configuration where a structure with an uneven surface is provided around the lens, a trouble such as ghost may be likely to occur due to reflection or diffusion of light incident on the structure. To get rid of this trouble, when a configuration of, as shown in Fig. 7, providing a patterned light-blocking film 414 in the region excluding a lens surface 412a of a lens 412 is employed, light can be blocked except for the lens surface 412a and the optical performance can be improved.

[Examples]

The present invention is described below by referring to Examples, but the present invention should not be construed as being limited to these Examples.

<Preparation of Binder Solution A>

A 1,000 mL-volume three-neck flask was charged with 159 g of 1-methoxy-2-propanol and heated to 85˚C under nitrogen flow, and a solution obtained by dissolving 63.4 g of benzyl methacrylate, 72.3 g of methacrylic acid and 4.15 g of V-601 (produced by Wako Pure Chemical Industries, Ltd.) in 159 g of 1-methoxy-2-propanol was added dropwise thereto over 2 hours. After the completion of dropwise addition, the mixture was further heated for 5 hours and thereby reacted.

Subsequently, the heating was stopped, and a benzyl methacrylate/methacrylic acid copolymer (30/70 by mol%) was obtained.

Thereafter, a 120.0 g portion of the copolymer solution above was transferred to a 300 mL-volume three-neck flask, and 16.6 g of glycidyl methacrylate and 0.16 g of p-methoxyphenol were added and dissolved by stirring. After the dissolution, 3.0 g of triphenylphosphine was added, and the mixture was heated to 100˚C, thereby performing an addition reaction. Disappearance of glycidyl methacrylate was confirmed by gas chromatography, and heating was stopped. Furthermore, 38 g of 1-methoxy-2-propanol was added, whereby Binder Solution A having an acid group content of 2 meq/g (acid value: 112 mgKOH/g), a crosslinking group content of 2.23 meq/g, a weight average molecular weight of 24,000 (in terms of polystyrene by GPC method) and a solid content of 46 mass% was prepared.

<Preparation of Binder Solution B>

In a 500 ml-volume three-neck round-bottom flask equipped with a condenser and a stirrer, a diisocyanate compound shown below and two kinds of diol compounds shown below were dissolved in a molar ratio shown below in 100 ml of N,N-dimethylacetamide (the total molar amount of the diisocyanate compound and two kinds of diol compounds was 0.152 mol). Thereto, 0.1 g of dibutyltin dilaurate was added, and the mixture was heated with stirring at 100˚C for 8 hours. The resulting solution was diluted with 100 ml of N,N-dimethylformamide and 200 ml of methyl alcohol and stirred for 30 minutes. The reaction solution was poured in 3 liter of water with stirring to precipitate a white polymer. This polymer was separated by filtration, washed with water and dried under vacuum to obtain Urethane-Based Resin P-1. Subsequently, 1-methoxy-2-propanol was added to the urethane-based polymer to prepare Binder Solution B having an acid group content of 1.3 meq/g, a weight average molecular weight of 17,000 (in terms of polystyrene by GPC method) and a solid content of 46 mass%.

| Polymer No. | Diisocyanate Compound Used (mol%) | Diol Compound Used (mol%) | Weight Average Molecular Weight |
|---|---|---|---|
| P-1 | 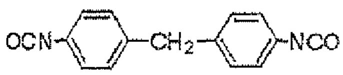 50 | 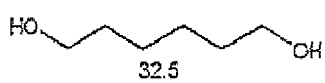 32.5 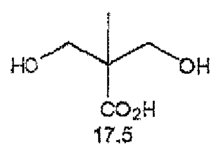 17.5 | 17,000 |

<Preparation of Curable Composition Solution>

(Example 1)

The components in the following formulation were mixed to obtain the curable composition solution of Example 1. The viscosity at 25˚C of this composition was 520 mPa●s (the solid content concentration of the composition was 50 mass%).

| | |
|---|---|
| Binder solution shown in Table 1 (alkali- soluble binder) | 45.0 parts by mass |
| Crosslinking agent shown in Table 1 | 15.7 parts by mass |
| Acid generator shown in Table 1 | 2.50 parts by mass |
| Sensitizer shown in Table 1 | 1.20 parts by mass |
| Silica liquid dispersion shown below (filler, alkali-soluble binder, curing accelerator) | 35.7 parts by mass |
| Megaface F-780 (produced by Dainippon Ink and Chemicals, Inc.) (surfactant) | 0.13 parts by mass |

(continued)

| | |
|---|---|
| YMF-02 (produced by Sumitomo Metal Mining Co., Ltd., cesium tungsten oxide (a 18.5 mass% liquid dispersion of $Cs_{0.33}$ $WO_3$ (average dispersed particle diameter: 800 nm or less)) | 18.0 parts by mass |

The silica liquid dispersion used above was prepared by previously mixing 30 parts by mass of silica (SO-C2, produced by Admatechs Company Limited) (filler), 48.2 parts by mass of Binder Solution A, 0.37 parts by mass of dicyandiamide (curing accelerator) and 59.0 parts by mass of propylene glycol monomethyl ether acetate, and then dispersing the mixture with use of zirconia beads having a diameter of 1.0 mm in a motor mill M-250 (manufactured by Eiger) at a circumferential velocity of 9 m/s for 3 hours.

(Examples 2 to 8 and Reference Example 1)

The curing composition solutions of Examples 2 to 8 and Reference Example 1 were obtained in the same manner as in Example 1 except for changing the kinds of binder solution (including the binder solution in the silica liquid dispersion), crosslinking agent, acid generator and sensitizer to those shown in Table 1. Here, HS-1 used in Reference Example 1 is not a compound capable of generating an acid upon irradiation with an actinic ray or radiation (acid generator) but is a compound capable of generating a radical upon irradiation with an actinic ray or radiation (radical generator).

Table 1

| Example | Binder Solution | Crosslinking Agent | Acid Generator | Sensitizer | Viscosity (mPa•s) (25°C) |
|---|---|---|---|---|---|
| Example 1 | B-1 | K-1 | S-1 | Z-1 | 520 |
| Example 2 | B-2 | K-1 | S-2 | Z-2 | 420 |
| Example 3 | B-3 | K-1 | S-2 | Z-1 | 530 |
| Example 4 | B-3 | K-2 | S-3 | Z-3 | 540 |
| Example 5 | B-4 | K-3 | S-4 | Z-2 | 620 |
| Example 6 | B-4 | K-4 | S-1 | Z-1 | 570 |
| Example 7 | B-4 | K-5 | S-1 | Z-2 | 530 |
| Example 8 | B-4 | K-5 | S-3 | Z-4 | 550 |
| Reference Example 1 | B-1 | HK-1 | HS-1 | none | 500 |

B-1: Binder Solution A

B-2: Binder Solution B

B-3: A polyamide acid solution obtained by the following synthesis method.

B-4: A PGMEA solution of 46 mass% polyhydroxystyrene (MARUKA LYNCUR M S-4, produced by Maruzen Petrochemical Co., Ltd.).

(Synthesis Method of Polyamide Resin)

After pouring 12.09 g (0.0375 mol) of 3.3',4,4'-benzophenonetetracarboxylic dianhydride), 2.73 g (0.0125 mol) of pyromellitic dianhydride and 50 g of N-methyl-2-pyrrolidone, these were thoroughly mixed with stirring and cooled to 10°C. Subsequently, 9.41 g (0.047 mol) of 4,4'-diaminodiphenyl ether and 1.1 g (0.003 mol) of (3-amino-4-hydroxyphenyl) hexafluoropropane were dissolved in 30 g of N-methyl-2-pyrrolidone, and the resulting solution was gradually added dropwise to the reaction flask above kept at 10°C. The thus-obtained mixed solution was stirred at 10 to 15°C for 6 hours to obtain Solution B-3 of polyamide acid. Incidentally, the logarithmic viscosity of the N-methyl-2-pyrrolidone solution of polyamide acid was measured at 30°C and found to be 1.4 dl/g.
K-1: 2,4,6-Tris[bis(methoxymethyl)amino]-1,3.5-triazine

K-2: Hexamethylolmelamine
K-3: Xylylenc bisoxetane (OXT-121 produced by Toagosei Co., Ltd.).
K-4: Bisphenol A propylene oxide diglycidyl ether (Epolight 3002, produced by Kyoeisha Chemical Co., Ltd.)

K-5: 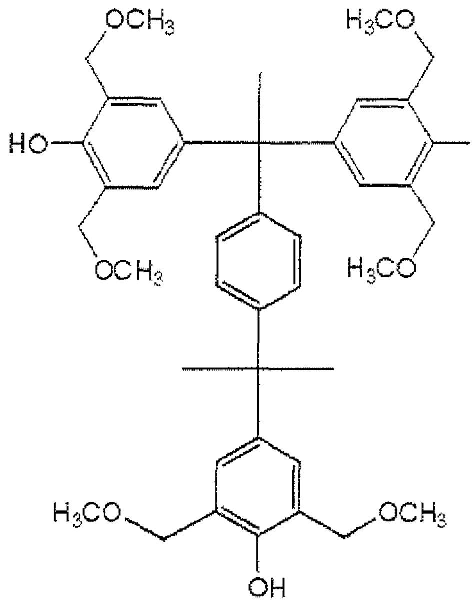

S-1: Triphenylsulfonium trifluoromethanesulfonate

S-2: Triphenylsulfonium p-toluenesulfonate

S-3: Bis(4-butoxyphenyl)iodonium p-toluenesulfonate

S-4: Tris(4-chlorophenyl)sulfonium 1-naphthalenesulfonate

Z-1: 9,10-Dibutoxyanthracene

Z-2: N-Ethyl-6-(2-methylbenzoyl)carbazole

Z-3: Michler's ketone

Z-4: Thioxanthone

HK-1: Bisphenol A diglycidyl ether acryl acid adduct (Epoxy Ester 3000A, produced by Kyoeisha Chemical Co., Ltd.)

HS-1: 2-(o-methoxystyryl)-4,6-bis(trichloromethyl)-S-triazine (produced by Midori Kagaku Co., Ltd.)

<Evaluation of Curable Composition for Solder Resist>

(Resist Pattern Formation)

Each of the curable compositions obtained in Examples 1 to 8 and Reference Example 1 was coated on a silicon wafer by a spin coating method to have a film thickness of 25 μm and then heated on a hot plate at 120°C for 2 minutes to obtain a photosensitive layer.
The obtained photosensitive layer was irradiated with light in an i-line stepper through a photomask having an island pattern in a square form of 200 μm on a side by changing the exposure dose in steps of 50 $mJ/cm^2$ in the range of 50 to 2,000 $mJ/cm^2$.
After the irradiation, heating was performed on a hot plate at 120°C for 3 minutes.
The photosensitive laser after the exposure and heating was subjected to puddle development at 25°C for 40 seconds by using an aqueous 2.38 mass% tetramethylammonium hydroxide solution, then rinsed by spin shower and

further washed with pure water to obtain an infrared-blocking solder resist pattern. The minimum exposure dose for obtaining an island pattern of 200 μm on a side when performing the development step for 40 seconds was measured. A smaller numerical value indicates higher sensitivity and is better.

(Infrared-Blocking Effect)

The curable composition was spin-coated on a glass substrate under the conditions above to form a photosensitive layer (curable composition layer) coating film having a thickness of 25 μm, and the transmittance at a wavelength of 1,200 nm of the coating film was measured using Ultraviolet-Visible-Near Infrared Spectrophotometer UV3600 (manufactured by Shimadzu Corporation). As the numerical value is smaller, the infrared-blocking effect is judged as higher. When the transmittance is 2% or less, the coating film can be said to exhibit a practically good infrared-blocking effect.

(Evaluation of Pattern)

In accordance with (Resist Pattern Formation) above, exposure using the minimum exposure dose and development were performed to form a pattern. The cross-section of the island pattern of 200 μm on a side was observed using an electron microscope (S-4800, manufactured by Hitachi High-Technologies Corporation) and ranked according to the following evaluation criteria.

[Evaluation Criteria]

A: A pattern was formed on the substrate with sufficient adherence and the cross-section of the pattern showed a good rectangular shape. That is, in the cross-sectional profile of the pattern, the difference between the width in the upper layer part of the pattern and the width in the lower layer part (in the vicinity of interface with the substrate) was 7 μm or less.
B: A pattern was formed on the substrate with sufficient adherence and the cross-section of the pattern showed a good rectangular shape. That is, in the cross-sectional profile of the pattern, the difference between the width in the upper layer part of the pattern and the width in the lower layer part was more than 7 μm and 10 μm or less.
C: In the cross-sectional profile of the pattern, the difference between the width in the upper layer part of the pattern and the width in the lower layer part was more than 10 μm and 15 μm or less.
D: In the cross-sectional profile of the pattern, the difference between the width in the upper layer part of the pattern and the width in the lower layer part was more than 15 μm.

(Repeated Heat/Cold Shock Resistance: Thermal Cycle Test (TCT) Resistance)

On a silicon wafer as the base material, where wiring was formed in a comb form such that the copper thickness was 12 μm and the copper line/space was 50 μm/50 μm, each of the curable compositions of Examples 1 to 8 and Reference Example 1 was coated by a spin coating method to have a film thickness of 20 μm on the copper. Thereafter, the coating film was heated on a hot plate at 100˚C for 2 minutes to obtain a photosensitive layer.
The obtained photosensitive layer was irradiated with light of a high-pressure mercury lamp at an exposure dose of 800 $mJ/cm^2$.
The photosensitive laser after the exposure was subjected to puddle development at 25˚C for 40 seconds by using an aqueous 2.38 mass% tetramethylammonium hydroxide solution, then rinsed by spin shower, further washed with pure water and thereafter, heat-treated (post-baking) at 150˚C for 1 hour to form a solder resist pattern (permanent pattern). With respect to the formed permanent pattern, an electronic component module was left standing in a gas phase at temperatures of -55˚C and 125˚C each for 30 minutes by using a gas-phase heat/cold shock tester, which was taken as one cycle, and by performing the test under the condition of 300 cycles, the heat/cold shock property of the permanent pattern with respect to the region of 5 cm × 5 cm was evaluated according to the following criteria.

[Evaluation Criteria]

A: Cracks were not generated.
B: Cracks were generated but the number of cracks was less than 10.
C: 10 Cracks or more were generated.

Table 2

| | Infrared-Blocking Effect (1200 nm) | Minimum Exposure Dose ($mJ/cm^2$) | Evaluation of Pattern | TCT Resistance |
|---|---|---|---|---|
| Example 1 | <2% | 300 | B | B |
| Example 2 | <2% | 300 | B | B |
| Example 3 | <2% | 150 | A | A |
| Example 4 | <2% | 200 | A | A |
| Example 5 | <2% | 300 | B | B |
| Example 6 | <2% | 300 | B | B |
| Example 7 | <2% | 150 | A | A |
| Example 8 | <2% | 200 | A | A |
| Reference Example 1 | <2% | 300 | C | B |

As seen from the results in Table 2, compared with Reference Example 1 where the crosslinking agent is caused to undergo a crosslinking reaction by the action of a radical generated from a radial generator, in Examples where the crosslinking agent is caused to undergo a crosslinking reaction by the action of an acid generated from an acid generator, a pattern satisfying all of the requirements that (1) the light-blocking effect in the infrared region is high, (2) a desired profile and an excellent endurance (heat/cold shock resistance and adherence to substrate) are obtained by alkali development, and (3) the sensitivity in pattern formation is high, can be formed.

This application is based on a Japanese patent application filed on March 8,2011 (Japanese Patent Application No. 2011-50678), and the contents thereof are incorporated herein by reference.

[Reference Signs List]

10 Silicon substrate

12 Imaging device

13 Interlayer insulating film

14 Base layer

15 Color filter

16 Overcoat

17 Microlens

18 Light-blocking film

20 Adhesive

22 Insulating film

23 Metal electrode

24 Solder resist layer

26 Internal electrode

| | |
|---|---|
| 27 | Device surface electrode |
| 30 | Glass substrate |
| 40 | Imaging lens |
| 41 | Adhesive |
| 42 | Infrared cut filter |
| 43 | Adhesive |
| 44 | Light-blocking and electromagnetic shield |
| 45 | Adhesive |
| 50 | Lens holder |
| 60 | Solder ball |
| 70 | Circuit substrate |
| 100 | Solid-state imaging device substrate |
| 200 | Camera module |
| 410 | Substrate |
| 412, 420 | Lens |
| 412a | Lens surface |
| 412b | Lens edge |
| 414 | Light-blocking film |
| 414A | Light-blocking coated layer |
| 414a | Lens opening |
| 450 | Dispenser |
| 460, 480 | Mold |
| 462, 482 | Concave |
| 470 | Mask |

## Claims

**1.** A curable composition for a solid-state imaging device, comprising:

(A) an infrared-blocking material,
(B) a compound capable of generating an acid upon irradiation with an actinic ray or radiation,
(C) a compound caused to undergo a crosslinking reaction by the action of an acid, and
(D) a binder resin.

**2.** The curable composition for a solid-state imaging device as claimed in claim 1, wherein the compound (C) is a compound having an oxirane group, a hydroxymethyl group, an alkoxymethyl group or a phenol group.

**3.** The curable composition for a solid-state imaging device as claimed in claim 2, wherein the compound (C) is a compound having two or more oxirane groups, hydroxymethyl groups, alkoxymethyl groups or phenol groups.

**4.** The curable composition for a solid-state imaging device as claimed in any one of claims 1 to 3, wherein the compound (B) is an onium salt compound.

**5.** The curable composition for a solid-state imaging device as claimed in any one of claims 1 to 4, wherein the binder resin (D) has an acid group.

**6.** The curable composition for a solid-state imaging device as claimed in any one of claims 1 to 5, wherein the binder resin (D) is at least either one of a polyamide-based resin and a polyimide-based resin.

**7.** The curable composition for a solid-state imaging device as claimed in any one of claims 1 to 5, wherein the binder resin (D) is a urethane resin.

**8.** The curable composition for a solid-state imaging device as claimed in any one of claims 1 to 7, wherein the infrared-blocking material (A) is a tungsten compound.

**9.** The curable composition for a solid-state imaging device as claimed in any one of claims 1 to 8, wherein the viscosity at 25˚C is from 200 to 1,000 mPas.

**10.** A photosensitive layer formed of the curable composition for a solid-state imaging device claimed in any one of claims 1 to 9.

**11.** A permanent pattern formed using the curable composition for a solid-state imaging device claimed in any one of claims 1 to 9.

**12.** The permanent pattern as claimed in claim 11, wherein the permanent pattern is a solder resist layer.

**13.** The permanent pattern as claimed in claim 11, wherein the permanent pattern is an infrared-blocking film.

**14.** A wafer-level lens having a lens and the permanent pattern claimed in claim 11 formed in the circumferential edge part of the lens.

**15.** A solid-state imaging device having the permanent pattern claimed in any one of claims 11 to 13.

**16.** A solid-state imaging device comprising:

a solid-state imaging device substrate having an imaging element part formed on one surface thereof, and
an infrared-blocking film provided on the other surface side of the solid-state imaging device substrate,
wherein the infrared-blocking film is the permanent pattern claimed in claim 13.

**17.** A pattern forming method comprising, in order,
a step of forming the photosensitive layer claimed in claim 10,
a step of patternwise exposing said photosensitive layer to cure the exposed area,
and
a step of removing the unexposed area by alkali development to form a permanent pattern.

FIG. 1

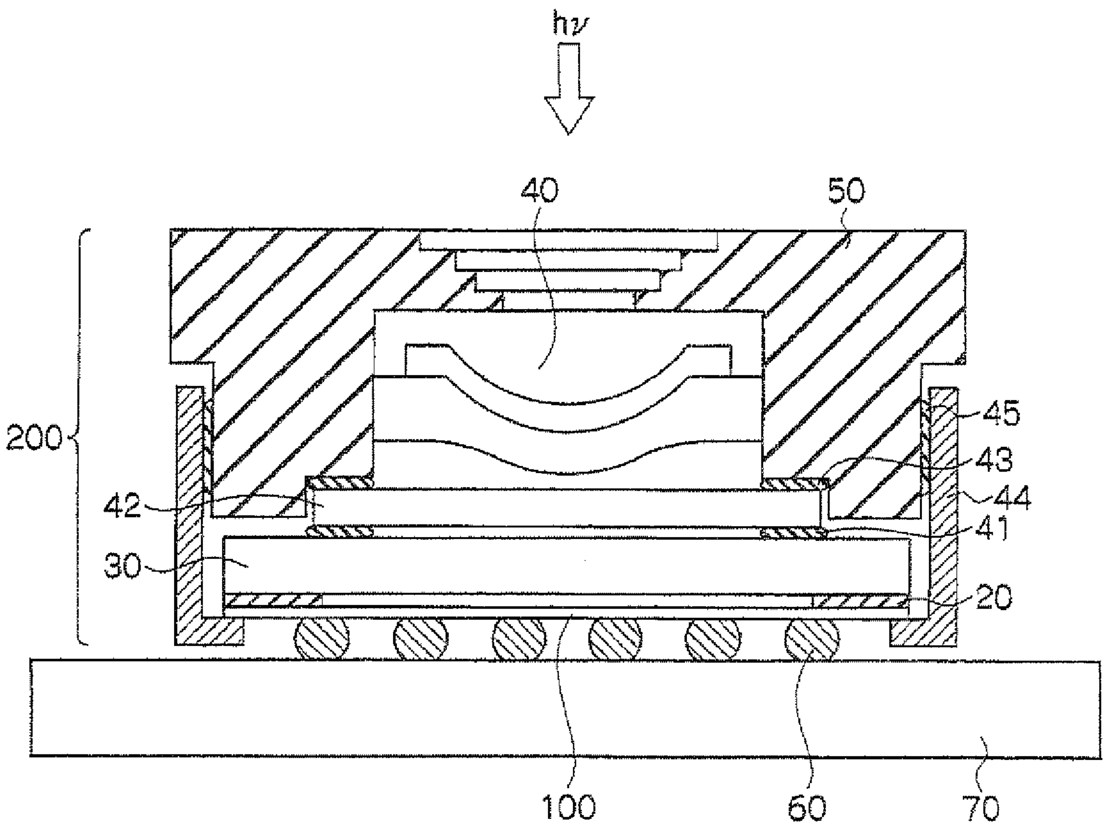

FIG. 2

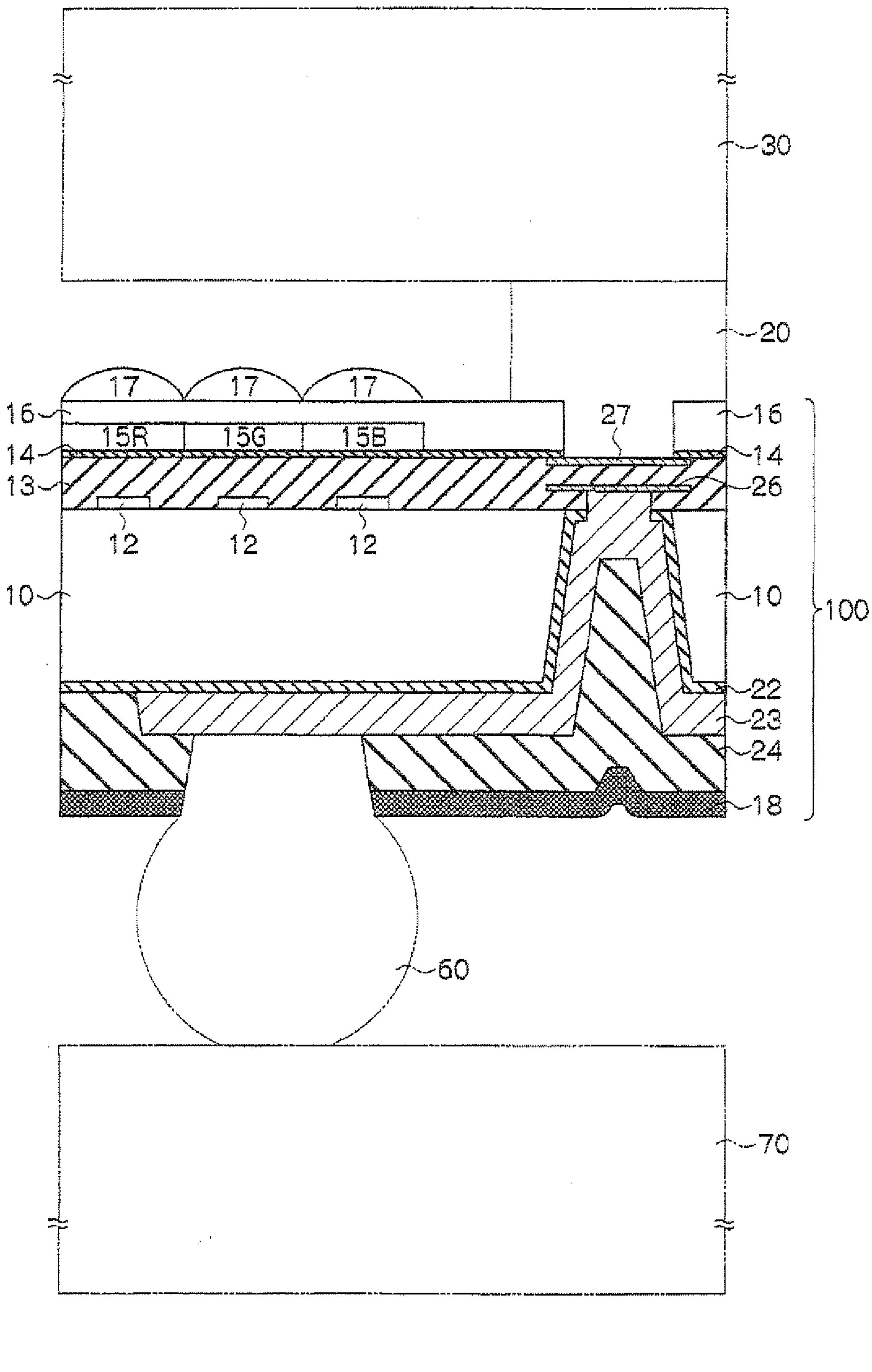
30
20
17
17
17
16
15R
15G
15B
27
16
14
14
13
26
12
12
12
10
10
100
22
23
24
18
60
70

FIG. 3

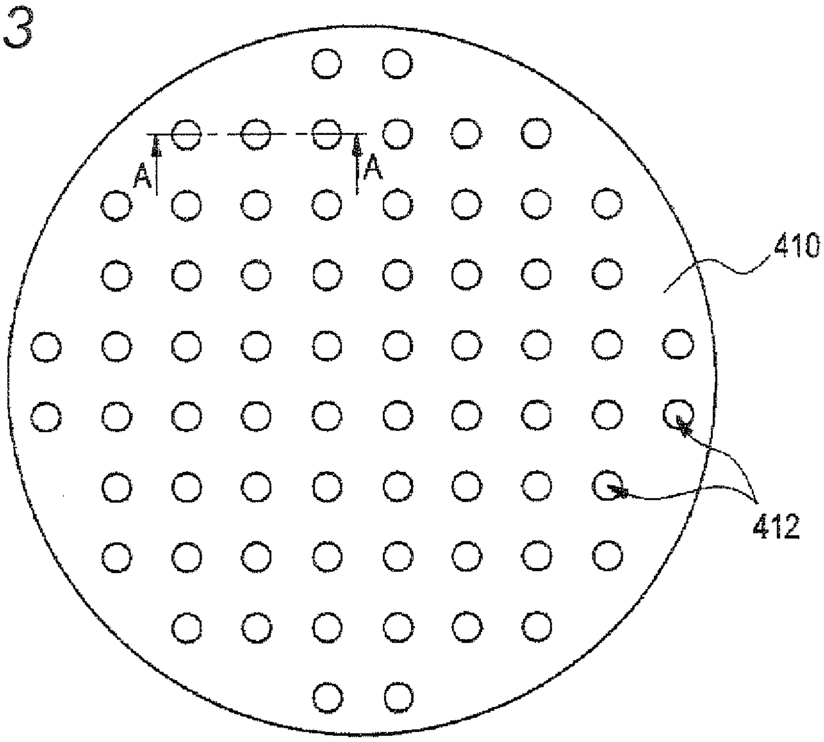


FIG. 4

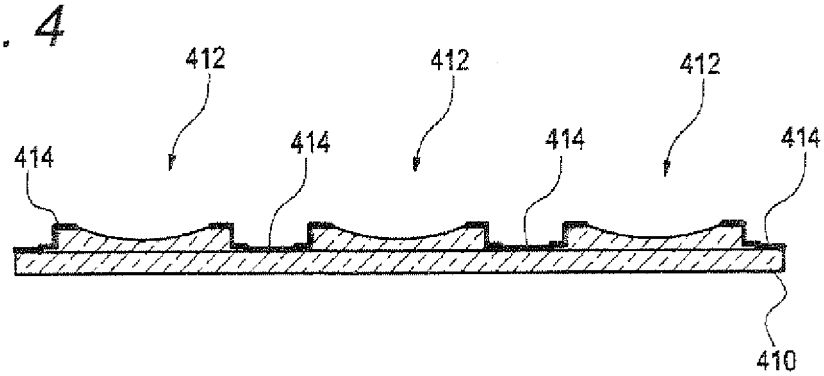


FIG. 5

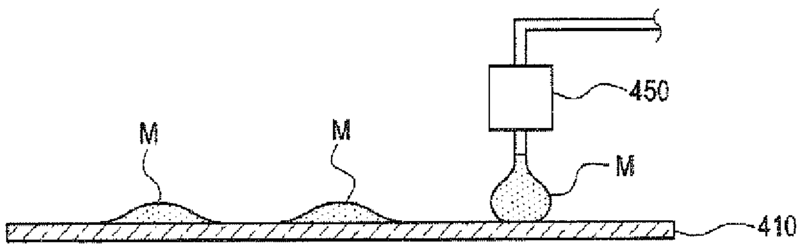

FIG. 6A

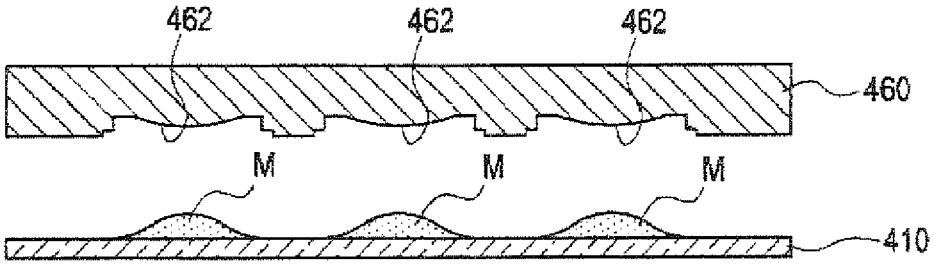


FIG. 6B

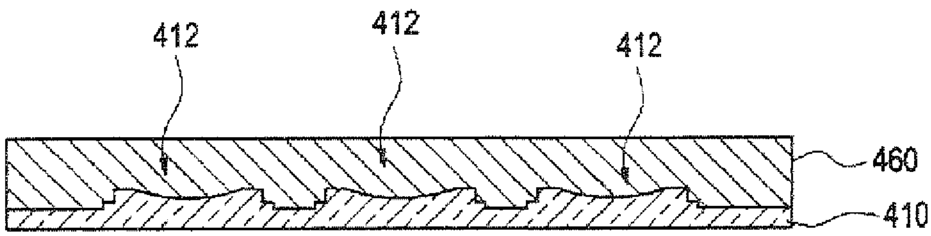


FIG. 6C

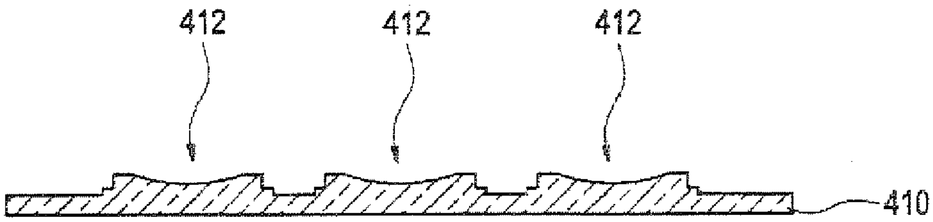

FIG. 7A

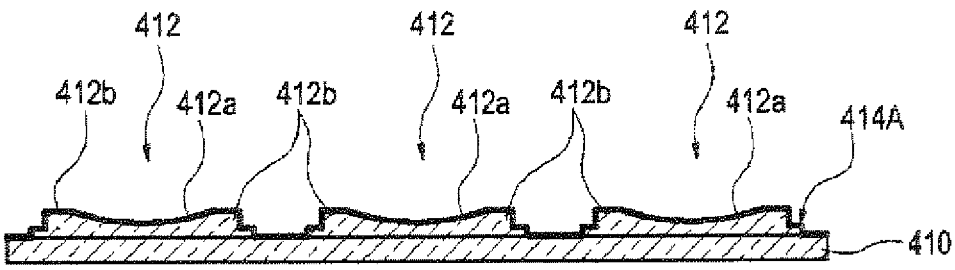


FIG. 7B

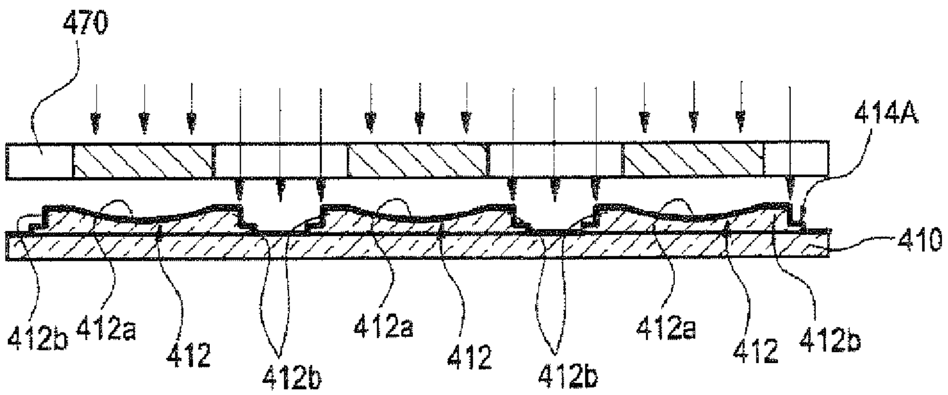


FIG. 7C

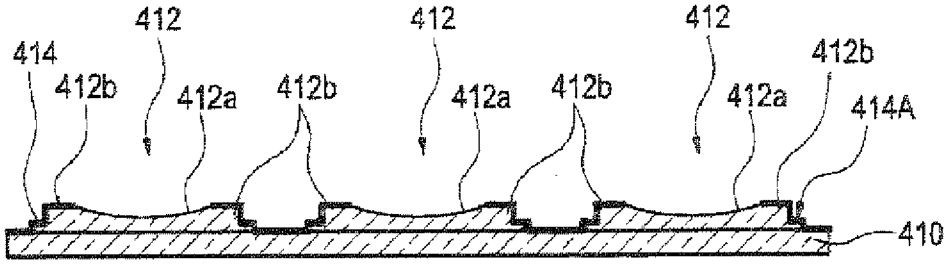

FIG. 8

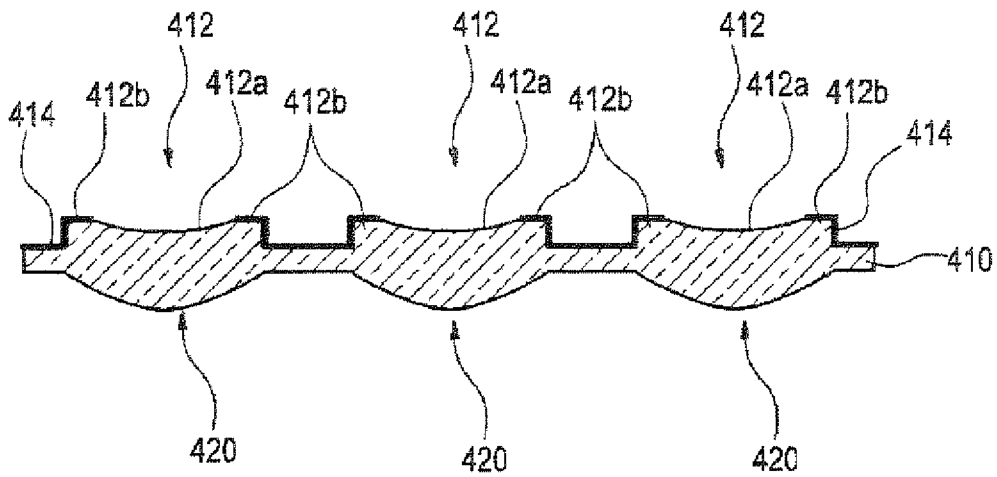


FIG. 9A

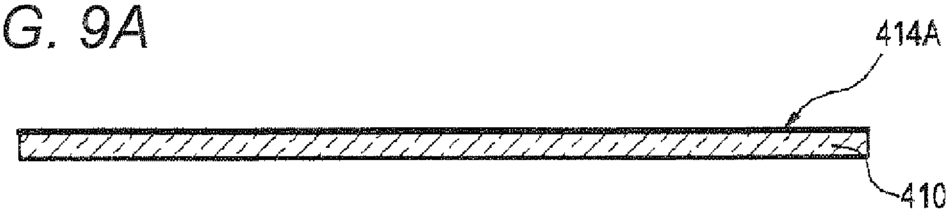


FIG. 9B

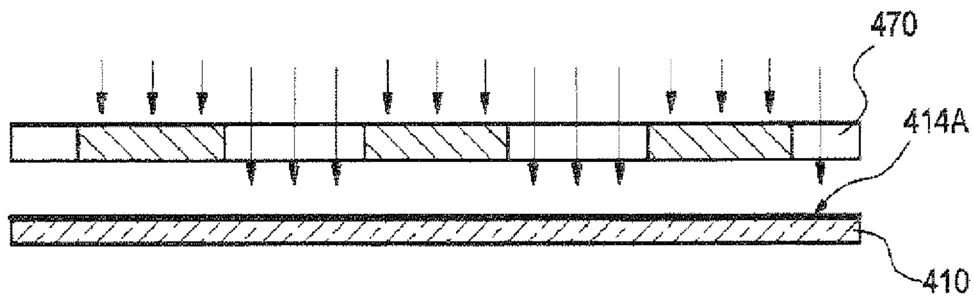


FIG. 9C

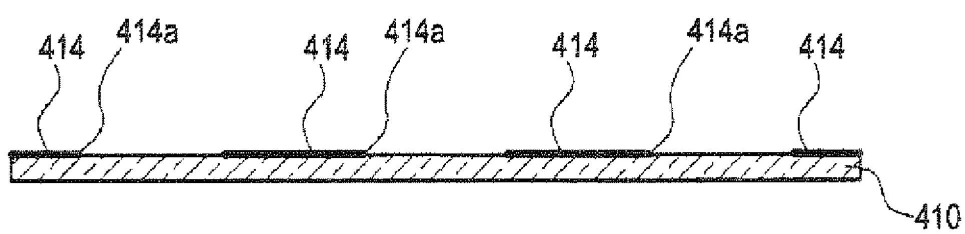

FIG. 10A

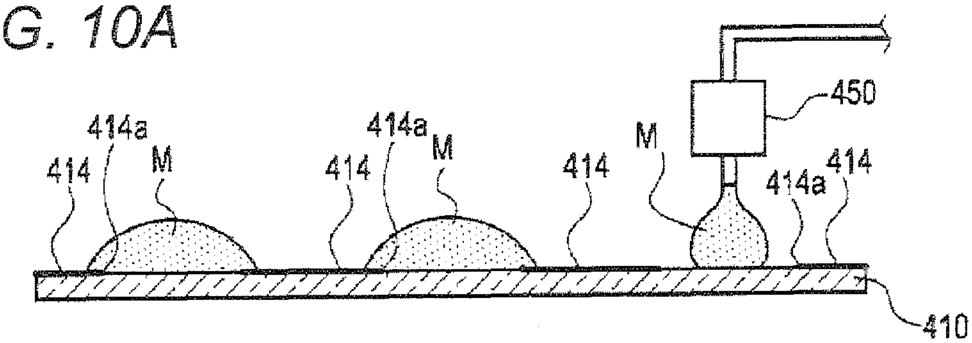


FIG. 10B

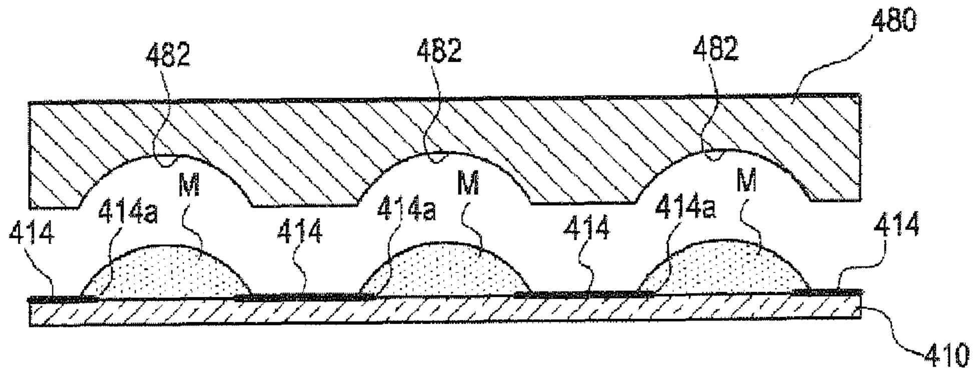


FIG. 10C

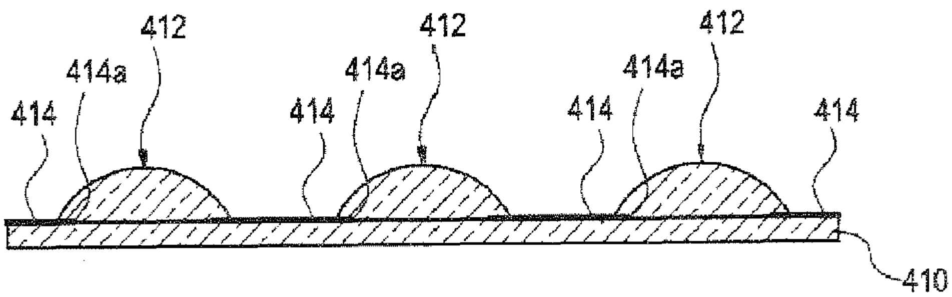

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009194396 A
- JP 2008257045 A
- JP 4096205 B
- US 3905815 A
- JP 46004605 B
- JP 48036281 A
- JP 55032070 A
- JP 60239736 A
- JP 61169835 A
- JP 61169837 A
- JP 62058241 A
- JP 62212401 A
- JP 63070243 A
- JP 63298339 A
- JP 62143044 A
- JP 62150242 A
- JP 9188685 A
- JP 9188686 A
- JP 9188710 A
- JP 2000131837 A
- JP 2002107916 A
- JP 2764769 B
- JP 2000310808 A
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2001132318 A
- JP 2000066385 A
- US 4069055 A
- JP 4365049 A
- US 4069056 A
- EP 104143 A
- US 339049 A
- US 410201 A
- JP 2150848 A
- JP 2296514 A
- EP 370693 A
- EP 390214 A
- EP 233567 A
- EP 297443 A
- EP 297442 A
- US 4933377 A
- US 161811 A
- US 4760013 A
- US 4734444 A
- US 2833827 A
- DE 2904626
- DE 3604580
- DE 3604581
- JP 5009407 A
- JP 6295060 A
- JP 59044615 A
- JP 54034327 B
- JP 58012577 B
- JP 54025957 B
- JP 59053836 A
- JP 59071048 A
- JP 2003262958 A
- JP 2763775 B
- JP 3172301 A
- JP 2000232264 A
- JP 2006063550 A
- EP 993966 A
- EP 1204000 A
- JP 2001318463 A
- JP 11240930 A
- JP 3112992 A
- JP 2003533455 T
- JP 2002273191 A
- JP 9077994 A
- JP 2008029901 A
- JP 2007277514 A
- JP 54037082 A
- JP 8507960 T
- JP 2009258668 A
- JP 9169821 A
- JP 2009203462 A
- JP 10339949 A
- JP 2004037986 A
- JP 2003238837 A
- JP 2008009426 A
- JP 2008081732 A
- JP 2010106268 A
- JP 2272009 A
- JP 2003049110 A
- JP 2009052010 A
- JP 10300922 A
- JP 2004300204 A
- JP 7319161 A
- EP 568993 A

- US 4508811 A
- US 5227227 A
- JP 2001125255 A
- JP 11271969 A
- JP 7068256 B
- JP 2008250074 A
- JP 2009205029 A
- JP 2009158863 A
- JP 2009099591 A
- JP 7128867 A
- JP 7146562 A
- JP 8278637 A
- JP 2000273370 A
- JP 2006085140 A
- JP 2006291191 A
- JP 2007002101 A
- JP 2007002102 A
- JP 2007281523 A
- JP 2011050678 A

**Non-patent literature cited in the description**


- **WAKABAYASHI et al.** *Bull. Chem. Soc. Japan,* 1969, vol. 42, 2924
- **M.P. HUTT.** *Journal of Heterocyclic Chemistry,* 1970, vol. 1 (3
- **MARTIN KUNZ.** *Rad Tech '98. Proceeding,* 19 April 1998
- *J.C.S. Perkin II,* 1979, 1653-1660
- *J.C.S. Perkin II,* 1979, 156-162
- *Journal of Photopolymer Science and Technology,* 1995, 202-232
- **S.I. SCHLESINGER.** *Photogr. Sci. Eng.,* 1974, vol. 18, 387
- **T.S. BAL et al.** *Polymer,* 1980, vol. 21, 423
- **J.V. CRIVELLO et al.** *Macromolecules,* 1977, vol. 10 (6), 1307
- **J.V. CRIVELLO et al.** *J. Polymer Sci., Polymer Chem. Ed.,* 1979, vol. 17, 1047
- **C.S. WEN et al.** *Teh. Proc. Conf. Rad. Curing ASIA,* October 1988, 478